# EUROPEAN PATENT APPLICATION

(11) **EP 4 714 959 A1**
(43) Date of publication of application: **25.03.2026**
(21) Application number: 24219734.1
(22) Date of filing: 13.12.2024
(51) Int. Cl.: C07F 5/02, H10K 85/30, H10K 50/11, C09K 11/02, H10K 85/60, H10K 50/12, C09K 11/06, C07F 7/08, H10K 101/20

(54) **LIGHT EMITTING ELEMENT, FUSED POLYCYCLIC COMPOUND FOR THE SAME, AND DISPLAY DEVICE INCLUDING THE SAME**

(30) Priority: 14.12.2023 KR 20230181640
(71) Applicant: Samsung Display Co., Ltd., Gyeonggi-Do (KR)
(72) Inventor: Suzaki, Yuji, Yokohama (JP); Hoshi, Keigo, Yokohama (JP); Furue, Ryhei, Yokohama (JP); Miyazaki, Yuuki, Yokohama (JP)
(74) Representative: Gulde & Partner

(57) **Abstract**

A light emitting element including a first electrode, a second electrode disposed on the first electrode, and an emission layer disposed between the first electrode and the second electrode is provided. The emission layer contains a first compound represented by Formula 1.

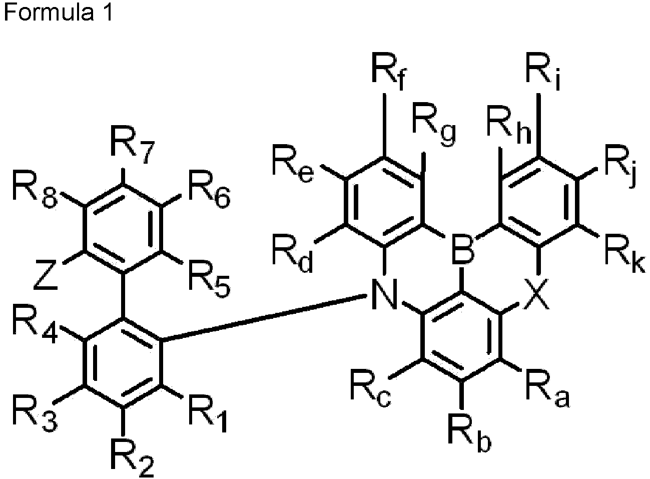

## Description

### BACKGROUND

### 1. Field

One or more embodiments of the present disclosure relate to a light emitting element, a fused polycyclic compound used in the light emitting element, and a display device including the light emitting element.

### 2. Description of the Related Art

Recently, organic electroluminescence display devices as image display devices have been actively researched and developed. The organic electroluminescence display devices are different from liquid crystal display devices, and/or the like and are self-luminous type or kind display devices that combine holes and electrons in the emission layer injected, respectively, from the first electrode and the second electrode of the organic electroluminescence display device, thereby emitting light using an emission material in the emission layer to implement displays (e.g., of image).

In applying organic electroluminescence light emitting elements to display devices, improvements in (e.g., high) luminous efficiency and (e.g., long) lifespan of the organic electroluminescence light emitting elements are desired or required, and thus the development of materials for organic electroluminescence light emitting elements capable of stably achieving such improvements is continuously desired or pursued.

For example, recently, in order to implement organic electroluminescence light emitting elements with high efficiency, the technology based on phosphorescence using an energy of the triplet state or the technology on fluorescence emission using triplet-triplet annihilation (TTA), which is a phenomenon in which singlet excitons are generated by collision of triplet excitons, is being actively developed or pursued, and developments of materials for thermally activated delayed fluorescence (TADF) using a delayed fluorescence phenomenon are being conducted or pursued.

### SUMMARY

One or more aspects of embodiments of the present disclosure are directed toward a light emitting element having improved luminous efficiency and element lifespan.

One or more aspects of embodiments of the present disclosure are directed toward a fused polycyclic compound capable of improving luminous efficiency and element lifespan of the light emitting element including the fused polycyclic compound.

One or more aspects of embodiments of the present disclosure are directed toward a display device having excellent or suitable display quality by including the light emitting element having improved luminous efficiency and lifespan.

Additional aspects will be set forth in part in the description which follows and, in part, will be apparent from the description, or may be learned by practice of the presented embodiments.

The invention is defined by the appended claims. The description that follows is subjected to this limitation. Any disclosure lying outside the scope of said claims is only intended for illustrative as well as comparative purposes.

According to one or more embodiments of the present disclosure, a light emitting element includes a first electrode, a second electrode facing (e.g., opposite) the first electrode, and an emission layer between the first electrode and the second electrode, wherein the emission layer includes a first compound represented by Formula 1.

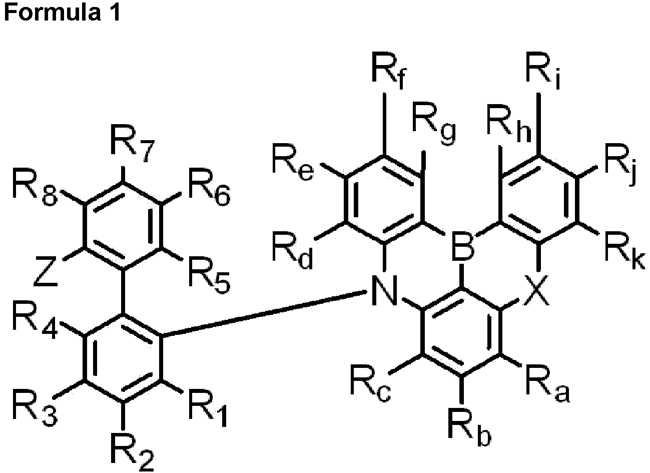

In Formula 1, X is a direct linkage, O, S, Se, CR₃₁ R₃₂, PR₃₃, SiR₃₄R₃₅, C=O, C=S, or NR₃₆, Z is a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons, R₁ to R₈, Rₐ to Rₖ, and R₃₁ to R₃₆ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons, and/or may be bonded to an adjacent group to form a ring, if (e.g., when) any one selected from among R₁ to R₈, Rₐ to Rₖ, and R₃₁ to R₃₆ is bonded to an adjacent group to form a ring, the formed ring may not (e.g., does not) include two consecutive *sp³* carbons that are bonded to each other, and if (e.g., when) Z is a substituted or unsubstituted aryl group, R₅ is not be a substituted or unsubstituted aryl group.

In one or more embodiments, the first compound represented by Formula 1 may be represented by any one selected from among Formula 2-1 to Formula 2-8.

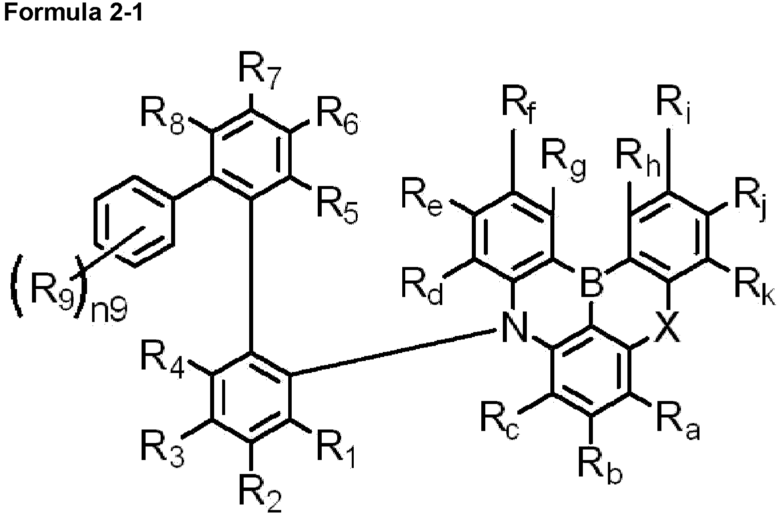

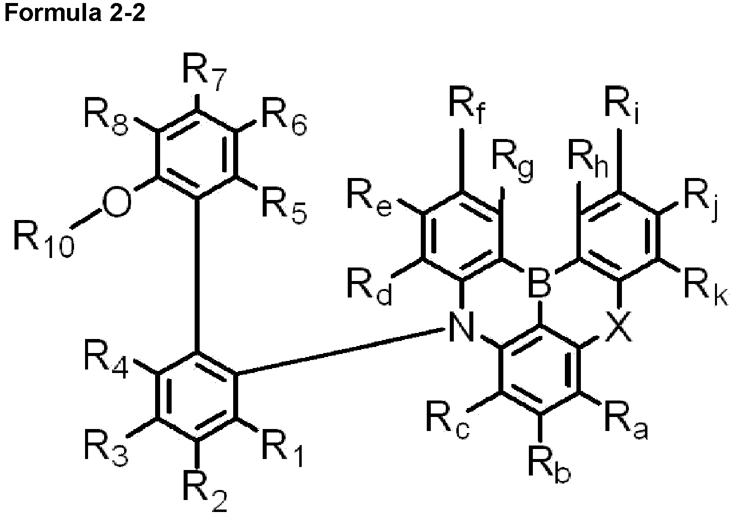

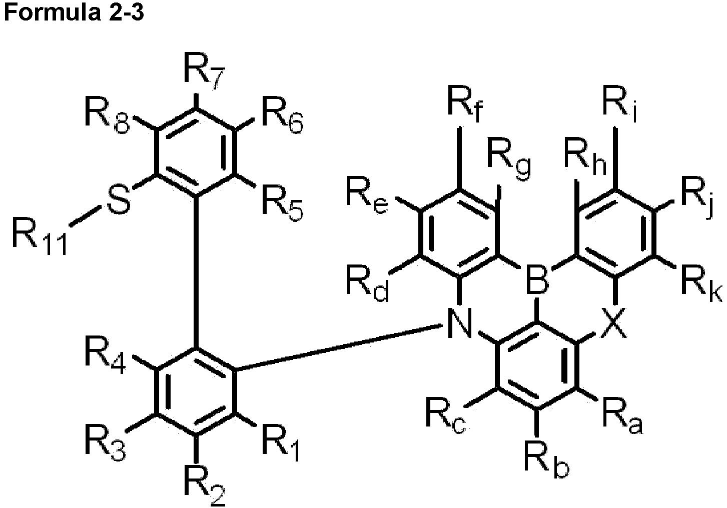

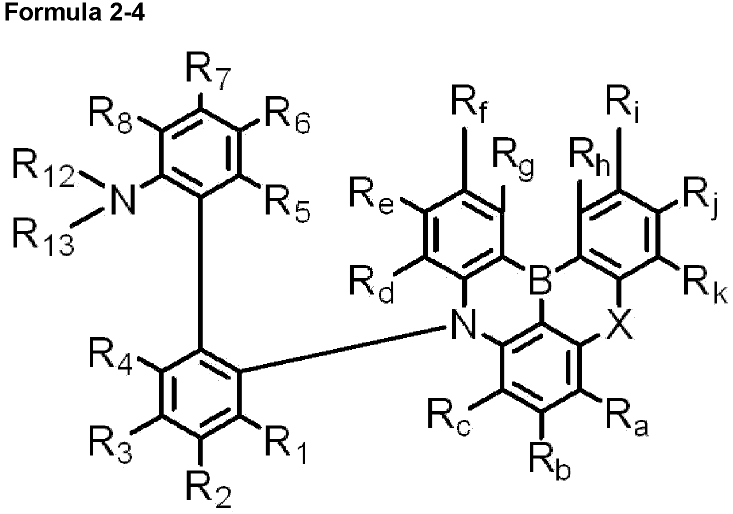

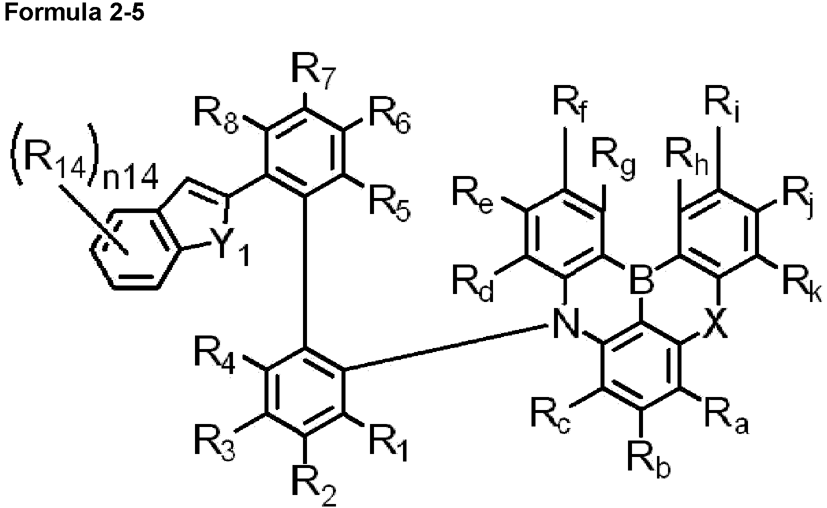

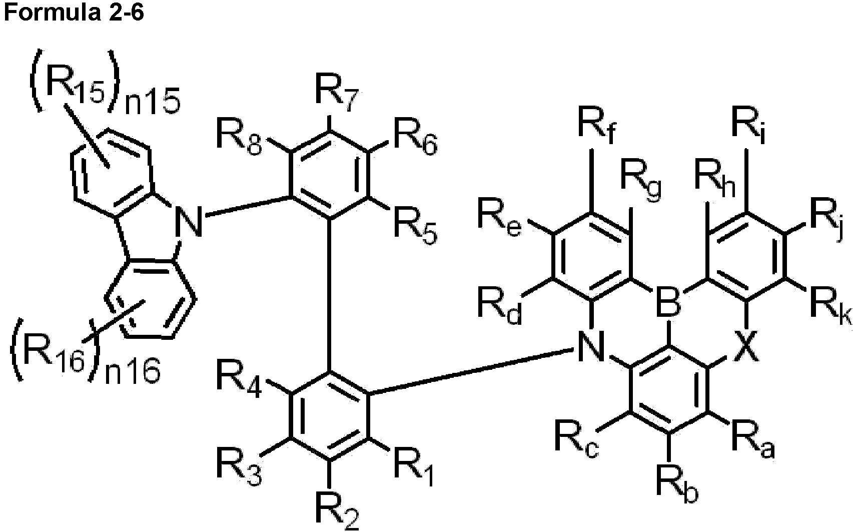

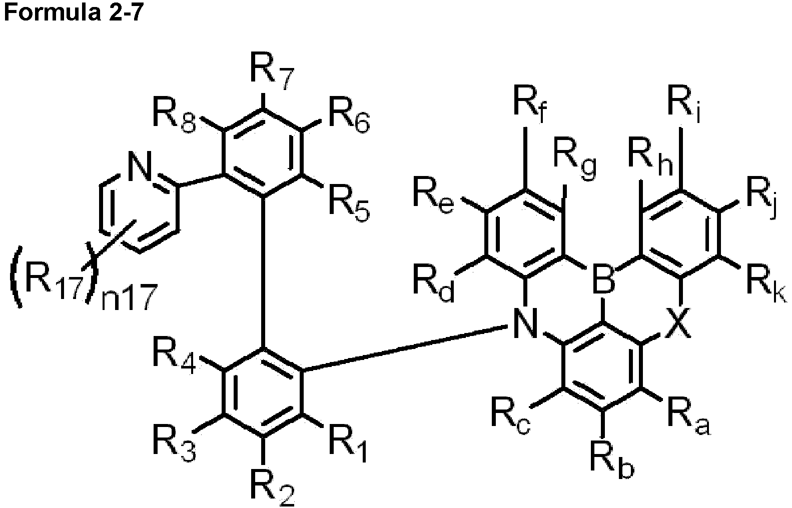

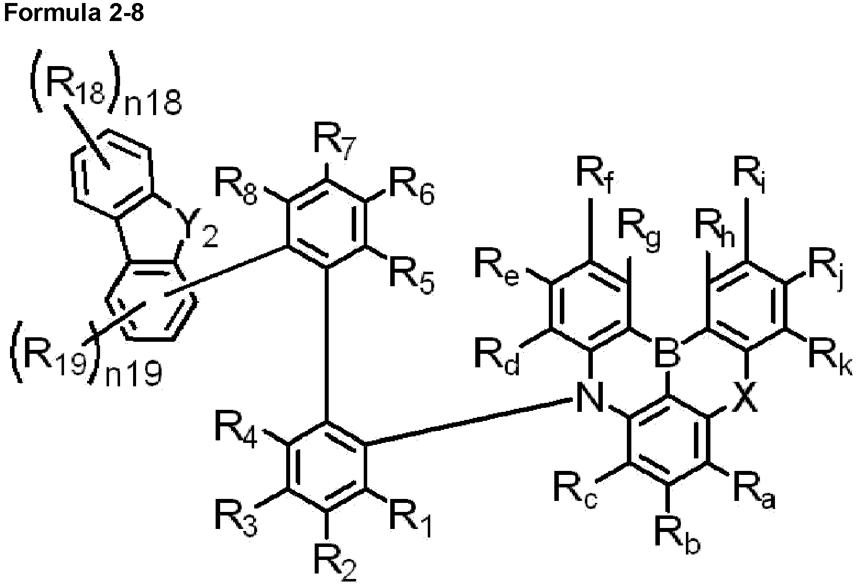

In Formula 2-1 to Formula 2-8, R₉ to R₁₉ are each independently hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, Y₁ and Y₂ are each independently O or S, n9 is an integer of 0 to 5, n14 to n18 are each independently an integer of 0 to 4, and n19 is an integer of 0 to 3.

In Formula 2-1 to Formula 2-8, X, R₁ to R₈, Rₐ to Rₖ, and R₃₁ to R₃₆ are each independently the same as defined in Formula 1.

In one or more embodiments, the first compound represented by Formula 1 may be represented by Formula 3-1 or Formula 3-2.

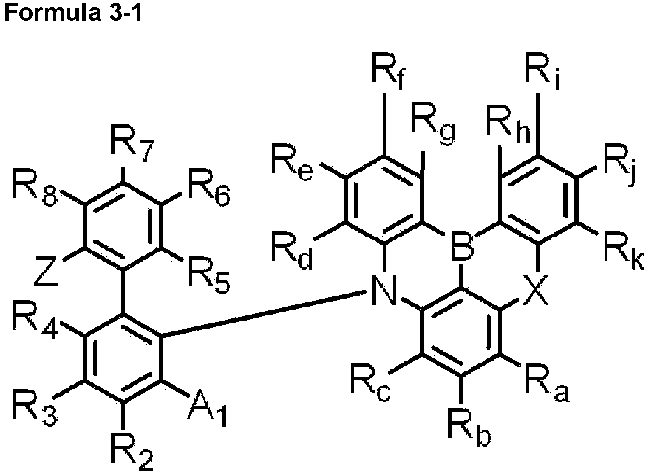

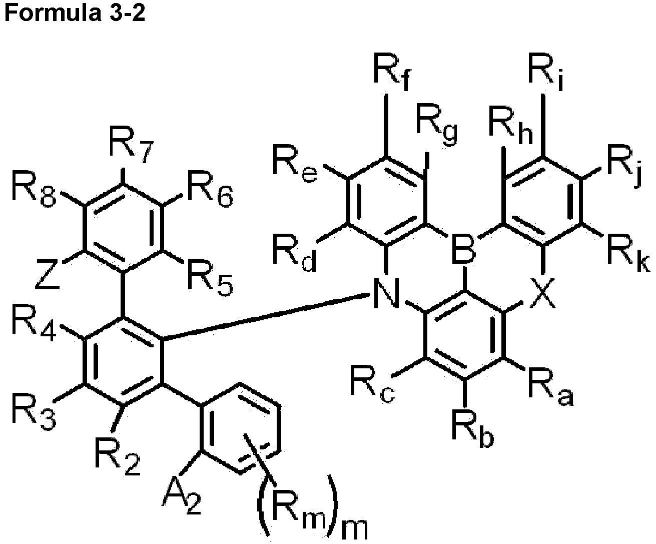

In Formula 3-1 and Formula 3-2, A₁ are hydrogen, deuterium, a substituted or unsubstituted oxy group, or a substituted or unsubstituted amine group, A₂ is hydrogen, deuterium, a substituted or unsubstituted oxy group, a substituted or unsubstituted thio group, a substituted or unsubstituted amine group, a substituted or unsubstituted aryl group having 6 to 30 ring-forming carbons, or substituted or unsubstituted heteroaryl group 2 to 30 ring-forming carbons, Rₘ is hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and m is an integer of 0 to 4.

In Formula 3-1 and Formula 3-2, the same descriptions as defined in Formula 1 are applied to X, Z, R₂ to R₈, Rₐ to Rₖ, and R₃₁ to R₃₆.

In one or more embodiments, Z and A₂ may be the same.

In one or more embodiments, the first compound represented by Formula 1 may be represented by any one selected from among Formula 4-1 to Formula 4-4.

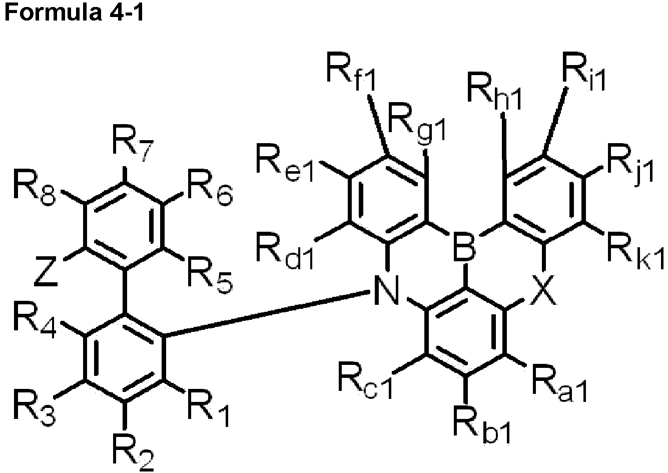

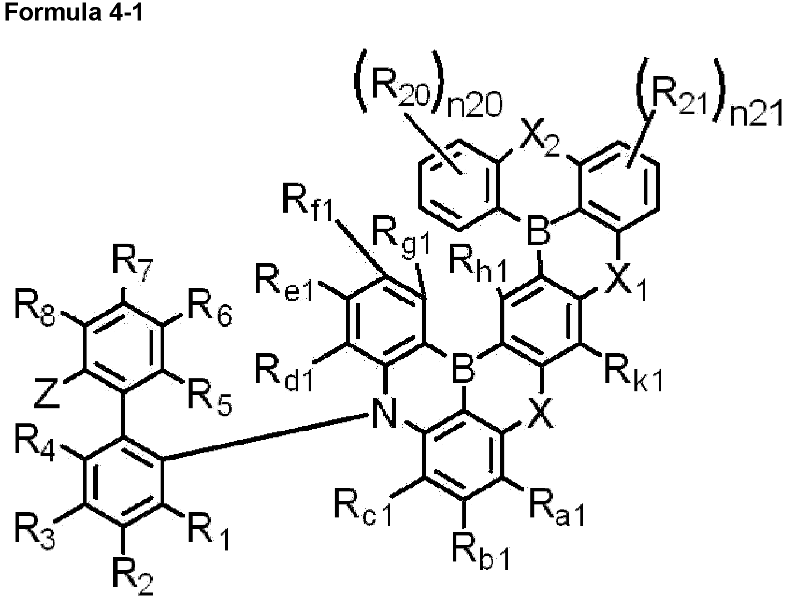

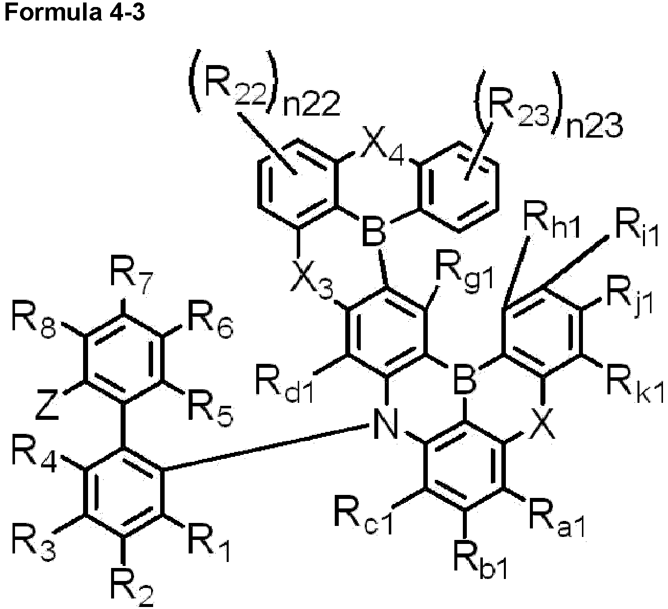

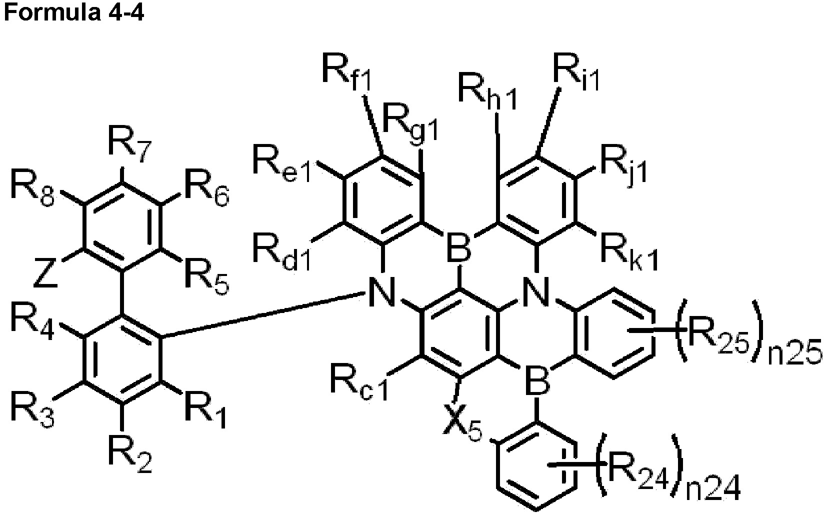

In Formula 4-1 to Formula 4-4, X₁ to X₅ are each independently O, S, CR₂₆R₂₇, or NR₂₈, Rₐ₁ to Rₖ₁, R₂₀ to R₂₈ are each independently hydrogen, deuterium, a halogen, a cyano group, a substituted or unsubstituted amine group, a substituted or unsubstituted oxy group, a substituted or unsubstituted thio group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and/or are bonded to an adjacent group to form a ring, n20 and n23 to n25 are each independently an integer of 0 to 4, and n21 and n22 are each independently an integer of 0 to 3.

In Formula 4-1 to Formula 4-4, the same descriptions as defined in Formula 1 are applied to X, Z, R₁ to R₈, and R₃₁ to R₃₆.

In one or more embodiments, the first compound represented by Formula 1 may be represented by Formula 5.

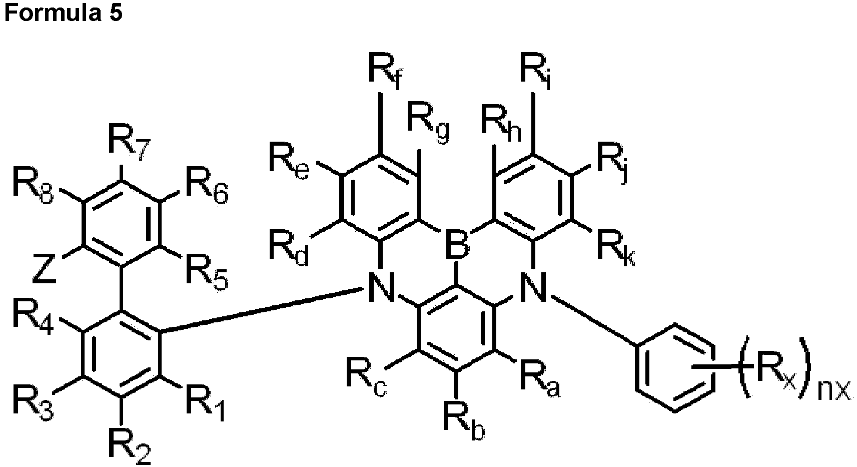

In Formula 5, Rₓ is hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons, and/or is bonded to an adjacent group to form a ring, and nx is an integer of 0 to 5.

In Formula 5, the same descriptions as defined in Formula 1 are applied to Z, R₁ to R₈, and Rₐ to Rₖ.

In one or more embodiments, the first compound represented by Formula 1 may be represented by Formula 6.

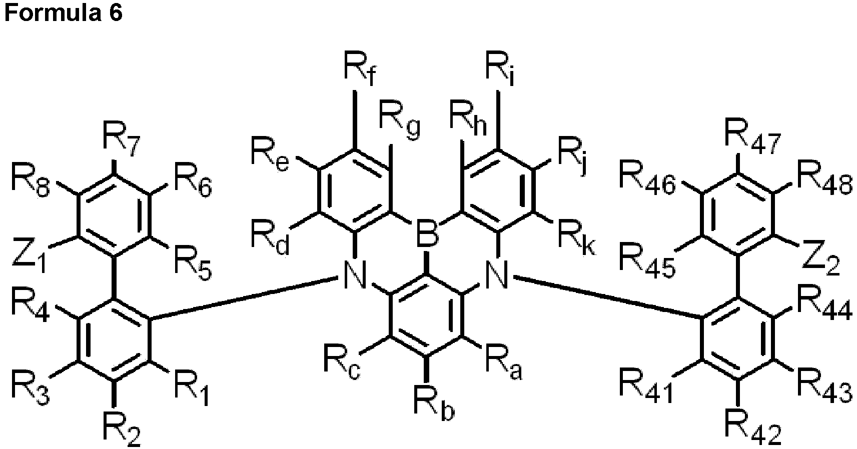

In formula 6, Z₁ and Z₂ are each independently a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons, and R₄₁ to R₄₈ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons, and/or is bonded to an adjacent group to form a ring.

In Formula 6, the same descriptions as defined in Formula 1 are applied to R₁ to R₈, and Rₐ to Rₖ.

In one or more embodiments, in Formula 6, R₁ and R₄₁ may each independently be hydrogen, a substituted or unsubstituted phenyl group, a substituted or unsubstituted phenyloxy group, or a substituted or unsubstituted diphenylamine group.

In one or more embodiments, the first compound represented by Formula 1 may be represented by any one selected from among Formula 7-1 to Formula 7-4.

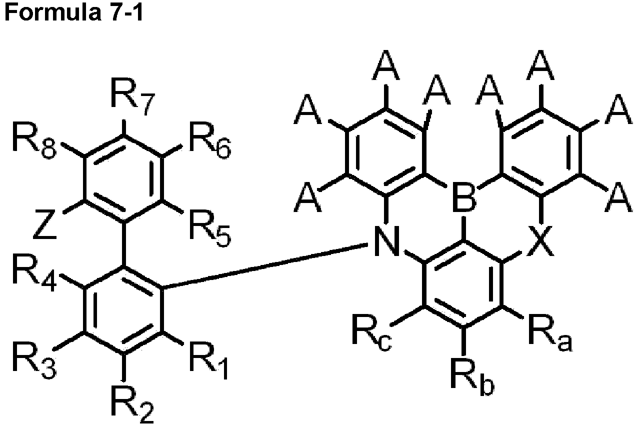

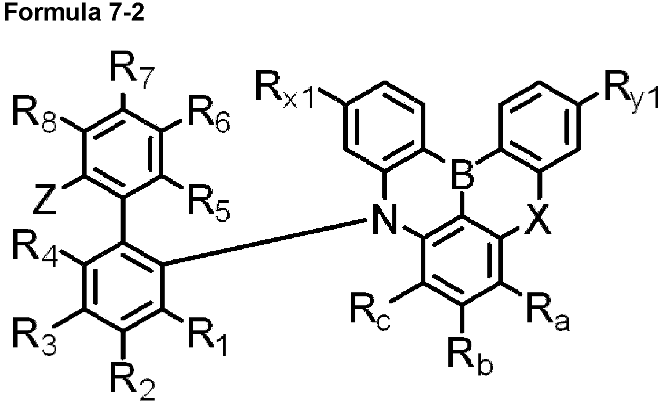

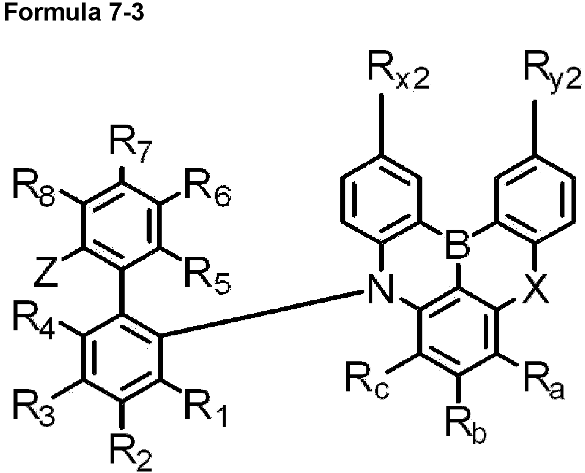

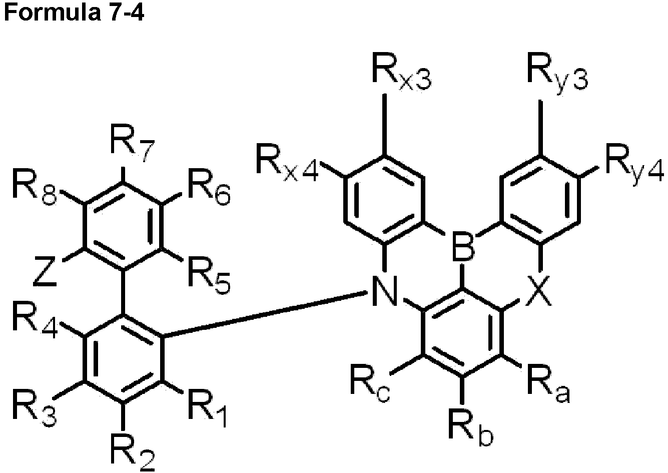

In Formula 7-1 to Formula 7-4, A is hydrogen, or deuterium, Rₓ₁, Rₓ₂, R_{y1}, and R_{y2} are each independently deuterium, a halogen, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and Rₓ₃, Rₓ₄, R_{y3}, and R_{y4} are each independently deuterium, a halogen, a substituted or unsubstituted oxy group, a substituted or unsubstituted thio group, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and/or is bonded to an adjacent group to form a ring.

In Formula 7-1 to Formula 7-4, the same descriptions as defined in Formula 1 are applied to X, R₁ to R₈, Rₐ to R_{c}, and R₃₁ to R₃₆.

In one or more embodiments, the first compound represented by Formula 1 may be represented by Formula 8-1 or Formula 8-2.

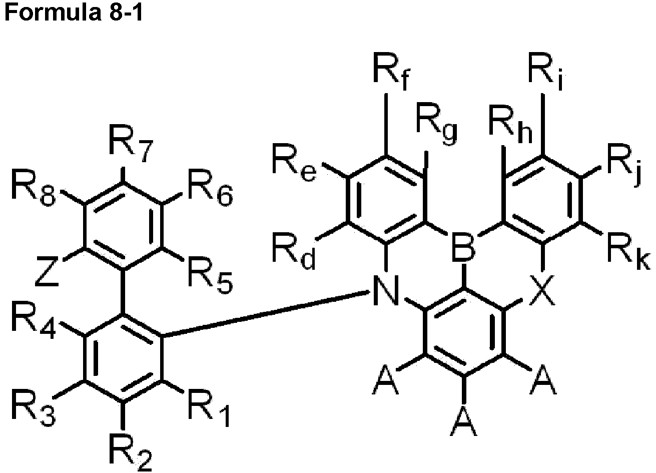

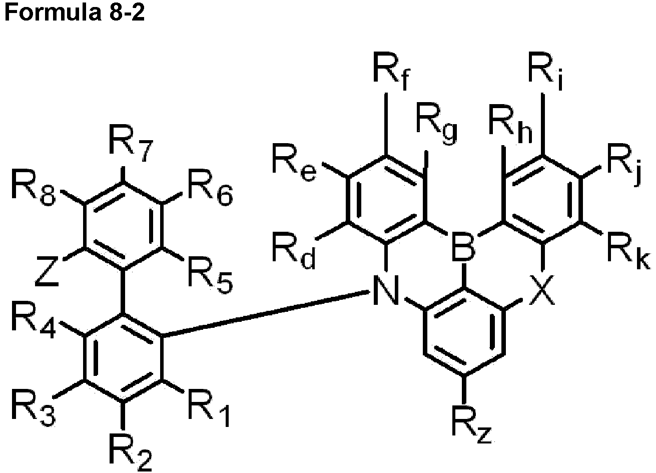

In Formula 8-1 and Formula 8-2, A is hydrogen or deuterium, and R₂ is deuterium, a halogen, a substituted or unsubstituted oxy group, a substituted or unsubstituted thio group, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons.

In Formula 8-1 and Formula 8-2, the same descriptions as defined in Formula 1 are applied to X, Z, R₁, R₃ to R₈, R_{d} to Rₖ, and R₃₁ to R₃₆.

In one or more embodiments, the emission layer further includes at least one selected from among a second compound represented by Formula HT-1, a third compound represented by Formula ET-1, and a fourth compound represented by Formula D-1.

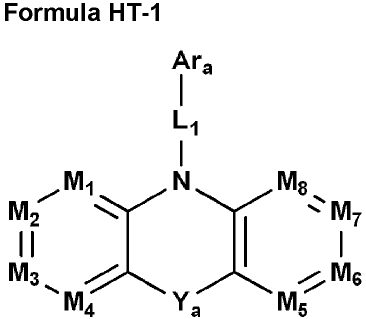

In Formula HT-1, M₁ to M₈ are each independently N or CR₅₁, L₁ may be a direct linkage, a substituted or unsubstituted arylene group having 6 to 30 ring-forming carbons, or a substituted or unsubstituted heteroarylene group having 2 to 30 ring-forming carbons, Yₐ is a direct linkage, CR₅₂R₅₃, or SiR₅₄R₅₅, Arₐ is a substituted or unsubstituted aryl group having 6 to 30 ring-forming carbons, or a substituted or unsubstituted heteroaryl group having 2 to 30 ring-forming carbons, and R₅₁ to R₅₅ are each independently hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbons, a substituted or unsubstituted alkenyl group having 2 to 20 carbons, a substituted or unsubstituted aryl group having 6 to 60 ring-forming carbons, or a substituted or unsubstituted heteroaryl group having 2 to 60 ring-forming carbons, and/or may be bonded to an adjacent group to form a ring.

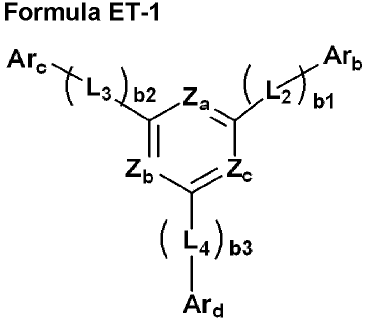

In Formula ET-1, at least one selected from among Zₐ to Z_{c} is N, and the rest may be CR₅₆, R₅₆ is hydrogen, deuterium, a substituted or unsubstituted alkyl group having 1 to 20 carbons, a substituted or unsubstituted aryl group having 6 to 60 ring-forming carbons, or a substituted or unsubstituted heteroaryl group having 2 to 60 ring-forming carbons, b1 to b3 are each independently an integer of 0 to 10, Ar_{b} to Ar_{d} are each independently hydrogen, deuterium, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and L₂ to L₄ are each independently a direct linkage, a substituted or unsubstituted arylene group having 6 to 30 ring-forming carbons, or a substituted or unsubstituted heteroarylene group having 2 to 30 ring-forming carbons.

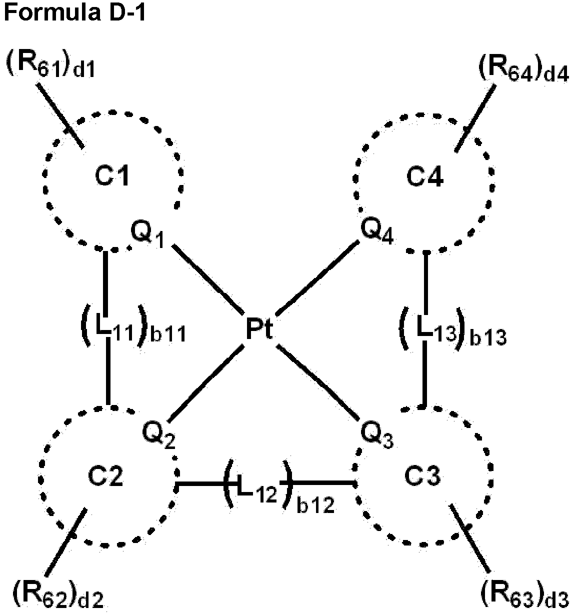

In Formula D-1, Q₁ to Q₄ are each independently C or N, rings C₁ to C₄ are each independently a substituted or unsubstituted hydrocarbon ring having 5 to 30 ring-forming carbons or a substituted or unsubstituted hetero ring having 2 to 30 ring-forming carbons, L₁₁ to L₁₃ are each independently a direct linkage, 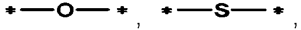 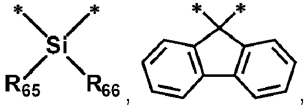 a substituted or unsubstituted alkylene group having 1 to 20 carbons, a substituted or unsubstituted arylene group having 6 to 30 ring-forming carbons, or a substituted or unsubstituted heteroarylene group having 2 to 30 ring-forming carbons, b11 to b13 are each independently 0 or 1, R₆₁ to R₆₆ are each independently hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbons, a substituted or unsubstituted alkenyl group having 2 to 20 carbons, a substituted or unsubstituted aryl group having 6 to 60 ring-forming carbons, or a substituted or unsubstituted heteroaryl group having 2 to 60 ring-forming carbons, and d1 to d4 are each independently an integer of 0 to 4.

In one or more embodiments of the present disclosure, a display device includes a base layer, a circuit layer on the base layer, and a display element layer on the circuit layer and including a light emitting element. The light emitting element includes a first electrode, a second electrode on the first electrode, and an emission layer between the first electrode and the second electrode and including a first compound represented by Formula 1.

In one or more embodiments, the light emitting element may further include a capping layer on the second electrode, and a refractive index of the capping layer is about 1.6 or greater for light in a wavelength range of about 550 nanometers (nm) to about 660 nm.

In one or more embodiments, the display device may further include a light control layer on the display element layer and including a quantum dot. The light emitting element may be to emit first color light, and the light control layer may include a first light control part including a first quantum dot that converts the first color light into second color light in a longer wavelength region than the first color light, a second light control part including a second quantum dot that converts the first color light into third color light in a longer wavelength region than (each of) the first color light and the second color light, and a third light control part that transmits the first color light.

In one or more embodiments, the display device may further include a color filter layer. The color filter layer may include a first filter configured to transmit the second color light, a second filter configured to transmit the third color light, and a third filter configured to transmit the first color light.

In one or more embodiments of the present disclosure, a fused polycyclic compound represented by Formula 1 is provided.

### BRIEF DESCRIPTION OF THE DRAWINGS

The accompanying drawings are included to provide a further understanding of the disclosure, and are incorporated in and constitute a part of this disclosure. The drawings illustrate example embodiments of the disclosure and, together with the description, serve to explain principles of the present disclosure. Above and/or other aspects of the disclosure should become apparent and appreciated from the following description of embodiments taken in conjunction with the accompanying drawings. In the drawings:
FIG. 1 is a plan view of a display apparatus according to one or more embodiments of the present disclosure;
FIG. 2 is a cross-sectional view of a display apparatus according to one or more embodiments of the present disclosure;
FIG. 3 is a cross-sectional view schematically illustrating a light emitting element according to one or more embodiments of the present disclosure;
FIG. 4 is a cross-sectional view schematically illustrating a light emitting element according to one or more embodiments of the present disclosure;
FIG. 5 is a cross-sectional view schematically illustrating a light emitting element according to one or more embodiments of the present disclosure;
FIG. 6 is a cross-sectional view schematically illustrating a light emitting element according to one or more embodiments of the present disclosure;
FIG. 7 and FIG. 8 are each a cross-sectional view of a display apparatus according to one or more embodiments of the present disclosure;
FIG. 9 is a cross-sectional view illustrating a display apparatus according to one or more embodiments of the present disclosure;
FIG. 10 is a cross-sectional view illustrating a display apparatus according to one or more embodiments of the present disclosure; and
FIG. 11 is a view illustrating a vehicle in which display apparatuses according to one or more embodiments of the present disclosure are arranged.

### DETAILED DESCRIPTION

The present disclosure may be modified in one or more suitable manners and have many forms, and thus specific/example embodiments will be exemplified in the drawings and described in more detail in the detailed description of present disclosure.

When explaining each of drawings, like reference numbers are used for referring to like elements. In the accompanying drawings, the dimensions of each structure may be exaggeratingly illustrated for clarity of the present disclosure. It will be understood that, although the terms "first," "second," and/or the like, may be used herein to describe one or more suitable components, these components should not be limited by these terms. These terms are only used to distinguish one component from another. For example, a first component could be termed a second component, and, similarly, a second component could be termed a first component, without departing from the scope of example embodiments of the disclosure. As used herein, the singular forms, "a," "an," "one," and "the" are intended to include the plural forms as well, unless the context clearly indicates otherwise. Further, the utilization of "may" when describing embodiments of the present disclosure refers to "one or more embodiments of the present disclosure".

In the present disclosure, it will be understood that the terms "comprise(s)/comprising," "include(s)/including," "have(has)/having" and/or the like specify the presence of features, numbers, steps, operations, component, parts, and/or one or more (e.g., any suitable) combinations thereof disclosed in the specification, but do not exclude the possibility of presence or addition of one or more other features, numbers, steps, operations, component, parts, and/or one or more (e.g., any suitable) combinations thereof. As used herein, the terms "and", "or", and "and/or" may include any and all combinations of one or more of the associated listed items. Expressions such as "at least one of," "one of," and "selected from," when preceding a list of elements, modify the entire list of elements and do not modify the individual elements of the list. For example, "at least one of a, b, or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

In the present disclosure, if (e.g., when) a layer, a film, a region, or a plate is referred to as being "on" or "in an upper portion of" another layer, film, region, or plate, it may be not only "directly on" the layer, film, region, or plate, but one or more intervening layers, films, regions, or plates may also be present. Opposite this, if (e.g., when) a layer, a film, a region, or a plate is referred to as being "below", "in a lower portion of" another layer, film, region, or plate, it can be not only directly under the layer, film, region, or plate, but one or more intervening layers, films, regions, or plates may also be present. In addition, it will be understood that if (e.g., when) a part is referred to as being "on" another part, it can be arranged above the other part, or arranged under the other part as well. In the present disclosure, "directly on" may refer to that there are no additional layers, films, regions, plates, *etc.,* between a layer, a film, a region, a plate, *etc.* and the other part. For example, "directly on" may refer to two layers or two members are disposed without utilizing an additional member such as an adhesive member therebetween.

In the present disclosure, the term "substituted" refers to the replacement of a hydrogen atom by a substituent selected from among the group consisting of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In addition, each of the substituents exemplified above may be substituted or unsubstituted. For example, a biphenyl group may be interpreted as an aryl group or a phenyl group substituted with a phenyl group.

In the present disclosure, the phrase "bonded to an adjacent group to form a ring" may refer to that a group is bonded to an adjacent group to form a substituted or unsubstituted hydrocarbon ring or a substituted or unsubstituted heterocycle. The hydrocarbon ring may include an aliphatic hydrocarbon ring and/or an aromatic hydrocarbon ring. The heterocycle may include an aliphatic heterocycle and/or an aromatic heterocycle. The hydrocarbon ring and the heterocycle may each be monocyclic or polycyclic. In addition, the rings formed by adjacent groups being bonded to each other may be connected to another ring to form a spiro structure.

In the present disclosure, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other, and two ethyl groups in 1,1-diethylcyclopentane may be interpreted as "adjacent groups" to each other. In one or more embodiments, two methyl groups in 4,5-dimethylphenanthrene may be interpreted as "adjacent groups" to each other.

In the present disclosure, examples of a halogen may include fluorine, chlorine, bromine, or iodine.

In the present disclosure, an alkyl group may be linear or branched. The number of carbons in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, and/or the like, but embodiments of the present disclosure are not limited thereto.

In the present disclosure, a cycloalkyl group may refer to a cyclic alkyl group. The number of carbons in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and/or the like, but embodiments of the present disclosure are not limited thereto.

In the present disclosure, an alkenyl group refers to a hydrocarbon group including at least one carbon-carbon double bond in the middle or terminal of an alkyl group having 2 or more carbon atoms. The alkenyl group may be linear or branched. The number of carbon atoms in the alkenyl group is not specifically limited, for example, may be 2 to 30, 2 to 20, or 2 to 10. Examples of the alkenyl group may include a vinyl group, a 1-butenyl group, a 1-pentenyl group, a 1,3-butadienyl aryl group, a styrenyl group, a styryl vinyl group, and/or the like, but embodiments of the present disclosure are not limited thereto.

In the present disclosure, an alkynyl group refers to a hydrocarbon group including at least one carbon-carbon triple bond in the middle or terminal of an alkyl group having 2 or more carbon atoms. The alkynyl group may be linear or branched. Although the number of carbon atoms is not specifically limited, it may be 2 to 30, 2 to 20, or 2 to 10. Examples of the alkynyl group may include an ethynyl group, a propynyl group, and/or the like, but embodiments of the present disclosure are not limited thereto.

In the present disclosure, a hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the present disclosure, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, but embodiments of the present disclosure are not limited thereto.

In the present disclosure, a fluorenyl group may be substituted, and two substituents may be bonded to each other to form a spiro structure. Examples of the substituted fluorenyl group are as follows. However, embodiments of the present disclosure are not limited thereto.

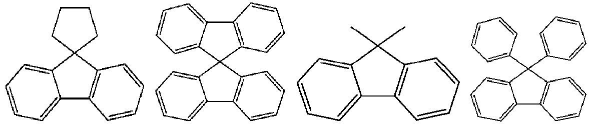

A heterocyclic group as used herein refers to any functional group or substituent derived from a ring containing at least one of B, O, N, P, Si, or Se as a heteroatom. The heterocyclic group includes an aliphatic heterocyclic group and/or an aromatic heterocyclic group. The aromatic heterocyclic group may be a heteroaryl group. The aliphatic heterocycle and the aromatic heterocycle may each be monocyclic or polycyclic.

In the present disclosure, the heterocyclic group may contain at least one of B, O, N, P, Si or S as a heteroatom. If (e.g., when) the heterocyclic group contains two or more heteroatoms, the two or more heteroatoms may be the same as or different from each other. The heterocyclic group may be a monocyclic heterocyclic group or a polycyclic heterocyclic group, and may include a heteroaryl group. The number of ring-forming carbon atoms in the heterocyclic group may be 2 to 30, 2 to 20, or 2 to 10.

In the present disclosure, an aliphatic heterocyclic group may include at least one of B, O, N, P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but embodiments of the present disclosure are not limited thereto.

In the present disclosure, a heteroaryl group may contain at least one of B, O, N, P, Si, or S as a heteroatom. If (e.g., when) the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridine group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like, but embodiments of the present disclosure are not limited thereto.

In the present disclosure, the above description of the aryl group may be applied to an arylene group except that the arylene group is a divalent group. The above description of the heteroaryl group may be applied to a heteroarylene group except that the heteroarylene group is a divalent group.

In the present disclosure, a silyl group may include an alkylsilyl group and/or an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but embodiments of the present disclosure are not limited thereto.

In the present disclosure, the number of carbon atoms in a carbonyl group is not specifically limited, but may be 1 to 40, 1 to 30, or 1 to 20. For example, the carbonyl group may have the following structures, but embodiments of the present disclosure are not limited thereto.

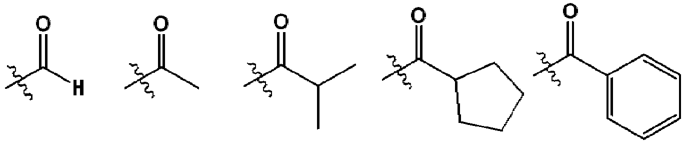

In the present disclosure, the number of carbon atoms in a sulfinyl group or a sulfonyl group is not particularly limited, for example, may be 1 to 30. The sulfinyl group may include an alkyl sulfinyl group and/or an aryl sulfinyl group. The sulfonyl group may include an alkyl sulfonyl group and/or an aryl sulfonyl group.

In the present disclosure, a thio group may include an alkylthio group and/or an arylthio group. The thio group may refer to that a sulfur atom is bonded to the alkyl group or the aryl group defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, and a naphthylthio group, but embodiments of the present disclosure are not limited thereto.

In the present disclosure, an oxy group may refer to that an oxygen atom is bonded to the alkyl group or the aryl group defined above. The oxy group may include an alkoxy group and/or an aryl oxy group. The alkoxy group may be a linear chain, a branched chain, or a ring. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like, but embodiments of the present disclosure are not limited thereto.

A boron group as used herein may refer to that a boron atom is bonded to the alkyl group or the aryl group as defined above. The boron group may include an alkyl boron group and/or an aryl boron group. Examples of the boron group may include a dimethylboron group, a trimethylboron group, a t-butyldimethylboron group, a diphenylboron group, a phenylboron group, and/or the like, but embodiments of the present disclosure are not limited thereto.

In the present disclosure, the number of carbon atoms in an amine group is not specifically limited, for example, may be 1 to 30. The amine group may include an alkyl amine group and/or an aryl amine group. Examples of the amine group may include a methylamine group, a dimethylamine group, a phenylamine group, a diphenylamine group, a naphthylamine group, a 9-methyl-anthracenylamine group, and/or the like, but embodiments of the present disclosure are not limited thereto.

In the present disclosure, the alkyl group among an alkylthio group, an alkylsulfoxy group, an alkylaryl group, an alkylamino group, an alkyl boron group, an alkyl silyl group, and an alkyl amine group may be the same as the examples of the alkyl group described above.

In the present disclosure, the aryl group among an aryloxy group, an arylthio group, an arylsulfoxy group, an arylamino group, an arylboron group, an arylsilyl group, and an arylamine group may be the same as the examples of the aryl group described above.

In the present disclosure, a direct linkage may refer to a single bond.

In the present disclosure, 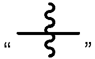 and " -*" refer to a position to be connected.

Hereinafter, embodiments of the disclosure will be described in more detail with reference to the accompanying drawings. In the present disclosure, the term "light emitting device" may be utilized interchangeably with the term "light emitting element."

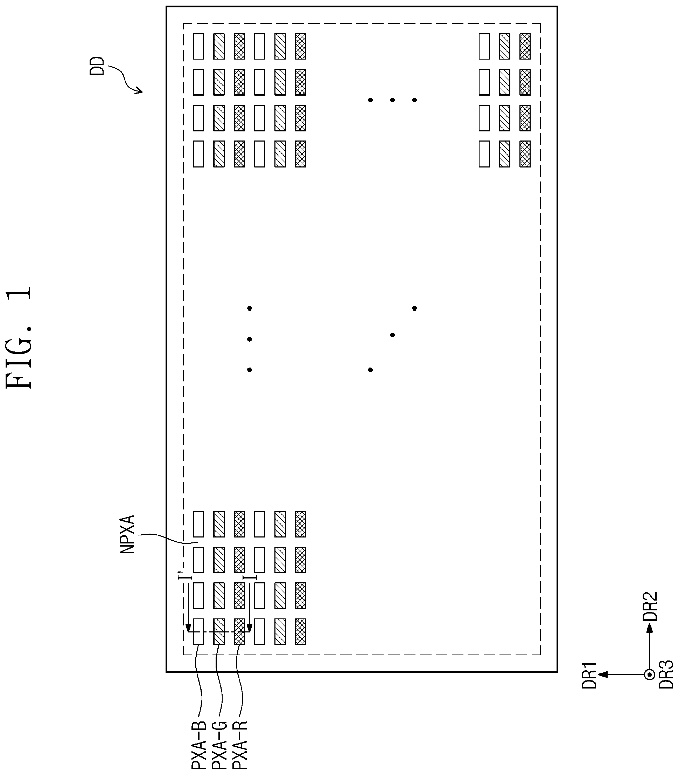

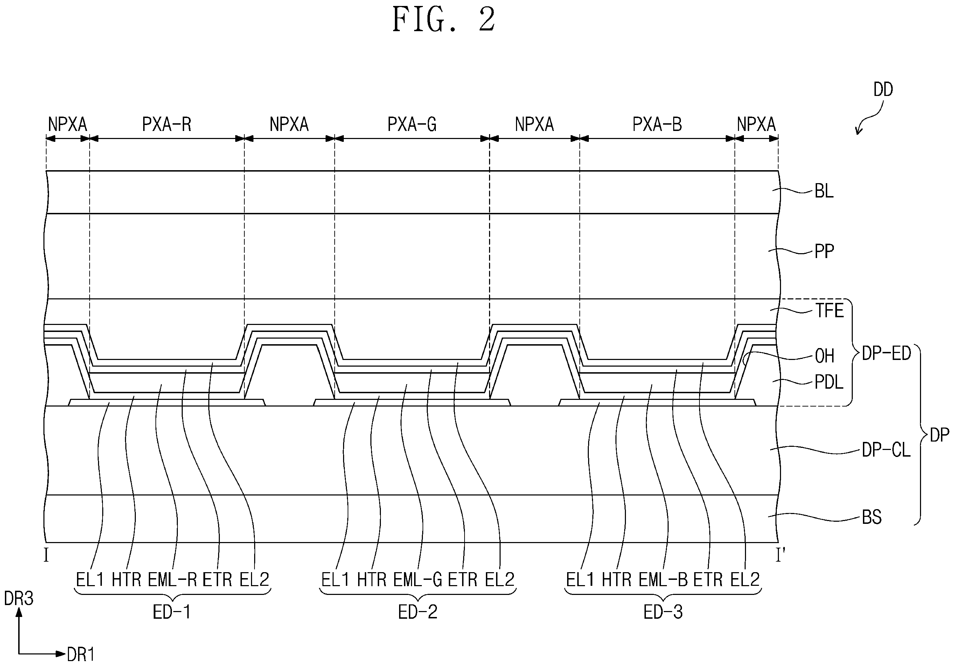

FIG. 1 is a plan view illustrating a display apparatus DD according to one or more embodiments of the present disclosure. FIG. 2 is a cross-sectional view of the display apparatus DD according to one or more embodiments of the present disclosure. FIG. 2 is a cross-sectional view illustrating a part taken along the line I-I' of the display apparatus of FIG. 1.

The display apparatus DD may include a display panel DP and an optical layer PP arranged on the display panel DP. The display panel DP may include light emitting devices ED-1, ED-2, and ED-3. The display apparatus DD may include a plurality of light emitting devices ED-1, ED-2, and ED-3. The optical layer PP may be arranged on the display panel DP to control reflected light in the display panel DP due to external light. The optical layer PP may include, for example, a polarization layer and/or a color filter layer. In one or more embodiments, the optical layer PP may not be provided in the display apparatus DD.

A base substrate BL may be arranged on the optical layer PP. The base substrate BL may be a member which provides a base surface on which the optical layer PP arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

The display apparatus DD according to one or more embodiments may further include a filling layer. The filling layer may be arranged between a display device layer DP-ED and the base substrate BL. The filling layer may be an organic material layer. The filling layer may include at least one of an acrylic-based resin, a silicone-based resin, or an epoxy-based resin.

The display panel DP may include a base layer BS, a circuit layer DP-CL provided on the base layer BS, and a display device layer DP-ED. The display device layer DP-ED may include a pixel defining film PDL, the light emitting devices ED-1, ED-2, and ED-3 arranged between respective portions of the pixel defining film PDL, and an encapsulation layer TFE arranged on the light emitting devices ED-1, ED-2, and ED-3.

The base layer BS may be a member which provides a base surface on which the display device layer DP-ED is arranged. The base layer BS may be a glass substrate, a metal substrate, a plastic substrate, and/or the like. However, embodiments of the present disclosure are not limited thereto, and the base layer BS may be an inorganic layer, an organic layer, or a composite material layer.

In one or more embodiments, the circuit layer DP-CL may be arranged on the base layer BS, and the circuit layer DP-CL may include a plurality of transistors. Each of the transistors may include a control electrode, an input electrode, and an output electrode. For example, in some embodiments, the circuit layer DP-CL may include switching transistor(s) and driving transistor(s) for driving the light emitting devices ED-1, ED-2, and ED-3 of the display device layer DP-ED.

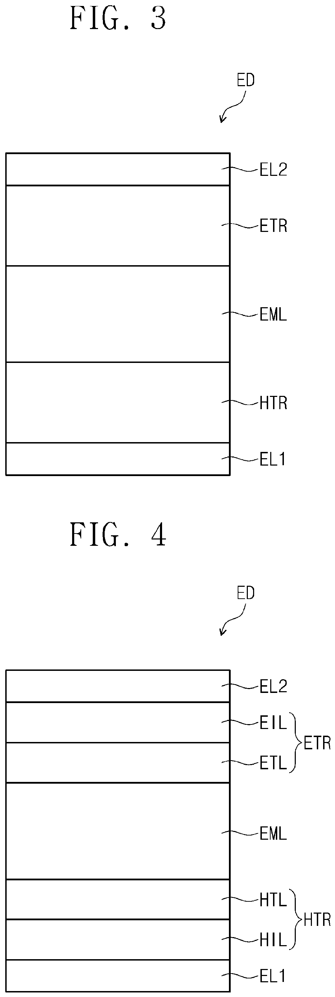

Each of the light emitting devices ED-1, ED-2, and ED-3 may have a structure of one of light emitting elements(devices) ED of embodiments according to FIGS. 3 to 6, which will be described in more detail later. Each of the light emitting devices ED-1, ED-2, and ED-3 may include a first electrode EL1, a hole transport region HTR, respective one of emission layers EML-R, EML-G, and EML-B, an electron transport region ETR, and a second electrode EL2.

FIG. 2 illustrates one or more embodiments in which the respective emission layers EML-R, EML-G, and EML-B of the light emitting devices ED-1, ED-2, and ED-3 are arranged in openings OH defined in the pixel defining film PDL, and the hole transport region HTR, the electron transport region ETR, and the second electrode EL2 are each provided as a common layer in the entire light emitting devices ED-1, ED-2, and ED-3. However, embodiments of the present disclosure are not limited thereto, for example, in one or more embodiments, the hole transport region HTR and the electron transport region ETR may be provided by being patterned inside the openings OH defined in the pixel defining film PDL. For example, the hole transport region HTR, the respective emission layers EML-R, EML-G, and EML-B, and the electron transport region ETR of the light emitting devices ED-1, ED-2, and ED-3 in one or more embodiments may be provided by being patterned in an inkjet printing method.

The encapsulation layer TFE may cover the light emitting devices ED-1, ED-2, and ED-3. The encapsulation layer TFE may seal the display device layer DP-ED. The encapsulation layer TFE may be a thin film encapsulation layer. The encapsulation layer TFE may be formed by laminating one layer or a plurality of layers. The encapsulation layer TFE may include at least one insulation layer. The encapsulation layer TFE according to one or more embodiments may include at least one inorganic film (hereinafter, an encapsulation-inorganic film). The encapsulation layer TFE according to one or more embodiments may also include at least one organic film (hereinafter, an encapsulation-organic film) and at least one encapsulation-inorganic film.

The encapsulation-inorganic film protects the display device layer DP-ED from moisture/oxygen, and the encapsulation-organic film protects the display device layer DP-ED from foreign substances such as dust particles. The encapsulation-inorganic film may include silicon nitride, silicon oxynitride, silicon oxide, titanium oxide, aluminum oxide, and/or the like, but embodiments of the present disclosure are not particularly limited thereto. In some embodiments, the encapsulation-organic film may include an acrylic-based compound, an epoxy-based compound, and/or the like. In some embodiments, the encapsulation-organic film may include a photopolymerizable organic material, but embodiments of the disclosure are not particularly limited thereto.

The encapsulation layer TFE may be arranged on the second electrode EL2 and may be arranged filling the opening OH.

Referring to FIG. 1 and FIG. 2, the display apparatus DD may include a non-light emitting region NPXA and light emitting regions PXA-R, PXA-G, and PXA-B. The light emitting regions PXA-R, PXA-G, and PXA-B may be regions in which light generated by the respective light emitting devices ED-1, ED-2, and ED-3 is emitted. The light emitting regions PXA-R, PXA-G, and PXA-B may be spaced and/or apart (e.g., spaced apart or separated) from each other on a plane (e.g., in a plan view).

Each of the light emitting regions PXA-R, PXA-G, and PXA-B may be a region divided by the pixel defining film PDL. The non-light emitting region NPXA may be areas between adjacent light emitting regions PXA-R, PXA-G, and PXA-B, which correspond to the pixel defining film PDL. In one or more embodiments, the light emitting regions PXA-R, PXA-G, and PXA-B may respectively correspond to pixels. The pixel defining film PDL may divide the light emitting devices ED-1, ED-2, and ED-3. The respective emission layers EML-R, EML-G, and EML-B of the light emitting devices ED-1, ED-2, and ED-3 may be arranged in openings OH defined in the pixel defining film PDL and separated from each other.

The light emitting regions PXA-R, PXA-G, and PXA-B may be divided into a plurality of groups according to the color of light generated from the light emitting devices ED-1, ED-2, and ED-3. In the display apparatus DD of one or more embodiments illustrated in FIG. 1 and FIG. 2, three light emitting regions PXA-R, PXA-G, and PXA-B, which emit red light, green light, and blue light, respectively, are exemplarily illustrated. For example, the display device DD of one or more embodiments may include a red light emitting region PXA-R, a green light emitting region PXA-G, and a blue light emitting region PXA-B that are separated from each other.

In the display apparatus DD according to one or more embodiments, the plurality of light emitting devices ED-1, ED-2, and ED-3 may be to emit light beams having wavelengths different from each other. For example, in one or more embodiments, the display apparatus DD may include a first light emitting device ED-1 that emits red light, a second light emitting device ED-2 that emits green light, and a third light emitting device ED-3 that emits blue light. For example, in one or more embodiments, the red light emitting region PXA-R, the green light emitting region PXA-G, and the blue light emitting region PXA-B of the display apparatus DD may correspond to the first light emitting device ED-1, the second light emitting device ED-2, and the third light emitting device ED-3, respectively.

However, embodiments of the present disclosure are not limited thereto, and the first to third light emitting devices ED-1, ED-2, and ED-3 may be to emit light beams in substantially the same wavelength range or at least one light emitting device may be to emit a light beam in a wavelength range different from the others. For example, in some embodiments, the first to third light emitting devices ED-1, ED-2, and ED-3 may all emit blue light.

The light emitting regions PXA-R, PXA-G, and PXA-B in the display apparatus DD according to one or more embodiments may be arranged in a stripe form. Referring to FIG. 1, a plurality of red light emitting regions PXA-R may be arranged with each other along a second direction axis DR2, a plurality of green light emitting regions PXA-G may be arranged with each other along the second direction axis DR2, and a plurality of blue light emitting regions PXA-B may be arranged with each other along the second direction axis DR2. In addition, the red light emitting region PXA-R, the green light emitting region PXA-G, and the blue light emitting region PXA-B may be alternately arranged in this order along a first direction axis DR1.

FIG. 1 and FIG. 2 illustrate that all the light emitting regions PXA-R, PXA-G, and PXA-B have similar area, but embodiments of the present disclosure are not limited thereto. Thus, the light emitting regions PXA-R, PXA-G, and PXA-B may have different areas from each other according to the wavelength range of the emitted light. The areas of the light emitting regions PXA-R, PXA-G, and PXA-B may refer to areas when viewed on a plane defined by the first direction axis DR1 and the second direction axis DR2 (e.g., the areas in a plan view).

In one or more embodiments, an arrangement form of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality desired or required in the display apparatus DD. For example, in one or more embodiments, the arrangement form of the light emitting regions PXA-R, PXA-G, and PXA-B may be a pentile (PENTILE^{®}) arrangement form (for example, an RGBG matrix, an RGBG structure, or an RGBG matrix structure) or a diamond (Diamond Pixel^{™}) arrangement form (e.g., a display (e.g., an OLED display) containing red, blue, and green (RGB) light-emitting regions arranged in the shape of diamonds). PENTILE^{®} is a duly registered trademark of Samsung Display Co., Ltd. Diamond Pixel^{™} is a trademark of Samsung Display Co., Ltd.

In one or more embodiments, the areas of the light emitting regions PXA-R, PXA-G, and PXA-B may be different from each other. For example, in one or more embodiments, the area of the green light emitting region PXA-G may be smaller than that of the blue light emitting region PXA-B, but embodiments of the present disclosure are not limited thereto.

Hereinafter, FIG. 3 to FIG. 6 are each a cross-sectional view schematically showing a light emitting element according to one or more embodiments of the present disclosure. The light emitting element ED of one or more embodiments may include a first electrode EL1, a hole transport region HTR, an emission layer EML, an electron transport region ETR, and a second electrode EL2 stacked in the stated order.

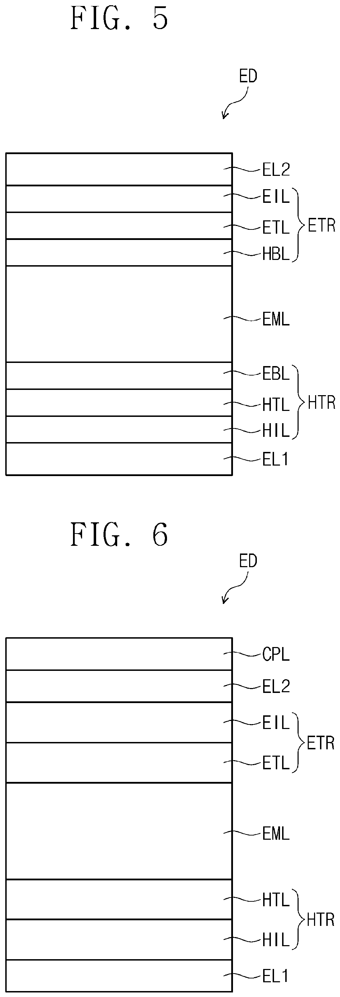

Compared with FIG. 3, FIG. 4 illustrates a cross-sectional view of a light emitting element ED of one or more embodiments, in which a hole transport region HTR includes a hole injection layer HIL and a hole transport layer HTL, and an electron transport region ETR includes an electron injection layer EIL and an electron transport layer ETL. In addition, compared with FIG. 3, FIG. 5 illustrates a cross-sectional view of a light emitting element ED of one or more embodiments, in which a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. Compared with FIG. 4, FIG. 6 illustrates a cross-sectional view of a light emitting element ED of one or more embodiments including a capping layer CPL arranged on a second electrode EL2.

The first electrode EL1 has conductivity (e.g., is a conductor). The first electrode EL1 may be formed of a metal material, a metal alloy, and/or a conductive compound. The first electrode EL1 may be an anode or a cathode. However, embodiments of the disclosure are not limited thereto. In one or more embodiments, the first electrode EL1 may be a pixel electrode. The first electrode EL1 may be a transmissive electrode, a transflective electrode, or a reflective electrode. The first electrode EL1 may include at least one selected from among silver (Ag), magnesium (Mg), copper (Cu), aluminum (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), zinc (Zn), a compound of two or more selected therefrom, a mixture of two or more selected therefrom, and/or an oxide thereof.

If (e.g., when) the first electrode EL1 is a transmissive electrode, the first electrode EL1 may include a transparent metal oxide such as indium tin oxide (ITO), indium zinc oxide (IZO), zinc oxide (ZnO), and/or indium tin zinc oxide (ITZO). If (e.g., when) the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (e.g., a mixture of Ag and Mg). In one or more embodiments, the first electrode EL1 may have a multilayer structure including a reflective film or a transflective film formed of one or more of the above-described materials, and a transparent conductive film formed of ITO, IZO, ZnO, ITZO, and/or the like. For example, the first electrode EL1 may have a three-layer structure of ITO/Ag/ITO, but embodiments of the present disclosure are not limited thereto. In addition, embodiments of the present disclosure are not limited thereto, and the first electrode EL1 may include one of the above-described metal materials, one or more combinations of at least two metal materials of the above-described metal materials, any oxide of the above-described metal materials, and/or the like. A thickness of the first electrode EL1 may be from about 700 ångström (Å) to about 10,000 Å. For example, in one or more embodiments, the thickness of the first electrode EL1 may be from about 1,000 Å to about 3,000 Å.

The hole transport region HTR may be provided on the first electrode EL1. The hole transport region HTR may include at least one of a hole injection layer HIL, a hole transport layer HTL, a buffer layer or an emission-auxiliary layer, or an electron blocking layer EBL. A thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, in one or more embodiments, the hole transport region HTR may have a single layer structure of a hole injection layer HIL or a hole transport layer HTL, or may have a single layer structure formed of a hole injection material and a hole transport material. In one or more embodiments, the hole transport region HTR may have a single layer structure formed of a plurality of different materials, or a structure in which a hole injection layer HIL/hole transport layer HTL, a hole injection layer HIL/hole transport layer HTL/buffer layer, a hole injection layer HIL/buffer layer, a hole transport layer HTL/buffer layer, or a hole injection layer HIL/hole transport layer HTL/electron blocking layer EBL are stacked in order (e.g., in the stated order) from the first electrode EL1, but embodiments of the present disclosure are not limited thereto.

The hole transport region HTR may be formed using one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the hole transport region HTR may include a compound represented by Formula H-1:

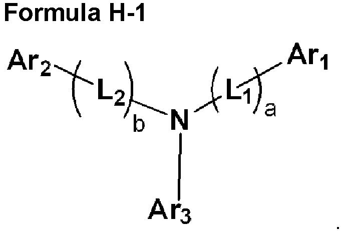

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. In one or more embodiments, if (e.g., when) a or b is an integer of 2 or greater, a plurality of L₁'s and L₂'s may each independently be a substituted or unsubstituted arylene group having 6 to 30 ring-forming carbon atoms or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. In addition, in Formula H-1, Ar₃ may be a substituted or unsubstituted aryl group having 6 to 30 ring-forming carbon atoms or a substituted or unsubstituted heteroaryl group having 2 to 30 ring-forming carbon atoms.

In one or more embodiments, the compound represented by Formula H-1 may be a monoamine compound. In one or more embodiments, the compound represented by Formula H-1 may be a diamine compound in which at least one selected from among Ar₁ to Ar₃ includes an amine group as a substituent. In one or more embodiments, the compound represented by Formula H-1 may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be any one selected from among compounds in Compound Group H. However, the compounds listed in Compound Group H are mere examples, and the compounds represented by Formula H-1 are not limited to those represented in Compound Group H:

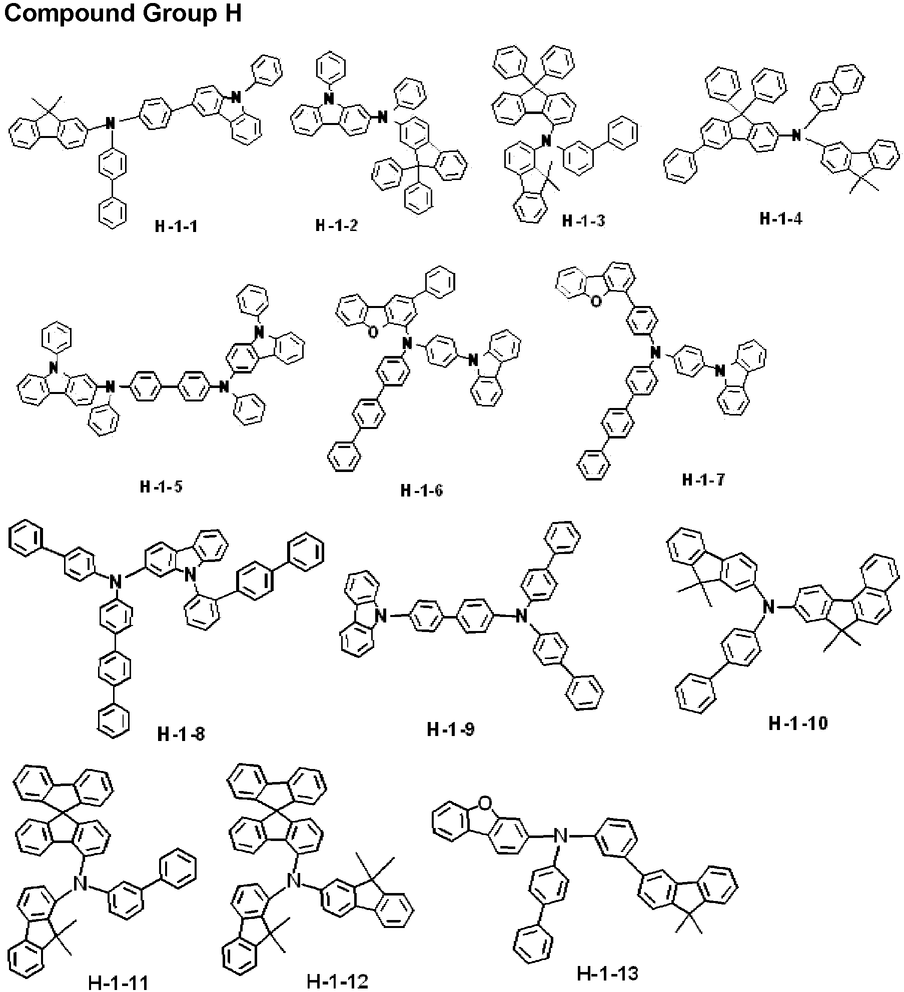

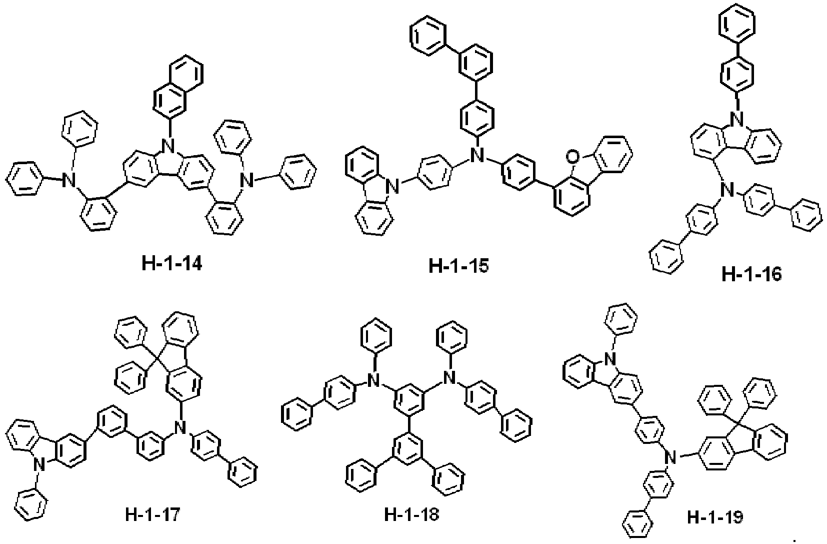

In one or more embodiments, the hole transport region HTR may include at least one selected from among a phthalocyanine compound such as copper phthalocyanine; N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N-(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalen-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), and/or the like.

In one or more embodiments, the hole transport region HTR may include at least one selected from among a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalen-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In one or more embodiments, the hole transport region HTR may include at least one selected from 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include one or more of the above-described compounds of the hole transport region in at least one of a hole injection layer HIL, a hole transport layer HTL, or an electron blocking layer EBL.

A thickness of the hole transport region HTR may be from about 100 Å to about 10,000 Å, for example, from about 100 Å to about 5,000 Å. When the hole transport region HTR includes a hole injection layer HIL, the hole injection layer HIL may have, for example, a thickness of about 30 Å to about 1,000 Å. When the hole transport region HTR includes a hole transport layer HTL, the hole transport layer HTL may have a thickness of about 250 Å to about 1,000 Å. For example, if (e.g., when) the hole transport region HTR includes an electron blocking layer EBL, the electron blocking layer EBL may have a thickness of about 10 Å to about 1,000 Å. If (e.g., when) the thicknesses of the hole transport region HTR, the hole injection layer HIL, the hole transport layer HTL, and the electron blocking layer EBL satisfy the above-described ranges, satisfactory hole transport properties may be achieved without a substantial increase in driving voltage.

In one or more embodiments, the hole transport region HTR may further include a charge generating material to increase conductivity (e.g., electric conductivity) in addition to the above-described materials. The charge generating material may be dispersed uniformly (e.g., substantially uniformly) or non-uniformly in the hole transport region HTR. The charge generating material may be, for example, a p-dopant. The p-dopant may include at least one of a halogenated metal compound, a quinone derivative, a metal oxide, or a cyano group-containing compound, but embodiments of the present disclosure are not limited thereto. For example, in one or more embodiments, the p-dopant may include a metal halide compound such as Cul and/or Rbl, a quinone derivative such as tetracyanoquinodimethane (TCNQ) and/or 2,3,5,6-tetrafluoro-7,7,8,8-tetracyanoquinodimethane (F4-TCNQ), a metal oxide such as tungsten oxide and/or molybdenum oxide, a cyano group-containing compound such as dipyrazino[2,3-f: 2',3'-h] quinoxaline-2,3,6,7,10,11-hexacarbonitrile (HATCN) and/or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, but embodiments of the present disclosure are not limited thereto.

As described above, the hole transport region HTR may further include at least one of the buffer layer or the electron blocking layer EBL in addition to the hole injection layer HIL and the hole transport layer HTL. The buffer layer may compensate for a resonance distance according to the wavelength of light emitted from the emission layer EML and may thus increase light emission efficiency. A material that may be included in the hole transport region HTR may be used as a material to be included in the buffer layer. The electron blocking layer EBL is a layer that serves to prevent or reduce the electron injection from the electron transport region ETR to the hole transport region HTR.

The emission layer EML may be provided on the hole transport region HTR. The emission layer EML may have a thickness of, for example, about 100 Å to about 1000 Å, or about 100 Å to about 300 Å. The emission layer EML may have a single layer formed of a single material, a single layer formed of a plurality of different materials, or a multi-layered structure having a plurality of layers formed of a plurality of different materials.

The light emitting element ED according to one or more embodiments may include a fused polycyclic compound represented by Formula 1 in at least one functional layer arranged between the first electrode EL1 and the second electrode EL2. In the light emitting element ED according to one or more embodiments, the emission layer EML may include the fused polycyclic compound according to one or more embodiments. In one or more embodiments, the emission layer EML may include the fused polycyclic compound according to one or more embodiments as a dopant. The fused polycyclic compound according to one or more embodiments may be a dopant material of the emission layer EML. In the present disclosure, as used herein, the fused polycyclic compound according to one or more embodiments may be referred to as a first compound.

The fused polycyclic compound according to one or more embodiments may include a fused structure of a plurality of aromatic rings via a boron atom and a nitrogen atom. The fused polycyclic compound according to one or more embodiments may include a fused structure of a plurality of aromatic rings via one boron atom and two nitrogen atoms. The fused polycyclic compound according to one or more embodiments may include a fused structure of a plurality of aromatic rings via a first boron atom, a first nitrogen atom, and a second nitrogen atom. For example, the fused polycyclic compound according to one or more embodiments may include a fused ring, which is formed by fusing a plurality of aromatic rings via one boron atom, a first nitrogen atom, and a second nitrogen atom.

The fused polycyclic compound according to one or more embodiments may include a fused structure of first to third aromatic rings (i.e., first aromatic ring, second aromatic ring, and third aromatic ring) via a fist boron atom, a first skeletal atom, and a second skeletal atom. The first aromatic ring, the second aromatic ring, and the third aromatic rings may be each connected to the first boron atom, the first aromatic ring and the third aromatic ring may be further connected via the first skeletal atom, and the second aromatic ring and the third aromatic ring may be further connected via the second skeletal atom. In one or more embodiments, as used herein, the first boron atom, the first skeletal atom, and the second skeletal atom, and a fused structure formed by fusing the first to third aromatic rings via the first boron atom, the first skeletal atom, and the second skeletal atom may be referred to as "a fused ring core". In one or more embodiments, the first skeletal atom may be a nitrogen atom. The second skeletal atom may be a nitrogen atom, a carbon atom, an oxygen atom, a sulfur atom, a selenium atom, or a phosphorus atom.

In one or more embodiments, the first to third aromatic rings may each independently be a substituted or unsubstituted monocyclic aromatic hydrocarbon ring having 6 to 30 ring-forming carbons. In one or more embodiments, the first to third aromatic hydrocarbon rings may each independently be a six-membered aromatic hydrocarbon ring. For example, in one or more embodiments, the first to third aromatic hydrocarbon rings may each independently be a benzene ring.

The fused polycyclic compound according to one or more embodiments may include a first substituent connected to the first skeletal atom. The first substituent may include a biphenyl moiety and a second substituent connected to the biphenyl moiety. The first substituent may include a 2-biphenyl moiety and the second substituent may be connected to a second carbon of the 2-biphenyl moiety. For example, in the 2-biphenyl moiety of the first substituent, the second benzene ring may be connected to the second carbon of the first benzene ring that is connected to the first skeletal atom, and a second substituent such as an aryl group or a heteroaryl group may be connected to the second carbon of the second benzene ring. In the present disclosure, the structure and the carbon number of the first substituent may be the same as descriptions represented by Formula S.

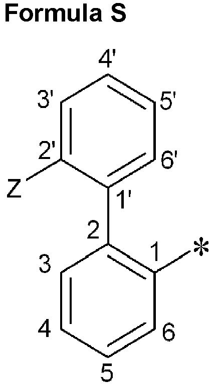

For convenience of explanation, in Formula S, 3 to 6 carbon positions, and 3' to 6' carbon positions of the biphenyl moiety are each illustrated to be unsubstituted for illustrative purposes, but a substituent may be substituted (e.g., be present) at each carbon position.

In Formula S, Z is the above-described second substituent. Z may be, for example, a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons.

In Formula S, * is a position at which the first skeletal atom is connected.

In one or more embodiments, the first substituent may be directly bonded to the first nitrogen atom of the fused ring core without a linker (e.g., without an additional linker).

The fused polycyclic compound according to one or more embodiments is represented by Formula 1.

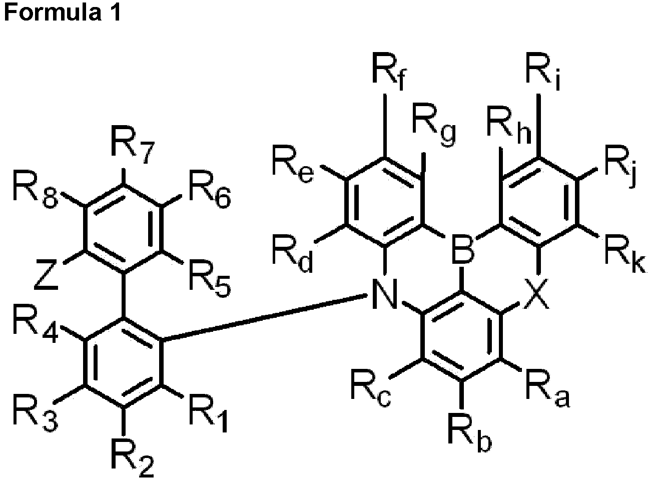

The fused polycyclic compound according to one or more embodiments represented by Formula 1 includes a structure in which three aromatic rings are fused via one boron atom, a first nitrogen atom, and a second additional atom included in X. In the present disclosure, as used herein, in Formula 1, a benzene ring that is substituted with substituents represented by R_{d} to R_{d} corresponds to the above-described first aromatic ring, a benzene ring that is substituted with substituents represented by Rₕ to Rₖ corresponds to the above-described second aromatic ring, and a benzene ring that is substituted with substituents represented by Rₐ to R_{c} corresponds to the above-described third aromatic ring. In Formula 1, the nitrogen atom corresponds to the above-described first skeletal atom, and X corresponds to a chemical moiety including or consisting of the above-described second skeletal atom. In Formula 1, the biphenyl moiety that is connected to the nitrogen atom and includes a substituent Z corresponds to the above-described first substituent, and the substituent Z corresponds to the second substituent.

In Formula 1, X is a direct linkage, O, S, Se, CR₃₁R₃₂, PR₃₃, SiR₃₄R₃₅, C=O, C=S, or NR₃₆. For example, in one or more embodiments, X may be O, S, Se, CR₃₁R₃₂, PR₃₃, SiR₃₄R₃₅, C=O, or NR₃₆.

In Formula 1, Z is a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons. For example, in one or more embodiments, Z may be a substituted or unsubstituted phenyl group, a substituted or unsubstituted biphenyl group, a substituted or unsubstituted phenyloxy group, a substituted or unsubstituted phenylthiol group, a substituted or unsubstituted diphenylamine group, a substituted or unsubstituted benzofuran group, a substituted or unsubstituted benzothiophene group, a substituted or unsubstituted carbazole group, a substituted or unsubstituted dibenzofuran group, or a substituted or unsubstituted dibenzothiophene group.

In Formula 1, R₁ to R₈, Rₐ to Rₖ, and R₃₁ to R₃₆ are each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group 6 to 30 ring-forming carbons, or a substituted or unsubstituted heteroaryl group having 2 to 30 ring-forming carbons. In one or more embodiments, any one selected from among R₁ to R₈, Rₐ to Rₖ, and R₃₁ to R₃₆ may be bonded to an adjacent group to form a ring. For example, in one or more embodiments, R₁ may be hydrogen, deuterium, a substituted or unsubstituted phenyl group, a substituted or unsubstituted biphenyl group, a substituted or unsubstituted oxy group, or a substituted or unsubstituted amine group. For example, in one or more embodiments, R₂ to R₈ may each independently be hydrogen, deuterium, a substituted or unsubstituted methyl group, a substituted or unsubstituted t-butyl group, or a substituted or unsubstituted phenyl group. For example, in one or more embodiments, Rₐ to Rₖ may each independently be hydrogen, deuterium, a halogen, a substituted or unsubstituted oxy group, a substituted or unsubstituted thio group, a substituted or unsubstituted amine group, a substituted or unsubstituted boron group, a substituted or unsubstituted methyl group, a substituted or unsubstituted t-butyl group, a substituted or unsubstituted carbonyl group, a substituted or unsubstituted phenyl group, a substituted or unsubstituted biphenyl group, a substituted or unsubstituted dibenzofuran group, a substituted or unsubstituted carbazole group, a substituted or unsubstituted phenoxazine group, or substituted or unsubstituted phenothiazine group. For example, in one or more embodiments, R₃₁ to R₃₆ may each independently be a substituted or unsubstituted methyl group, a substituted or unsubstituted phenyl group, a substituted or unsubstituted biphenyl group, a substituted or unsubstituted terphenyl group, a substituted or unsubstituted quarter phenyl group, or a substituted or unsubstituted quinone phenyl group. In one or more embodiments, Rₑ and Rf, Rᵢ and Rⱼ, which are adjacently arranged, are each independently coupled together to form an additional hydrocarbon ring or hetero ring. In one or more embodiments, X may be NR₃₆, and R₃₆ and Rₐ, Rₐ and R_{b}, which are adjacently arranged, are each independently coupled together to form an additional hydrocarbon ring or hetero ring.

In one or more embodiments, in Formula 1, if (e.g., when) any one selected from among R₁ to R₈, Rₐ to Rₖ, and R₃₁ to R₃₆ is coupled with an adjacent group to form a ring, the formed ring does not include consecutive two *sp³* carbons by bonding to each other. If (e.g., when) any one selected from among R₁ to R₈, Rₐ to Rₖ, and R₃₁ to R₃₆ is coupled with an adjacent group to form a ring, the formed ring does not include a structure, as shown in Formula X, containing consecutive two *sp³* carbons by bonding to each other.

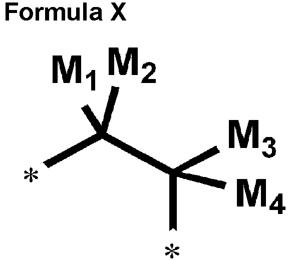

Formula X shows a case where M₁ to M₄ are each an arbitrary substituent, and the first carbon substituted with M₁ and M₂, and the second carbon substituted with M₃ and M₄, are all *sp³* hybridized carbons. In the fused polycyclic compound according to one or more embodiments, represented by Formula 1, if (e.g., when) any one selected from among R₁ to R₈, Rₐ to Rₖ, and R₃₁ to R₃₆ is bonded to an adjacent group to form a ring, the formed ring may not have a saturated hydrocarbon structure as Formula X. In Formula X, -* is a connection position.

In one or more embodiments, in Formula 1, if (e.g., when) some selected from among R₁ to R₈, Rₐ to Rₖ, and R₃₁ to R₃₆ are each bonded to an adjacent group to form a ring, the formed ring may be an aromatic ring.

In one or more embodiments, in Formula 1, if (e.g., when) Z is a substituted or unsubstituted aryl group, R₅ may not be a substituted or unsubstituted aryl group. In one or more embodiments, in Formula 1, if (e.g., when) Z is a substituted or unsubstituted aryl group, R₅ may be hydrogen or deuterium.

In one or more embodiments, in Formula 1, R_{d} to Rₖ may each independently be hydrogen, deuterium, a substituted or unsubstituted methyl group, a substituted or unsubstituted t-butyl group, or any one selected from among substituents represented by Formula a-1 to Formula a-8.

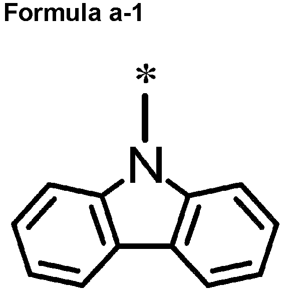

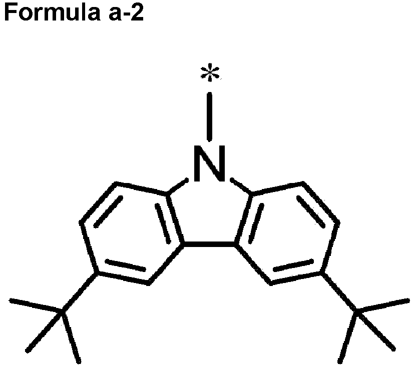

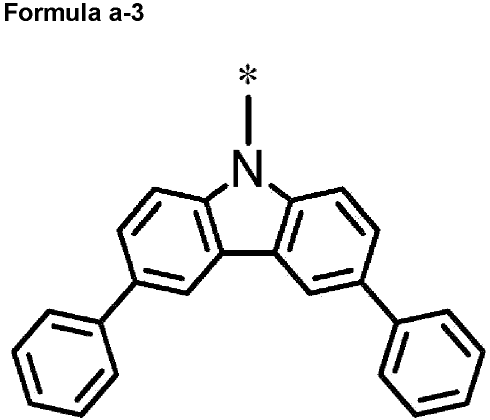

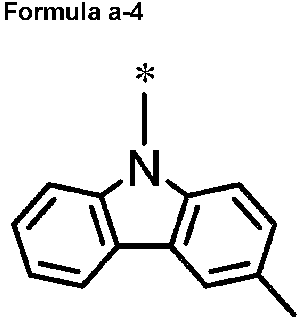

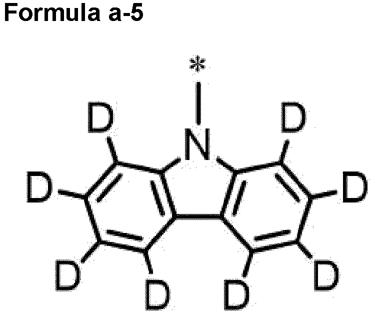

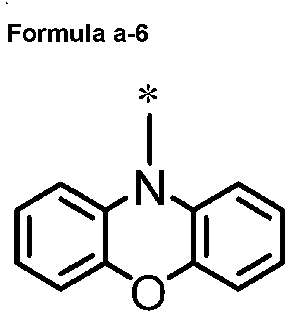

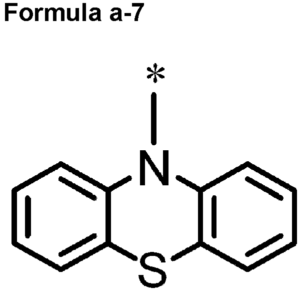

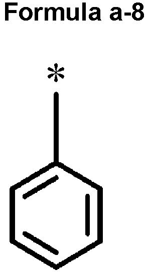

In Formula a-1 to Formula a-8, *- refers to a position at which the fused ring core of the fused polycyclic compound represented by Formula 1 is connected.

In one or more embodiments, in Formula 1, Rₐ to R_{c} may each independently be hydrogen, deuterium, a substituted or unsubstituted methyl group, a substituted or unsubstituted isopropyl group, or a substituted or unsubstituted t-butyl group, or any one selected from among substituents represented by Formula b-1 to Formula b-9.

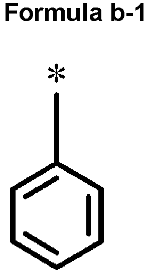

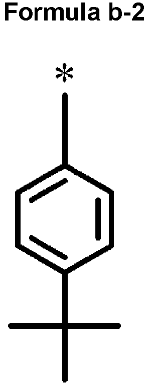

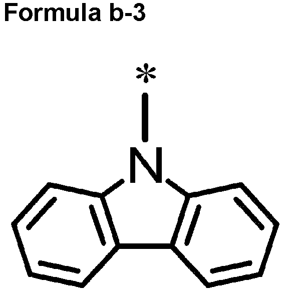

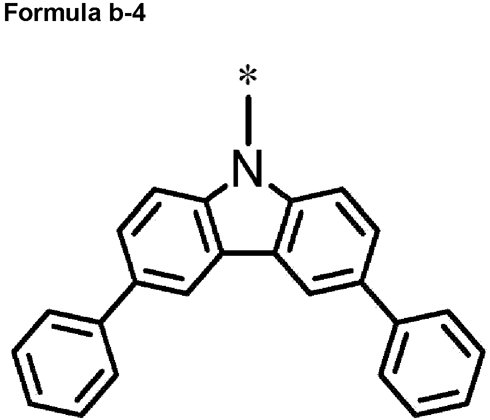

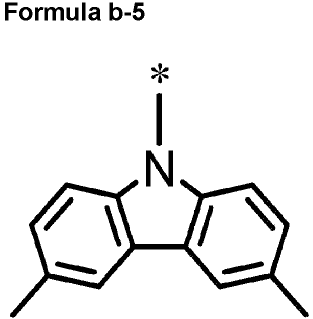

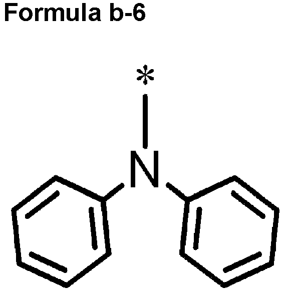

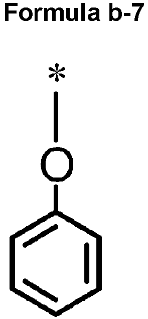

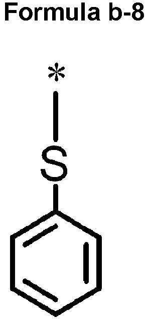

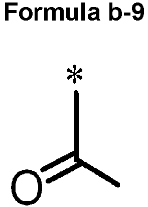

In Formula b-1 to Formula b-9, *- refers to a position at which the fused ring core of the fused polycyclic compound represented by Formula 1 is connected.

The fused polycyclic compound according to one or more embodiments, represented by Formula 1, has a structure, in which the first substituent is connected to the fused ring core, and thus may achieve high efficiency and a long lifespan.

The fused polycyclic compound according to one or more embodiments includes a "fused ring core" of five rings, which is formed by fusing the first to third aromatic rings via a boron atom, a first skeletal atom, and a second skeletal atom. In addition, the fused polycyclic compound according to one or more embodiments includes the first substituent connecting to the first skeletal atom of the fused ring core. The fused polycyclic compound according to one or more embodiments represented by Formula 1, includes the first substituent, thereby capable of achieving high luminous efficiency and long lifespan.

The first substituent may include a 2-biphenyl moiety and the second substituent may be connected to a second carbon of the 2-biphenyl moiety. The first substituent has a biphenyl moiety represented by Formula S and is connected to the nitrogen atom, which is the first skeletal atom, at the first carbon position of the biphenyl moiety shown in Formula S. The first substituent is substituted, at a position of the second carbon, with a second substituent, which may be an oxy group, a thio group, an amine group, an aryl group, or a heteroaryl group. The fused polycyclic compound according to one or more embodiments includes the first substituent connecting to the nitrogen atom of the fused ring core, and a trigonal planar structure of the boron atom may be effectively maintained through steric hindrance effect caused by the first substituent having a high steric bulkiness. The boron atom has electron-deficiency characteristics due to an unoccupied p-orbital and thus may form a bond with another nucleophile, and a structure thereof may change into a tetrahedral structure, which may cause device deterioration. According to one or more embodiments of the present disclosure, because the first substituent is used in the fused ring core of the fused polycyclic compound, the unoccupied p-orbital of the boron atom may be effectively protected, a deterioration phenomenon due to the structural deformation may be prevented or reduced.

In addition, in the fused polycyclic compound according to one or more embodiments, an intermolecular reaction may be suppressed or reduced due to a steric hindrance effect caused by the first substituent, and thus aggregation and a formation of an excimer or exciplex may be controlled or managed, which may lead to increasing luminous efficiency. Because the fused polycyclic compound according to one or more embodiments represented by Formula 1 has a bulky structure due to an introduction of the first substituent having a large volume, an intermolecular distance increases, and thus Dexter energy transfer may decrease. Therefore, an increase in a concentration of triplet excitons in the fused polycyclic compound may be suppressed or reduced. The triplet excitons having a high concentration remaining in an excited state for a long time may cause compound decomposition and generation of hot excitons having high energy through triplet-triplet annihilation (TTA). Therefore, the destruction of structures of peripheral compounds may be caused or induced. In addition, the triplet-triplet annihilation is a bimolecular reaction, which quickly exhausts the triplet excitons used for light emission, and thus a decrease in luminous efficiency may be caused by non-radiative transition. In the fused polycyclic compound according to one or more embodiments, an intermolecular distance increases due to the first substituent, and thus Dexter energy transfer may be suppressed or reduced. Therefore, deterioration of the lifespan of the fused polycyclic compound due to an increase in the concentration of the triplet excitons may be suppressed or reduced. Therefore, if (e.g., when) the fused polycyclic compound according to one or more embodiments is used in the emission layer EML of the light emitting element ED, not only may the luminous efficiency increase, but the element lifespan may also be improved.

Because the fused polycyclic compound according to one or more embodiments includes the first substituent, it is characterized that a higher excited triplet energy level (Tn level, where n is 2 or more) adjacent to a lowest excited singlet energy level (S1 level) may exhibit relatively low. In one or more embodiments, in the fused polycyclic compound according to one or more embodiments, represented by Formula 1, a difference (ΔE_{S1Tn}) between the lowest excited singlet energy level (S1 level) and a higher excited triplet energy level (Tn level, where n is 2 or greater) adjacent to the lowest excited singlet energy level (S1 level) may be about 0.6 eV or less. In one or more embodiments, in the fused polycyclic compound according to one or more embodiments, represented by Formula 1, the energy level difference (ΔE_{S1Tn}) between the lowest excited singlet energy level (S1 level) and a higher excited triplet energy level (Tn level) adjacent to the lowest excited singlet energy level (S1 level) may be about 0.2 eV or less. For example, in the fused polycyclic compound according to one or more embodiments, including the first substituent, a difference (ΔE_{S1Tn}) between the lowest excited singlet energy level and the second excited triplet energy level (T2 level) may be about 0.2 eV or less.

In a compound exhibiting thermally activated delayed fluorescence characteristics, an inter system crossing (ICS) occurs where an exciton is transferred from the lowest singlet energy level to a triplet energy level, and thereafter, a reverse inter system crossing (RISC) occurs where the exciton is transferred from the triplet energy level to the lowest singlet energy level. Finally, the exciton is transferred and relaxed from the singlet energy level to a ground state to show/emit delayed fluorescence. Herein, a thermally activated delayed fluorescence mechanism may include passing through and/or involving a higher triplet energy level (Tn level) as well as the lowest triplet energy level (T1 level) during the inter system crossing (ISC) and reverse intersystem crossing (RISC) processes. Because the fused polycyclic compound according to one or more embodiments includes the first substituent, it is characterized that the higher excited triplet energy level (Tn level) adjacent to the lowest excited singlet energy level (S1 level) is low. Accordingly, a spin-flip may increase. As used herein, the spin-flip may refer to a phenomenon in which the exciton of the higher excited triplet energy level (Tn level) is transferred to the lowest excited singlet energy level (S1 level) due to a spin-orbit coupling (SOC) between the lowest excited singlet energy level (S1 level) and the higher excited triplet energy level (Tn level) adjacent thereto. Therefore, because the fused polycyclic compound according to one or more embodiments exhibits characteristics in that the higher excited triplet energy level (Tn level) adjacent to the lowest excited singlet energy level (S1 level) is low, a reverse inter system crossing (RISC) rate may increase via the higher excited triplet energy level (Tn level) to the lowest excited singlet energy level (S1 level), and a delayed fluorescence lifespan/lifetime (Tau, τ) may decrease, which may lead to improvements in luminous efficiency and lifespan characteristics of the fused polycyclic compound.

According to one or more embodiments, the fused polycyclic compound represented by Formula 1 may be represented by any one selected from among Formula 2-1 to Formula 2-8.

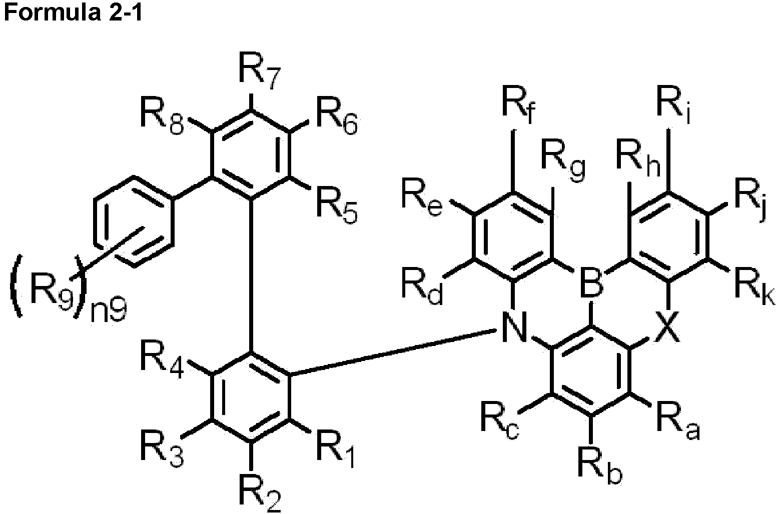

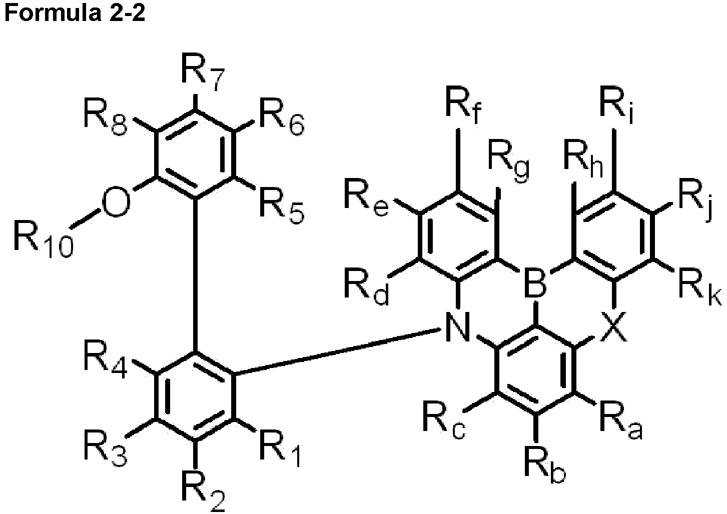

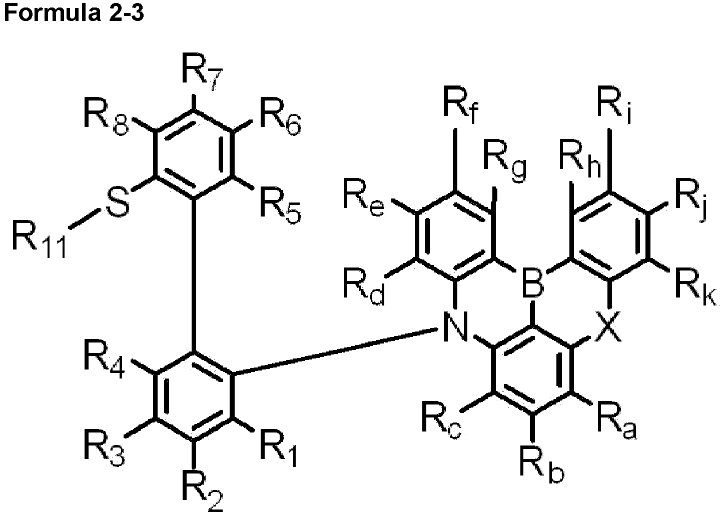

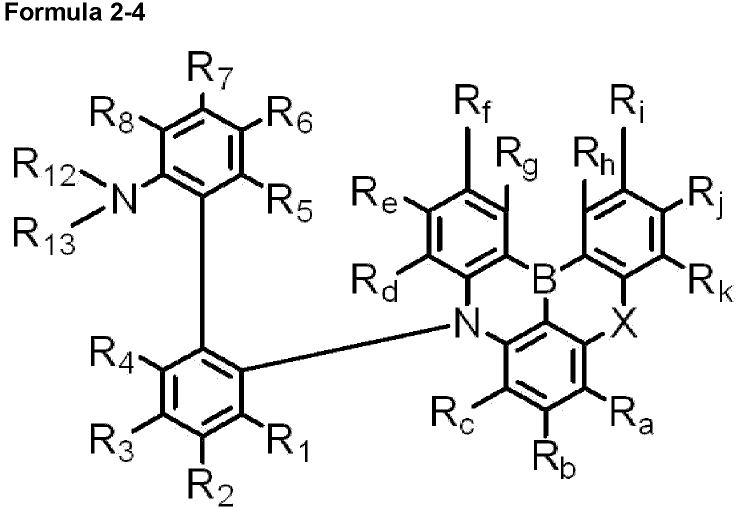

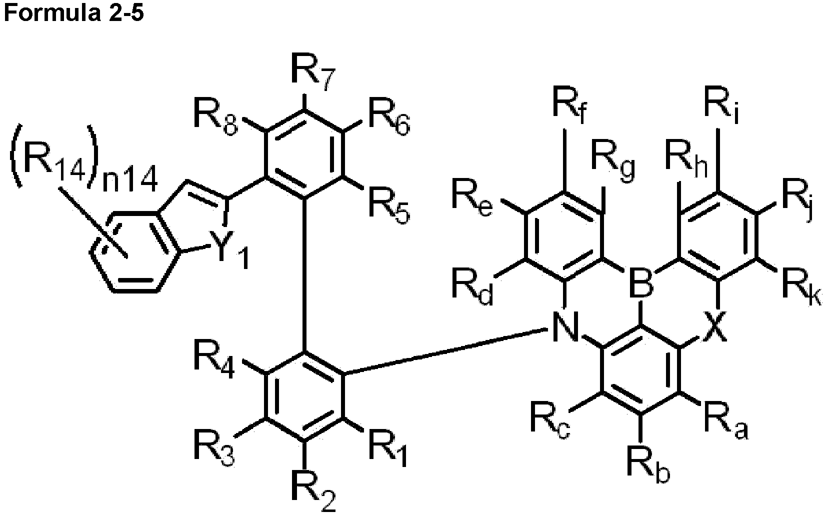

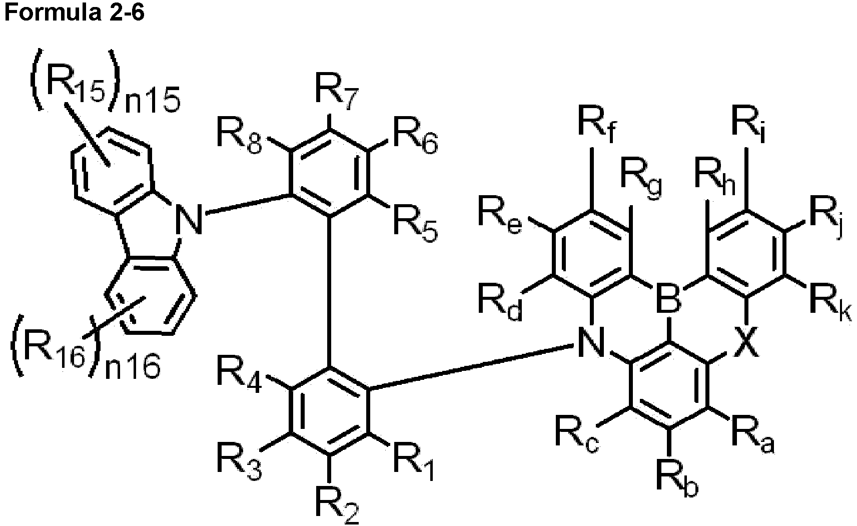

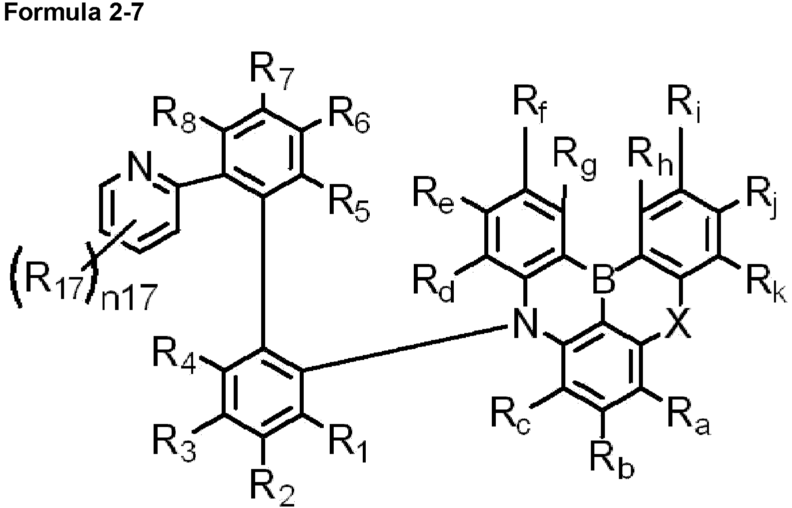

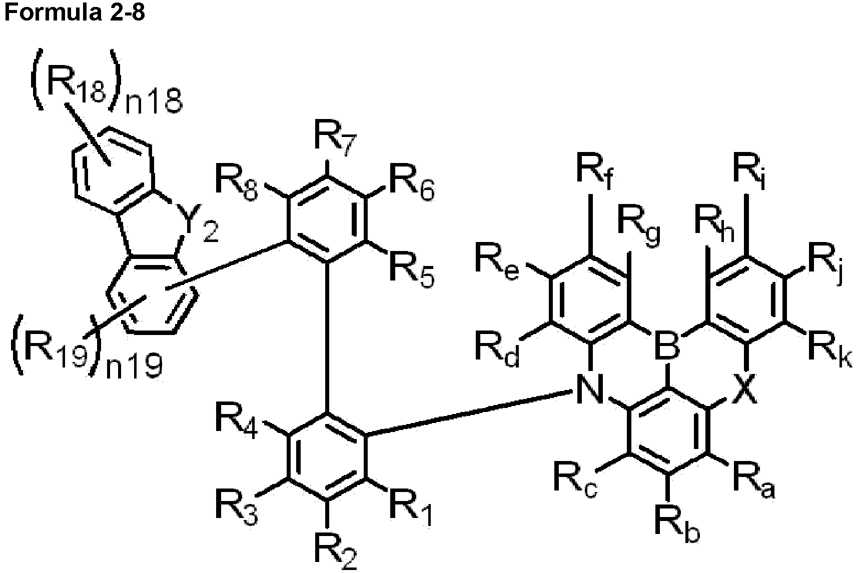

Formula 2-1 to Formula 2-8 are formulae showing specified embodiments of substituent Z in Formula 1.

In Formula 2-1 to Formula 2-8, R₉ to R₁₉ may each independently be hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons. For example, in one or more embodiments, R₉ to R₁₉ may each independently be hydrogen, deuterium, a halogen, a substituted or unsubstituted methyl group, a substituted or unsubstituted t-butyl group, or a substituted or unsubstituted phenyl group.

In Formula 2-5 and Formula 2-8, Y₁ and Y₂ may each independently be a or S.

In Formula 2-1, n9 may be an integer of 0 to 5. If (e.g., when) n9 is 0 in Formula 2-1, it refers to that the fused polycyclic compound according to one or more embodiments is unsubstituted with R₉. An embodiment in which n9 is 5 and all R₉(s) are each hydrogen in Formula 2-1 is the same as the embodiment in which n9 is 0. In Formula 2-1, if (e.g., when) n9 is an integer of 2 or greater, R₉(s) provided in plurality may be all the same, or at least one selected from among the plurality of R₉(s) may be different.

In Formula 2-5 to Formula 2-8, n14 to n18 may each independently be an integer of 0 to 4. In Formula 2-5 to Formula 2-8, embodiments in which n14 to n18 are each 0 refer to that the fused polycyclic compound according to one or more embodiments may be unsubstituted with R₁₄ to R₁₈, respectively. In Formula 2-5 to 2-8, embodiments in which n14 to n18 are each 4 and R₁₄ to R₁₈ are each all hydrogen may be the same as the embodiments in which n14 to n18 are each 0, respectively. In Formula 2-5 to Formula 2-8, if (e.g., when) n14 to n18 are each an integer of 2 or greater, R₁₄(s) to R₁₈(s) each provided in plurality may be all the same, or at least one selected from among R₁₄(s) to R₁₈(s) provided in the plurality may be different.

In Formula 2-8, n19 may be an integer 0 to 3. In Formula 2-8, an embodiment in which n19 is 0 may refer to the fused polycyclic compound according to one or more embodiments is unsubstituted with R₁₉. In Formula 2-8, an embodiment in which n19 is 3 and R₁₉(s) are each hydrogen atoms may be the same as the embodiment in which n19 is 0. In Formula 2-8, if (e.g., when) n19 is an integer of 2 or greater, R₁₉(s) provided in plurality may be all the same, or at least one selected from among the plurality of R₁₉(s) may be different.

In Formula 2-1 to Formula 2-8, the descriptions described in Formula 1 may be similarly applied to X, R₁ to R₈, Rₐ to Rₖ, and R₃₁ to R₃₆.

In one or more embodiments, the fused polycyclic compound represented by Formula 1 may be represented by any one selected from among Formula 3-1 and Formula 3-2.

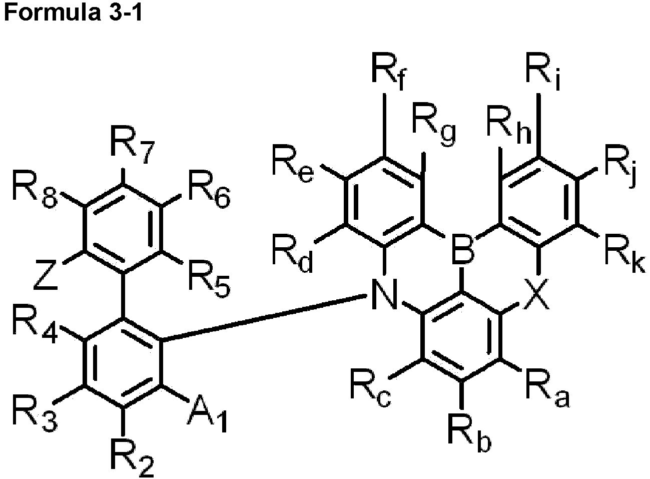

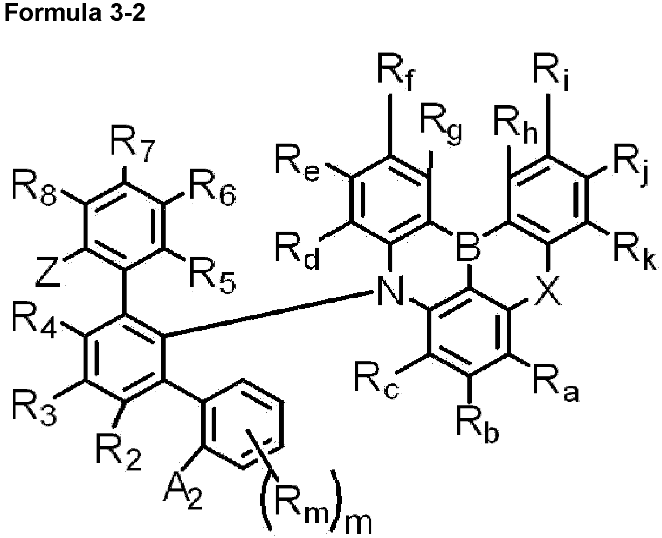

In Formula 3-1, A₁ may be hydrogen, deuterium, a substituted or unsubstituted oxy group, or a substituted or unsubstituted amine group. For example, in one or more embodiments, A₁ may be hydrogen, deuterium, a substituted or unsubstituted phenyloxy group, or a substituted or unsubstituted diphenylamine group.

In Formula 3-2, A₂ may be hydrogen, deuterium, a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons. For example, in one or more embodiments, A₂ may be hydrogen, deuterium, a substituted or unsubstituted phenyl group, a substituted or unsubstituted biphenyl group, a substituted or unsubstituted phenyloxy group, a substituted or unsubstituted phenylthio group, a substituted or unsubstituted diphenylamine group, a substituted or unsubstituted benzofuran group, a substituted or unsubstituted benzothiophene group, or a substituted or unsubstituted carbazole group.

In one or more embodiments, in Formula 3-2, Z and A₂ may be the same. For example, in some embodiments, Z and A₂ may be a phenyl group having the same structure. For example, Z and A₂ may be each an unsubstituted phenyl group.

In Formula 3-2, Rₘ may be hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons. For example, in one or more embodiments, Rₘ may be hydrogen, deuterium, a substituted or unsubstituted methyl group, a substituted or unsubstituted t-butyl group, or a substituted or unsubstituted phenyl group.

In Formula 3-2, m may be an integer of 0 to 4. In Formula 3-2, an embodiment in which m is 0 may refer to the fused polycyclic compound according to one or more embodiments is unsubstituted with Rₘ. In Formula 3-2, an embodiment in which m is 4 and Rₘ(s) are each hydrogen may be the same as the embodiment in which m is 0. In Formula 3-2, if (e.g., when) m is an integer of 2 or greater, Rₘ(s) provided in plurality may be all the same, or at least one selected from among the plurality of Rₘ(s) may be different.

In Formula 3-1 and Formula 3-2, the descriptions described in Formula 1 may be similarly applied to X, Z, R₂ to R₈, Rₐ to Rₖ, and R₃₁ to R₃₆.

In one or more embodiments, the fused polycyclic compound represented by Formula 1 may be represented by any one selected from among Formula 4-1 to Formula 4-4.

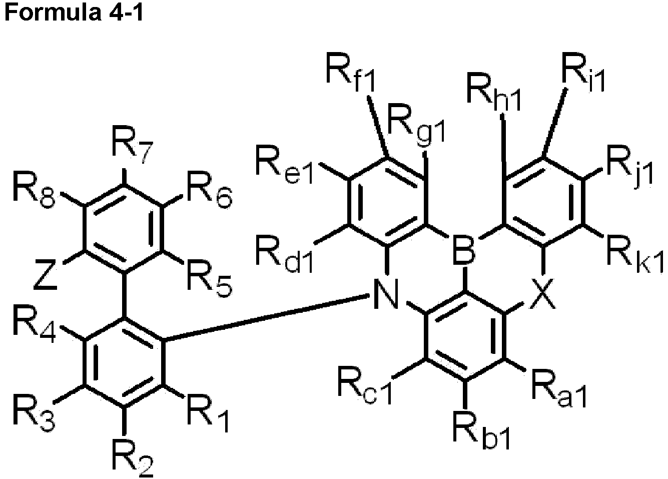

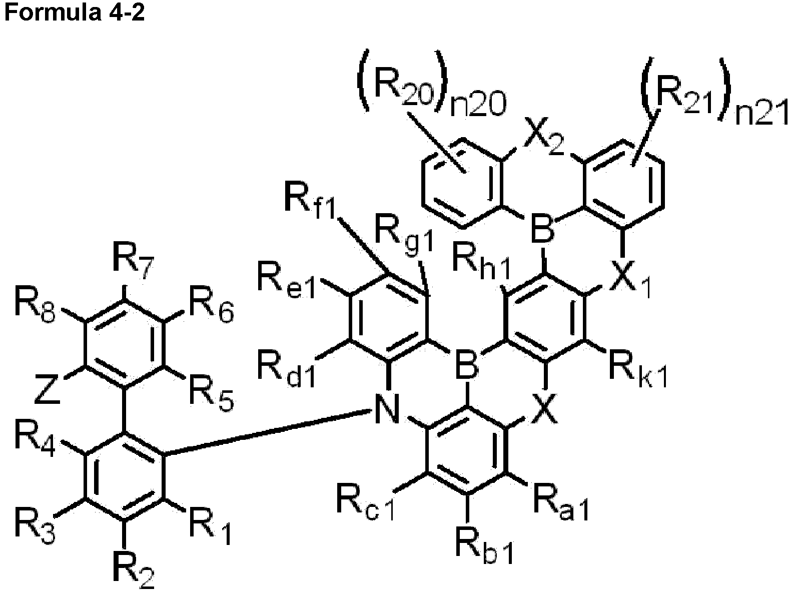

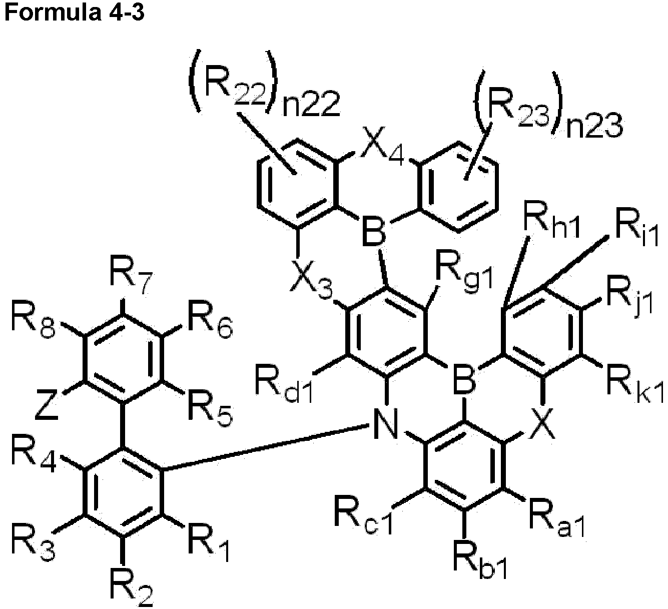

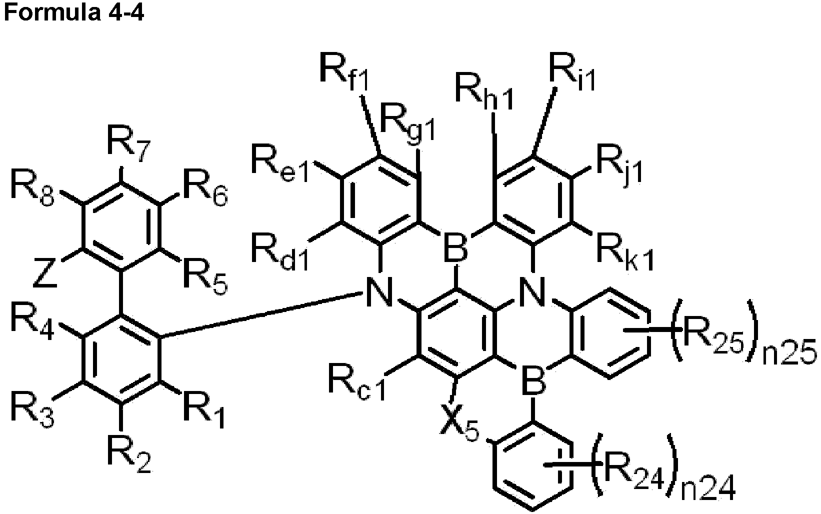

In Formula 4-1 to Formula 4-4, X₁ to X₅ may each independently be O, S, CR₂₆R₂₇, or NR₂₈. For example, in one or more embodiments, X₁ to X₅ may be each N R2a.

In Formula 4-1 to Formula 4-4, Rₐ₁ to Rₖ₁, and R₂₀ to R₂₈ may each independently be hydrogen, deuterium, a halogen, a cyano group, a substituted or unsubstituted amine group, a substituted or unsubstituted oxy group, a substituted or unsubstituted thio group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons. In one or more embodiments, adjacent groups selected from among Rₐ₁ to Rₖ₁ may be bonded to form a ring. For example, in one or more embodiments, Rₐ₁ to Rₖ₁ may each independently be hydrogen, deuterium, a halogen, a substituted or unsubstituted oxy group, a substituted or unsubstituted thio group, a substituted or unsubstituted amine group, a substituted or unsubstituted boron group, a substituted or unsubstituted methyl group, a substituted or unsubstituted t-butyl group, a substituted or unsubstituted carbonyl group, a substituted or unsubstituted phenyl group, a substituted or unsubstituted biphenyl group, a substituted or unsubstituted dibenzofuran group, or a substituted or unsubstituted carbazole group. For example, in one or more embodiments, R₂₀ to R₂₈ may each independently be a substituted or unsubstituted methyl group, a substituted or unsubstituted phenyl group, a substituted or unsubstituted biphenyl group, a substituted or unsubstituted terphenyl group, a substituted or unsubstituted quarterphenyl group, or a substituted or unsubstituted quinquephenyl group. In one or more embodiments, Rₑ₁ and R_{f1}, Rᵢ₁ and Rⱼ₁ which are adjacently arranged may independently be bonded to each other to form an additional hetero ring. For example, in some embodiments, Rₑ₁ and R_{f1}, Rᵢ₁ and Rⱼ₁ which are adjacently arranged may independently be bonded to each other to form a ring to thereby form a benzofuran moiety.

In Formula 4-2 to Formula 4-4, n20 and n23 to n25 may each independently be an integer of 0 to 4. In Formula 4-2 to Formula 4-4, embodiments in which n20 and n23 to n25 are each 0 may refer to that the fused polycyclic compound according to one or more embodiments is unsubstituted with R₂₀, R₂₃ to R₂₅, respectively. In Formula 4-2 to Formula 4-4, embodiments in which n20, and n23 to n25 are each 4 and R₂₀, R₂₃ to R₂₅ are each all hydrogens may be the same as the embodiments n20 and n23 to n25 are 0, respectively. In Formula 4-2 and Formula 4-4, if (e.g., when) n20 and n23 to n25 are each an integer of 2 or greater, R₂₀(s) and R₂₃(s) to R₂₅(s) each provided in plurality may be all the same, or at least one selected from among the plurality of R₂₀(s) and R₂₃(s) to R₂₅(s) may be different.

In Formula 4-2 and Formula 4-3, n21 and n22 may each independently be an integer of 0 to 3. In Formula 4-2 and Formula 4-3, embodiments in which n21 and n22 are each 0 may refer to that the fused polycyclic compound according to one or more embodiments is unsubstituted with R₂₁ and R₂₂, respectively. In Formula 4-2 and Formula 4-3, embodiments in which n21 and n22 are each 3 and R₂₁ and R₂₂ are each all hydrogens may be the same as the embodiments in which n20 and n22 are 0, respectively. In Formula 4-2 and Formula 4-3, if (e.g., when) n21 and n22 are each an integer of 2 or greater, R₂₀(s) and R₂₂(s) each provided in plurality may be all the same, or at least one selected from among the plurality of R₂₁(s) and R₂₂(s) may be different.

In Formula 4-1 to Formula 4-4, the descriptions described in Formula 1 may be similarly applied to X, Z, R₁ to R₈, and R₃₁ to R₃₆.

In one or more embodiments, the fused polycyclic compound represented by Formula 1 may be represented by Formula 5.

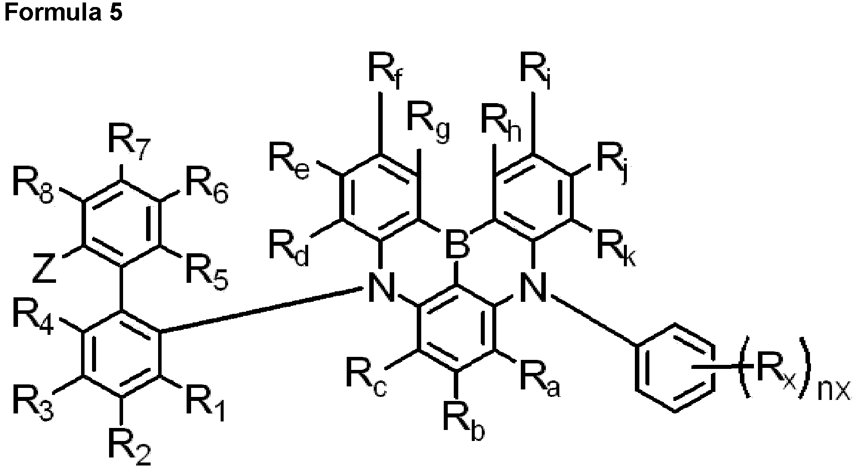

In Formula 5, Rₓ may be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons. For example, in one or more embodiments, Rₓ may be hydrogen, deuterium, a substituted or unsubstituted methyl group, a substituted or unsubstituted t-butyl group, a substituted or unsubstituted phenyl group, a substituted or unsubstituted biphenyl group, a substituted or unsubstituted phenyloxy group, a substituted or unsubstituted phenylthio group, a substituted or unsubstituted diphenylamine group, a substituted or unsubstituted benzofuran group, a substituted or unsubstituted benzothiophene group, or a substituted or unsubstituted carbazole group.

In Formula 5, nx may be an integer of 0 to 5. In Formula 5, an embodiment in which nx is 0 may refer to that the fused polycyclic compound according to one or more embodiments is unsubstituted with Rₓ. In Formula 5, an embodiment in which nx is 5, and Rₓ(s) are each hydrogen may be the same as an embodiment in which nx is 0. In Formula 5, if (e.g., when) nx is an integer of 2 or greater, Rₓ(s) provided in plurality may be all the same, or at least one selected from among the plurality of Rₓ(s) may be different.

In Formula 5, the descriptions described in Formula 1 may be similarly applied to Z, R₁ to R₈, and Rₐ to Rₖ.

In one or more embodiments, the fused polycyclic compound represented by Formula 1 may be represented by Formula 6.

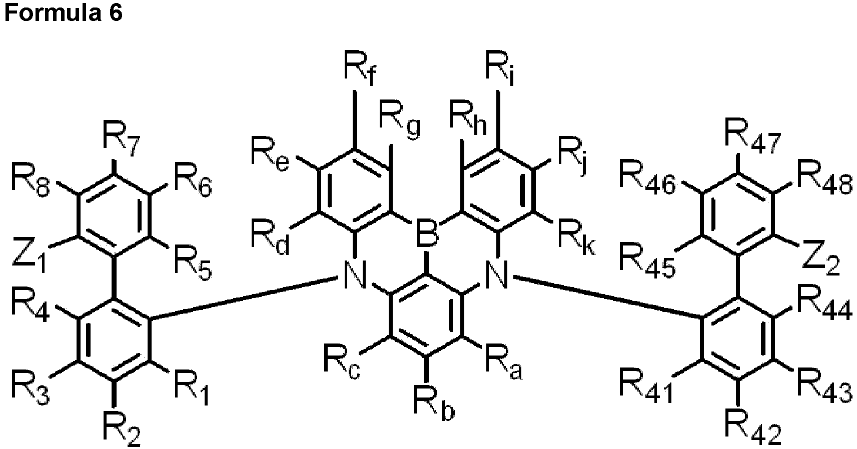

In Formula 6, Z₁ and Z₂ may each independently be a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons. For example, in one or more embodiments, Z₁ and Z₂ may each independently be a substituted or unsubstituted phenyl group, a substituted or unsubstituted biphenyl group, a substituted or unsubstituted phenyloxy group, a substituted or unsubstituted phenylthiol group, a substituted or unsubstituted diphenylamine group, a substituted or unsubstituted benzofuran group, a substituted or unsubstituted benzothiophene group, or a substituted or unsubstituted carbazole group.

In Formula 6, R₄₁ to R₄₈ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons. In one or more embodiments, one or more selected from among R₄₁ to R₄₈ may be each independently bonded to an adjacent group to form a ring. For example, in some embodiments, R₄₁ may be hydrogen, deuterium, a substituted or unsubstituted phenyl group, a substituted or unsubstituted biphenyl group, a substituted or unsubstituted oxy group, or a substituted or unsubstituted amine group. For example, in some embodiments, R₄₂ to R₄₈ may each independently be hydrogen, deuterium, a substituted or unsubstituted methyl group, a substituted or unsubstituted t-butyl group, or a substituted or unsubstituted phenyl group.

In one or more embodiments, in Formula 6, if (e.g., when) any one selected from among R₄₁ to R₄₈ is bonded to an adjacent group to form a ring, the formed ring does not include two *sp*³ carbons bonded to each other. In one or more embodiments, if (e.g., when) any one selected from among R₄₁ to R₄₈ is bonded to an adjacent group to form a ring, the formed ring does not include a structure containing consecutive two *sp*³ carbons bonded to each other. In one or more embodiments, in Formula 6, if (e.g., when) some of R₄₁ to R₄₈ are each independently bonded to an adjacent group to form a ring, the formed ring may be an aromatic ring.

In one or more embodiments, in Formula 6, if (e.g., when) Z₁ is a substituted or unsubstituted aryl group, R₅ may not be a substituted or unsubstituted aryl group. In one or more embodiments, in Formula 6, if (e.g., when) Z₁ is a substituted or unsubstituted aryl group, R₅ may be hydrogen or deuterium.

In one or more embodiments, in Formula 6, if Z₂ is a substituted or unsubstituted aryl group, R₄₅ may not be a substituted or unsubstituted aryl group. In one or more embodiments, in Formula 6, if Z₂ is a substituted or unsubstituted aryl group, R₄₅ may be hydrogen or deuterium.

In one or more embodiments, in Formula 6, Z₁ and Z₂ may be the same. For example, in one or more embodiments, Z₁ and Z₂ may each independently be a substituted or unsubstituted phenyl group, a substituted or unsubstituted biphenyl group, a substituted or unsubstituted phenyloxy group, a substituted or unsubstituted phenylthio group, a substituted or unsubstituted diphenyl amine group, a substituted or unsubstituted benzofuran group, a substituted or unsubstituted benzothiophene group, or a substituted or unsubstituted carbazole group, and may have the same chemical structure.

In one or more embodiments, the fused polycyclic compound according to one or more embodiments may have an axisymmetric structure centered on the boron atom and the third aromatic ring of the fused ring core. In one or more embodiments, the fused polycyclic compound may be represented by Formula 6, R₁ and R₄₁ may be the same, and Z₁ and Z₂ may have the same structure.

In Formula 6, the descriptions described in Formula 1 may be similarly applied to R₁ to R₈ and Rₐ to Rₖ.

In one or more embodiments, the fused polycyclic compound represented by Formula 6 may be represented by Formula 6-1.

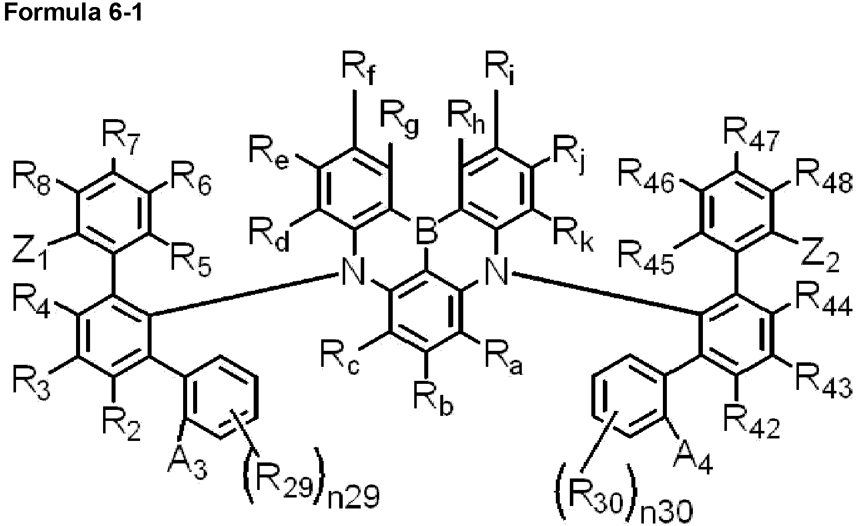

In Formula 6-1, A₃ and A₄ may each independently be hydrogen, deuterium, a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons. For example, in one or more embodiments, A₃ and A₄ may each independently be hydrogen, deuterium, a substituted or unsubstituted phenyl group, a substituted or unsubstituted biphenyl group, a substituted or unsubstituted phenyloxy group, a substituted or unsubstituted phenylthio group, a substituted or unsubstituted diphenylamine group, a substituted or unsubstituted benzofuran group, a substituted or unsubstituted benzothiophene group, or a substituted or unsubstituted carbazole group.

In one or more embodiments, in Formula 6-1, Z₁ and A₃ may be the same. For example, in some embodiments, Z₁ and A₃ may each be a phenyl group having the same chemical structure. Z₁ and A₃ may be each an unsubstituted phenyl group. In one or more embodiments, in Formula 6-1, Z₂ and A₄ may be the same. For example, in some embodiments, Z₂ and A₄ may each be a phenyl group having the same chemical structure. For example, Z₂ and A₄ may be each an unsubstituted phenyl group.

In Formula 6-1, R₂₉ and R₃₀ may each independently be hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons. For example, in one or more embodiments, R₂₉ and R₃₀ may each independently be hydrogen, deuterium, a substituted or unsubstituted methyl group, a substituted or unsubstituted t-butyl group, or a substituted or unsubstituted phenyl group.

In Formula 6-1, n29 and n30 may each be an integer of 0 to 4. In Formula 6-1, an embodiment in which n29 and n30 are each 0 may refer to that the fused polycyclic compound according to one or more embodiments is unsubstituted with R₂₉ and R₃₀, respectively. In Formula 6-1, embodiments in which n29 and n30 are each 4 and R₂₉ and R₃₀ are each hydrogen may be the same as the embodiment in which n29 and n30 are 0, respectively. In Formula 6-1, if (e.g., when) n29 and n30 are each an integer of 2 or greater, R₂₉(s) and R₃₀(s) each provided in plurality may be all the same, or at least one selected from among the plurality of R₂₉(s) and R₃₀(s) may be different.

In Formula 6-1, the descriptions described in Formula 1 and Formula 6 may be similarly applied to R₂ to R₈, Rₐ to Rₖ, R₄₂ to R₄₈, Z₁, and Z₂.

In one or more embodiments, the fused polycyclic compound represented by Formula 1 may be represented by any one selected from among Formula 7-1 to Formula 7-4.

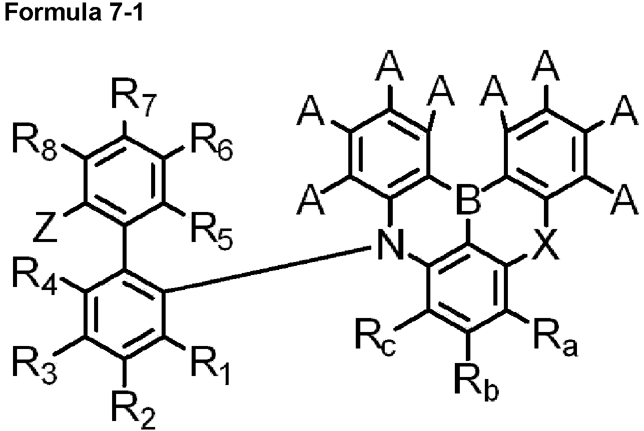

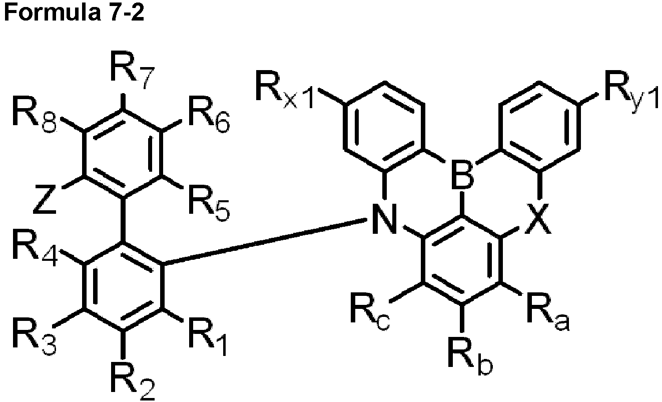

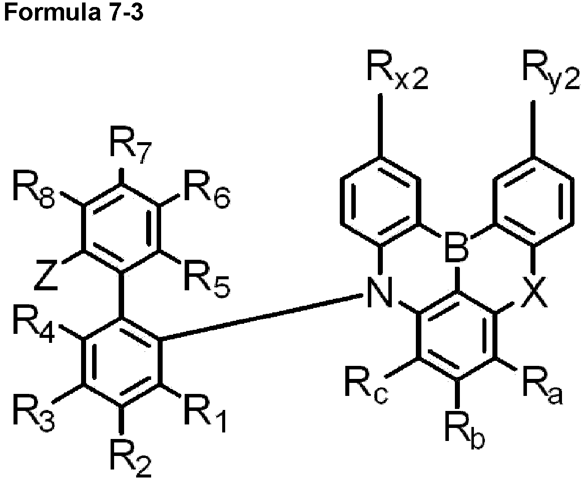

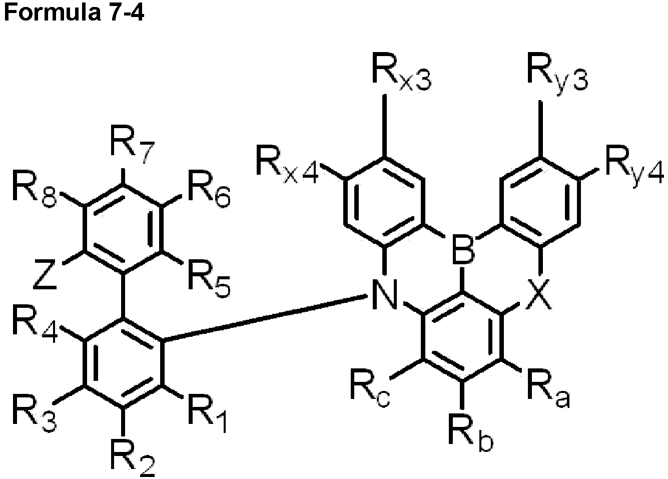

In Formula 7-1, A may be hydrogen or deuterium. A plurality of A(s) may be all the same or may be different from each other. For example, in some embodiments, all A(s) may each be hydrogen. In some embodiments, all A(s) may each be deuterium.

In Formula 7-2 and Formula 7-3, Rₓ₁, Rₓ₂, R_{y1}, and R_{y2} may each independently be deuterium, a halogen, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons. For example, in one or more embodiments, Rₓ₁, Rₓ₂, R_{y1}, and R_{y2} may each independently be a substituted or unsubstituted methyl group, a substituted or unsubstituted t-butyl group, a substituted or unsubstituted amine group, a substituted or unsubstituted phenyl group, a substituted or unsubstituted biphenyl group, a substituted or unsubstituted N-carbazole group, a substituted or unsubstituted phenoxazine group, or a substituted or unsubstituted phenothiazine group. In one or more embodiments, the N-carbazole group may refer to a substituent that is connected to the fused cyclic core according to one or more embodiments via a nitrogen atom. In one or more embodiments, Rₓ₁, Rₓ₂, R_{y1}, and R_{y2} may each independently be any one selected from among substituents represented by Formula a-1 to Formula a-8 described previously.

In Formula 7-4, Rₓ₃, Rₓ₄, R_{y3}, and R_{y4} may each independently be hydrogen, a halogen, a substituted or unsubstituted oxy group, a substituted or unsubstituted thio group, a substituted or unsubstituted amine group, a substituted or unsubstituted carbonyl group, a substituted or unsubstituted alkyl group having 1 to 20 carbon, a substituted or unsubstituted aryl group having 6 to 30 ring-forming carbons, or a substituted or unsubstituted heteroaryl group having 2 to 30 ring-forming carbons, In one or more embodiments, one or more selected from among Rₓ₃, Rₓ₄, R_{y3} and R_{y4} may independently be bonded to an adjacent group to form a ring. For example, in some embodiments, Rₓ₃ and Rₓ₄, which are adjacently arranged, are bonded to each other to form an additional hetero ring. In some embodiments, R_{y3} and R_{y4}, which are adjacently arranged, are bonded to each other to form an additional hetero ring.

In Formula 7-1 to Formula 7-4, the descriptions described in Formula 1 may be similarly applied to X, Z, R₁ to R₈, Rₐ to R_{c}, and R₃₁ to R₃₆.

In one or more embodiments, the fused polycyclic compound represented by Formula 1 may be represented by Formula 8-1 or Formula 8-2.

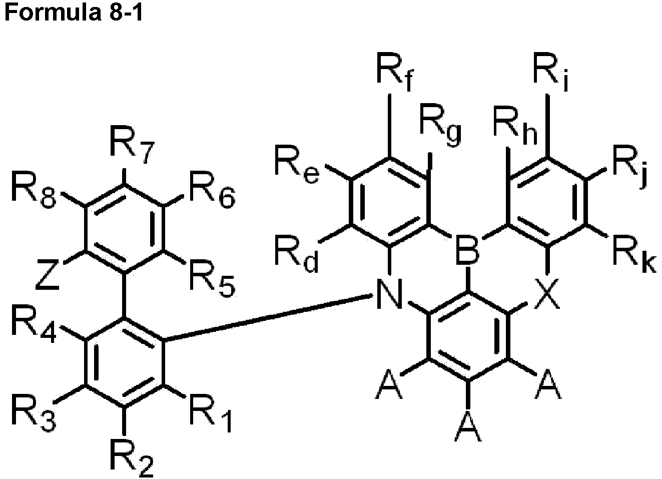

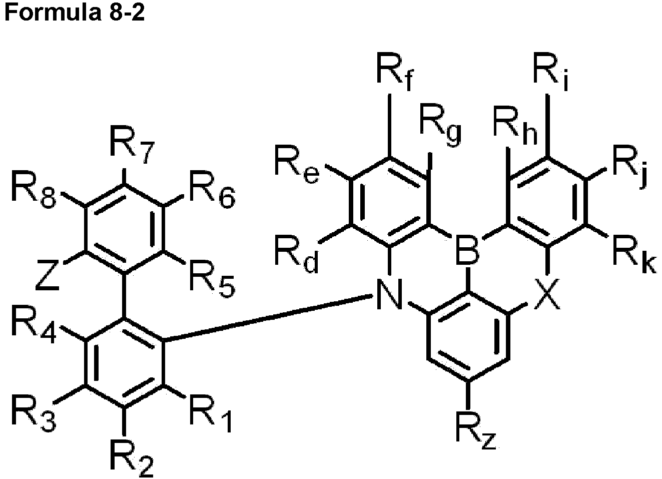

In Formula 8-1, A may be hydrogen or deuterium. A plurality of A(s) may be all the same or may be different from each other. For example, in one or more embodiments, A(s) may be all hydrogens. In one or more embodiments, A(s) may each be deuterium.

In Formula 8-2, R_{z} may be deuterium, a halogen, a substituted or unsubstituted oxy group, a substituted or unsubstituted thio group, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons. In one or more embodiments, R_{z} may not be bonded to an adjacent group to form a ring. For example, in one or more embodiments, R_{z} may be a substituted or unsubstituted methyl group, a substituted or unsubstituted isopropyl group, a substituted or unsubstituted t-butyl group, a substituted or unsubstituted phenyl group, a substituted or unsubstituted biphenyl group, a substituted or unsubstituted terphenyl group, a substituted or unsubstituted carbonyl group, or a substituted or unsubstituted carbazole group. In one or more embodiments, R_{z} may be an unsubstituted methyl group, an unsubstituted isopropyl group, or an unsubstituted t-butyl group, or may be any one selected from among substituents represented by Formula b-1 to Formula b-9 described previously.

In Formula 8-1 and Formula 8-2, the descriptions described in Formula 1 may be similarly applied to X, Z, R₁ to R₈, R_{d} to Rₖ, and R₃₁ to R₃₆.

In one or more embodiments, the fused polycyclic compound according to one or more embodiments represented by Formula 1 may include at least one deuterium as a substituent. The fused polycyclic compound according to one or more embodiments represented by Formula 1 may include a structure in which at least one hydrogen is substituted with deuterium.

The fused polycyclic compound according to one or more embodiments may be any one selected from among compounds present in Compound Group 1. At least one functional group included in the light emitting element ED according to one or more embodiments may include at least one fused polycyclic compound selected from among the compounds present in Compound Group 1. The light emitting element ED according to one or more embodiments may include at least one fused polycyclic compound selected from among the compounds present in Compound Group 1 in the emission layer EML.

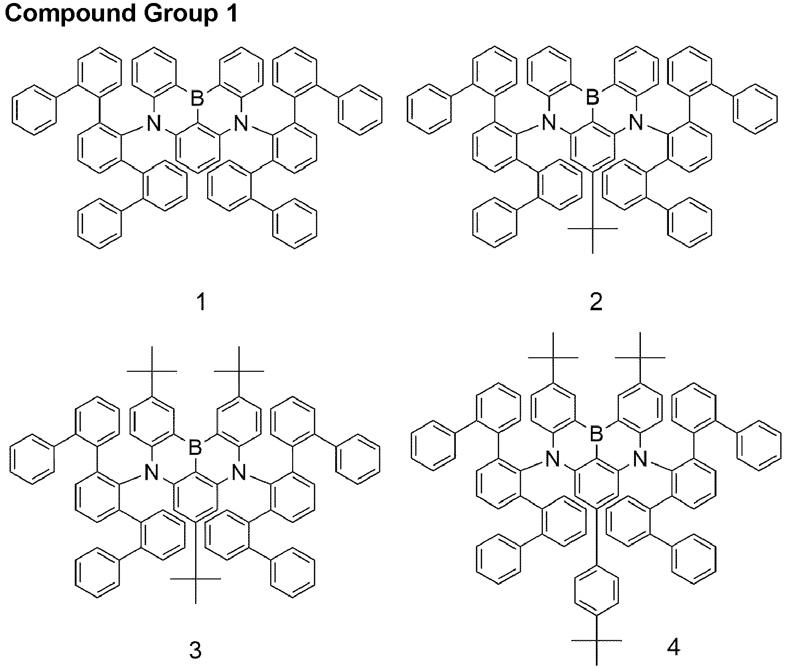

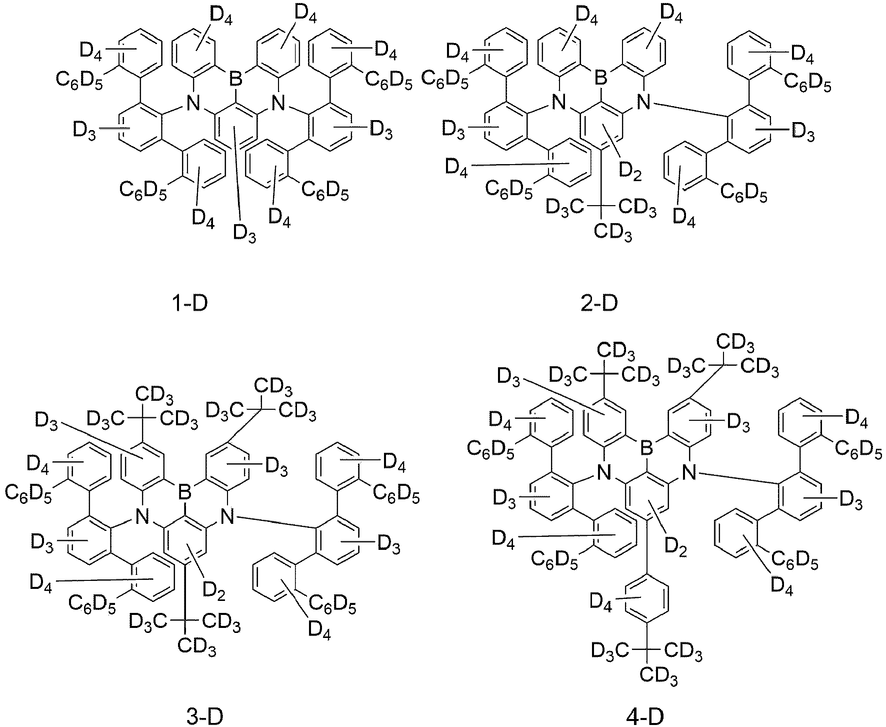

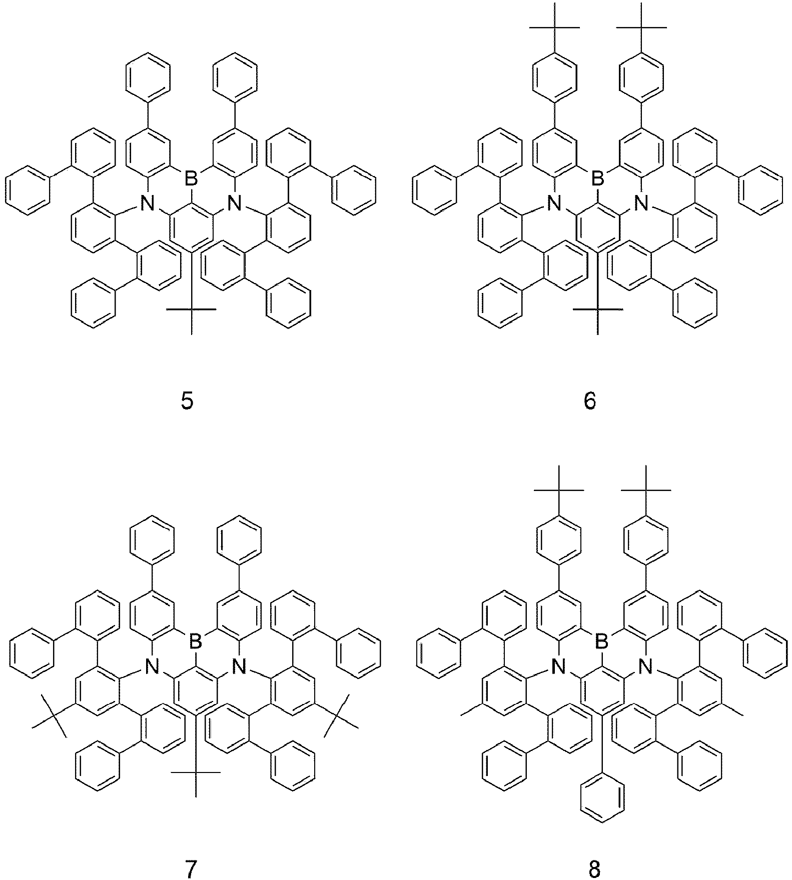

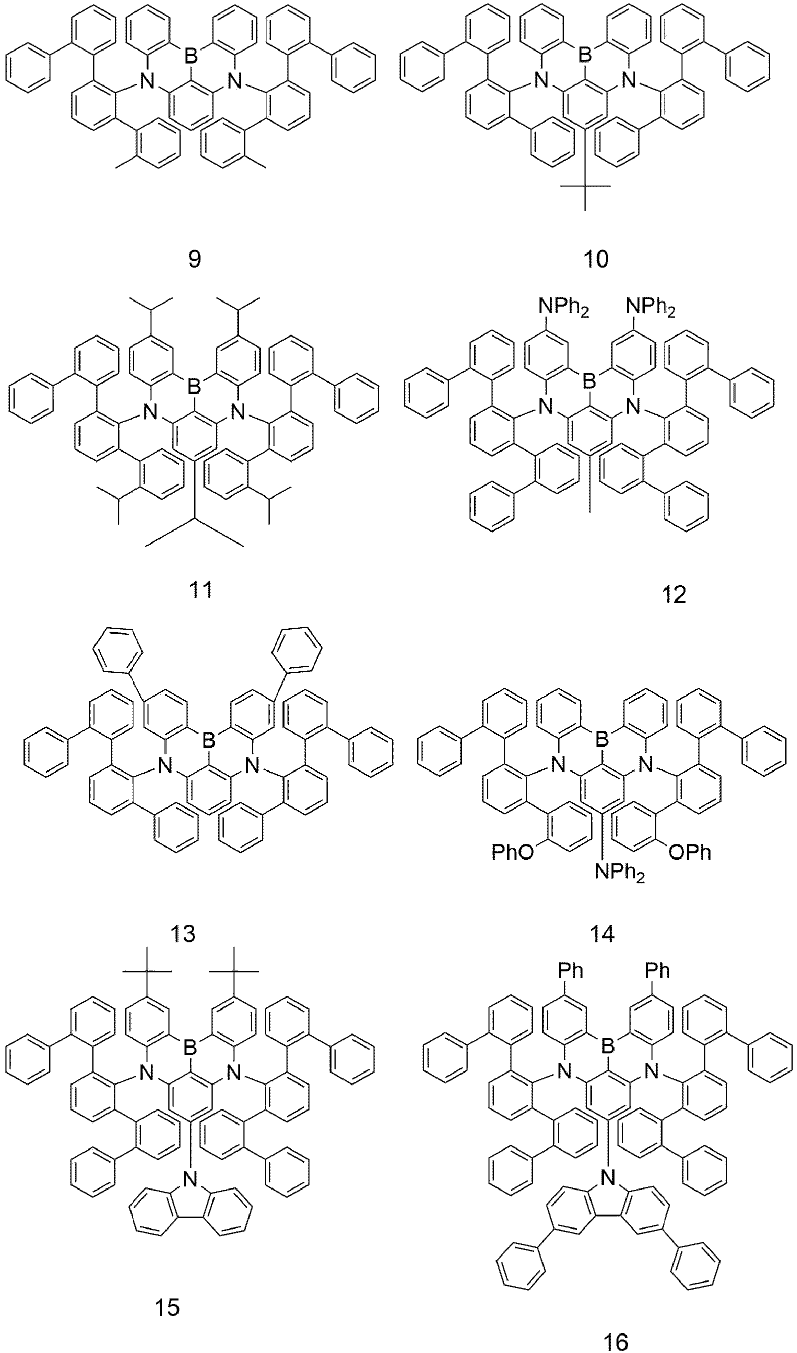

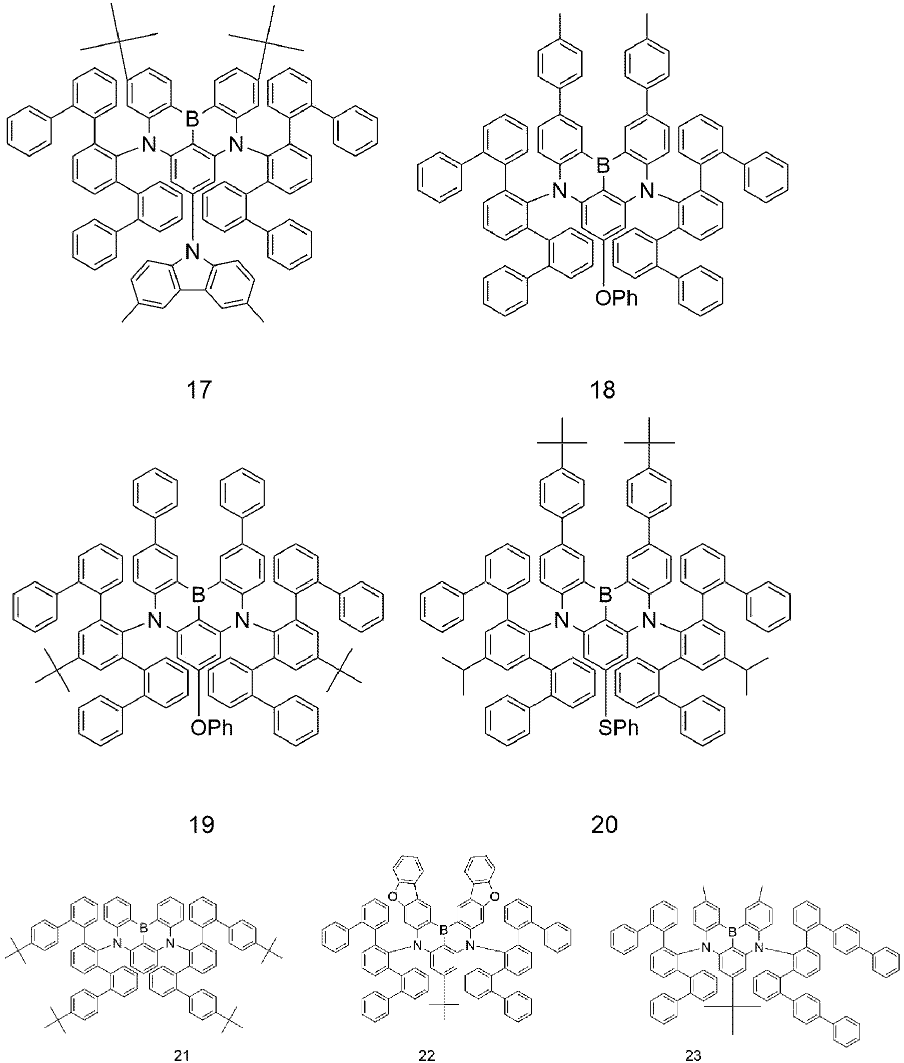

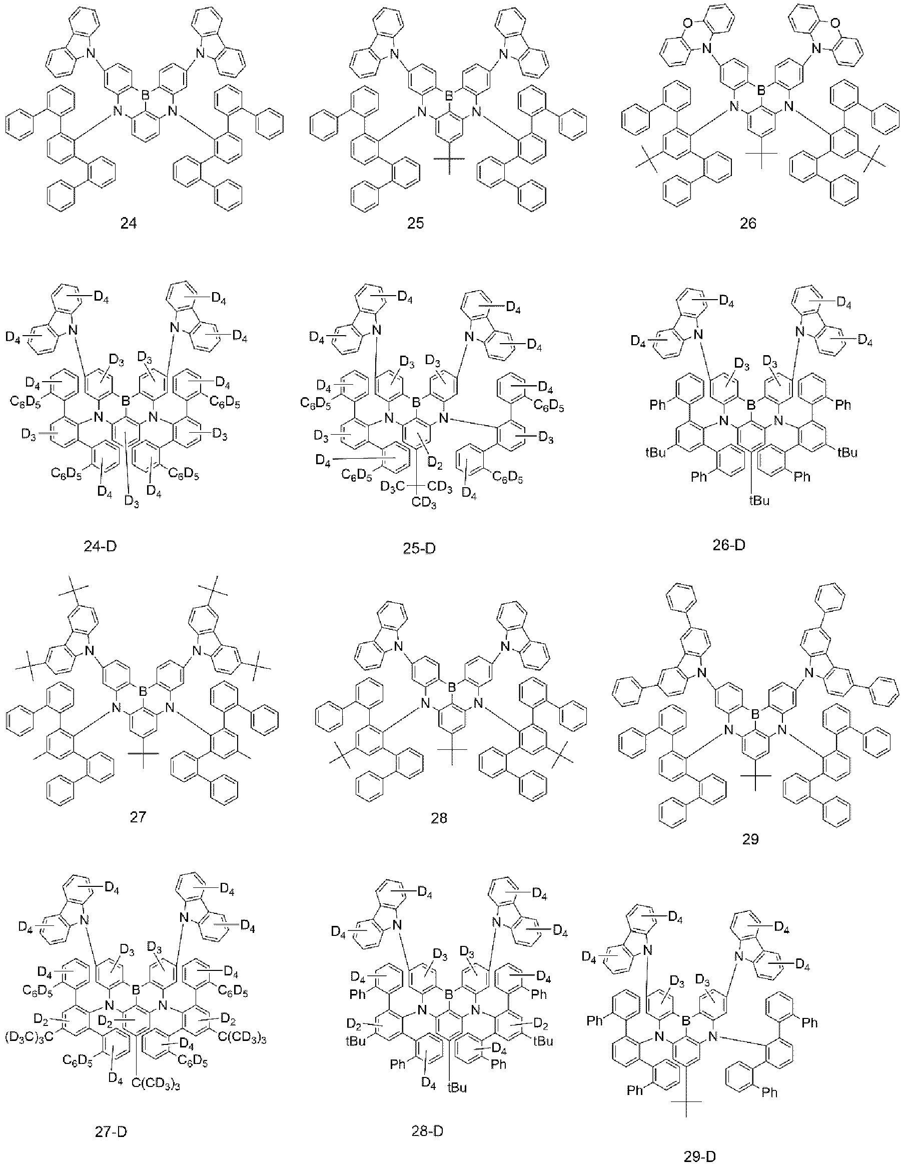

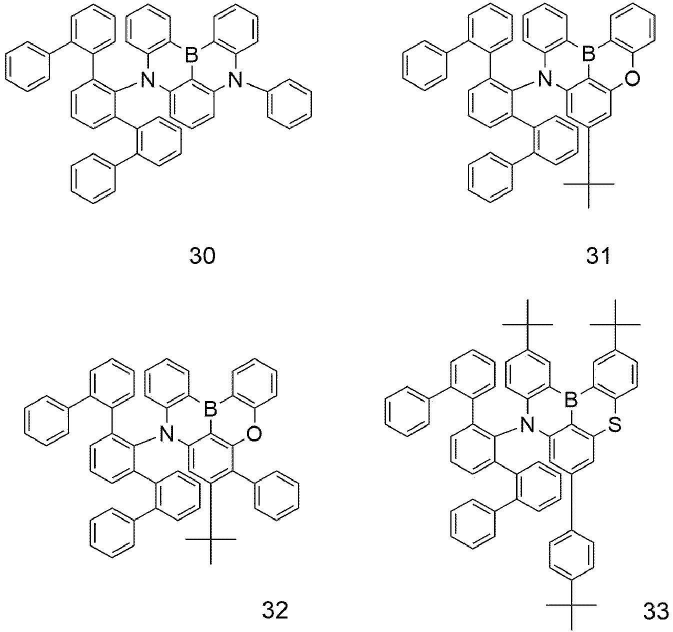

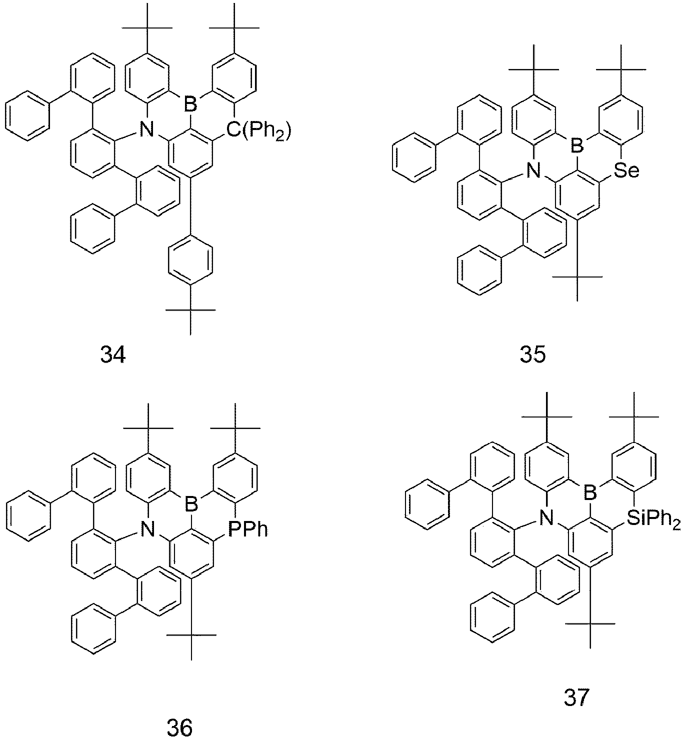

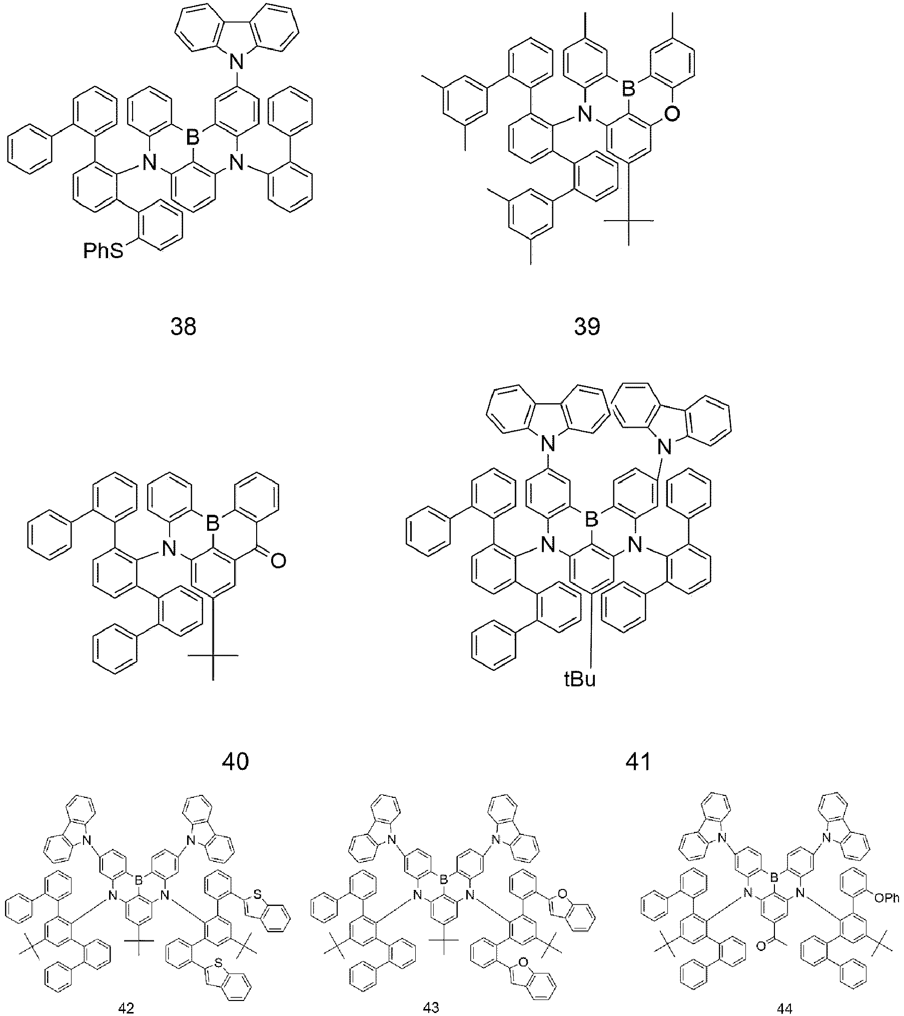

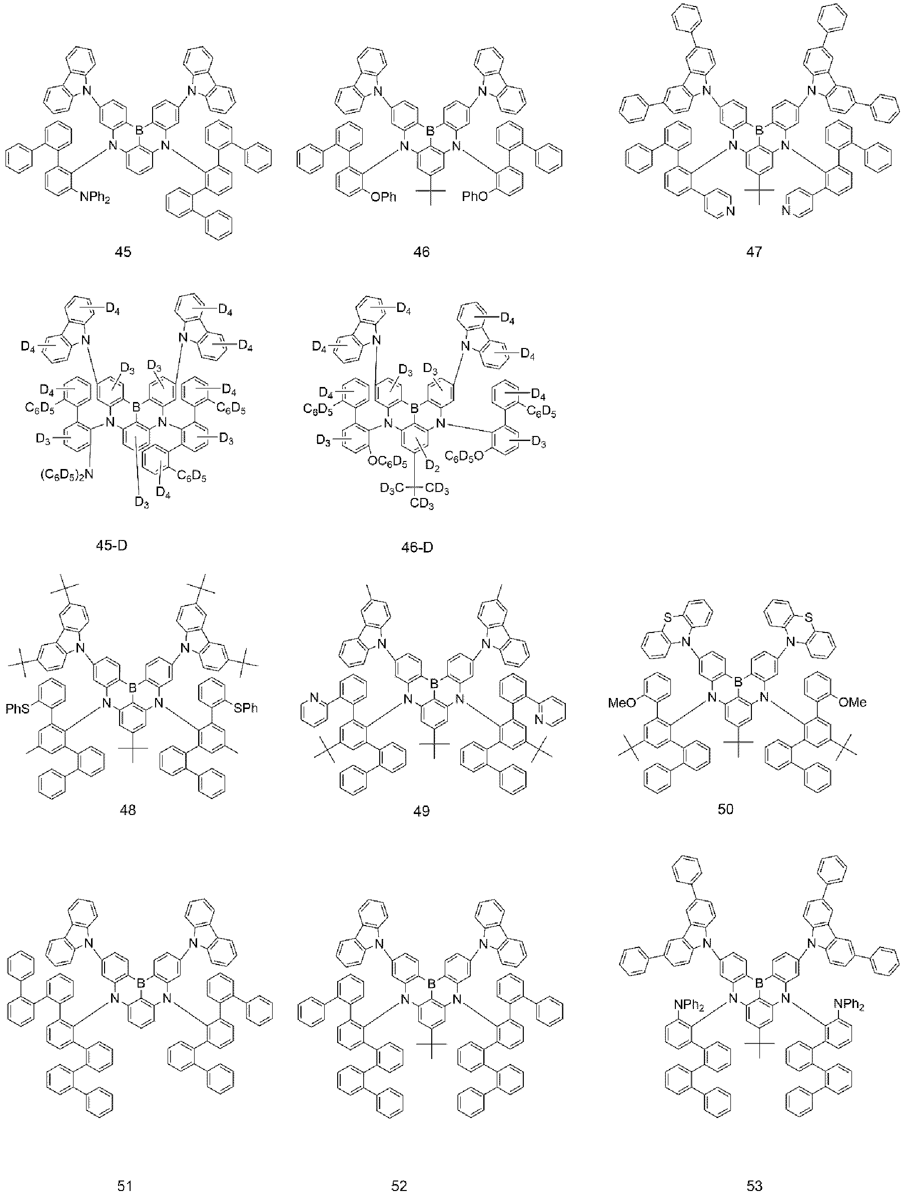

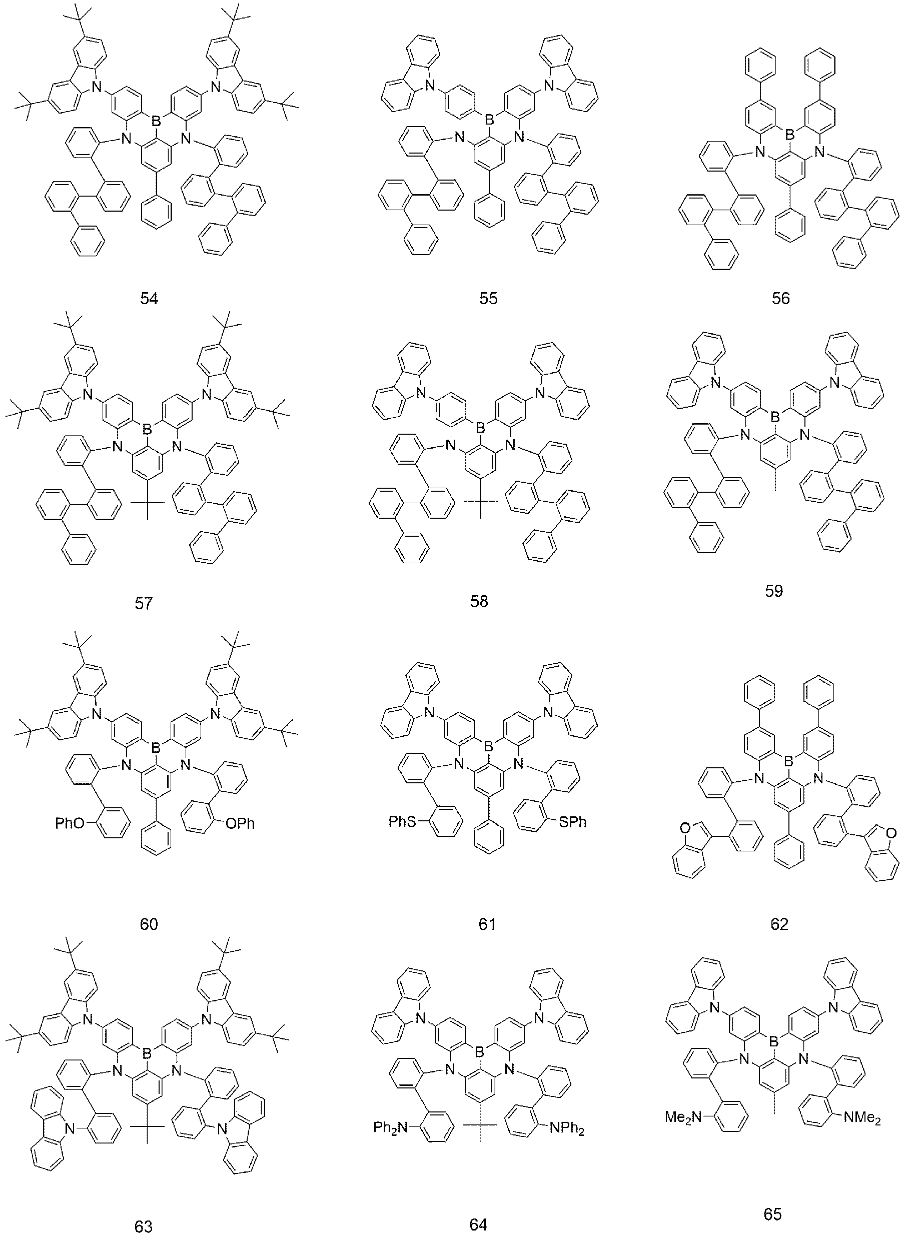

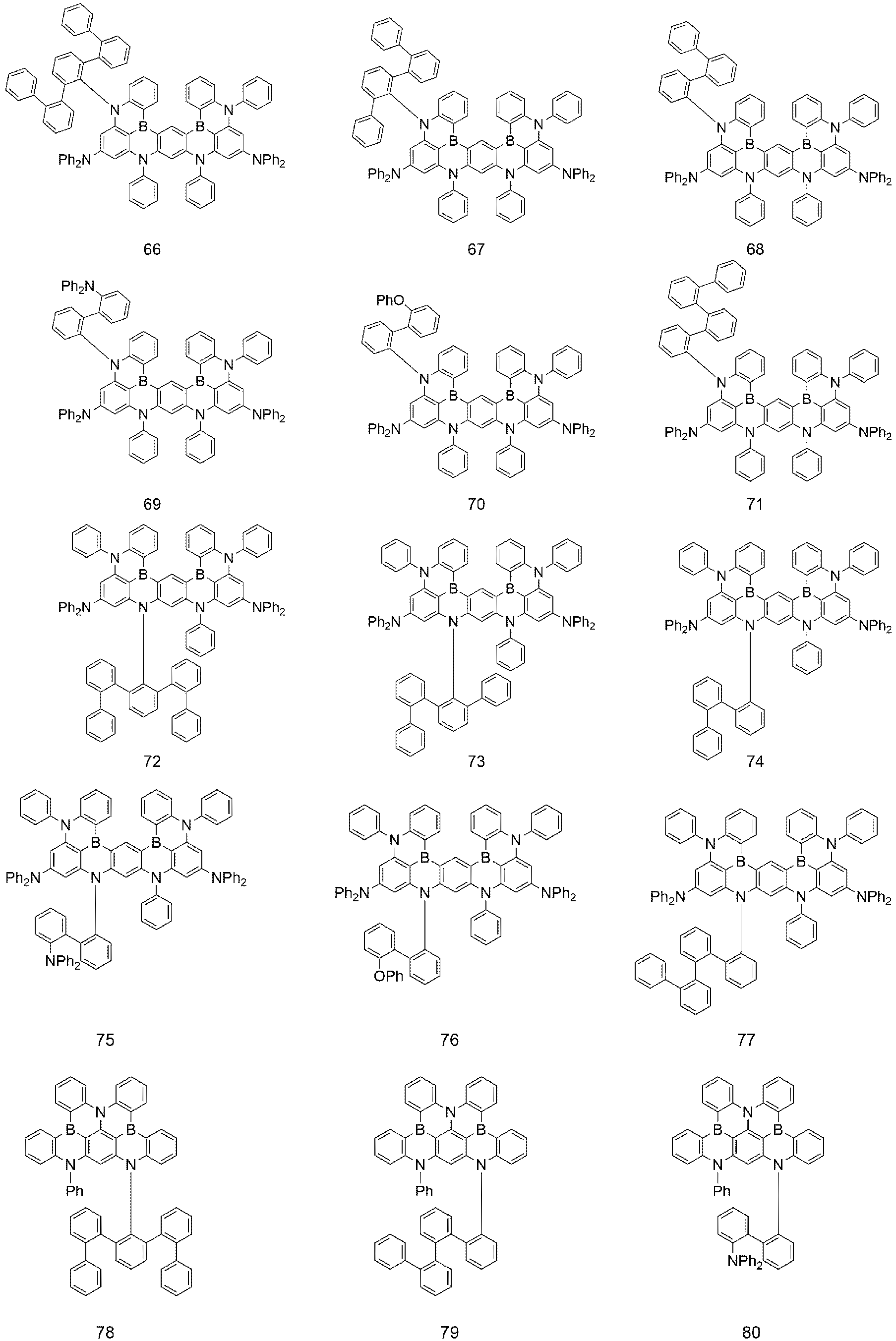

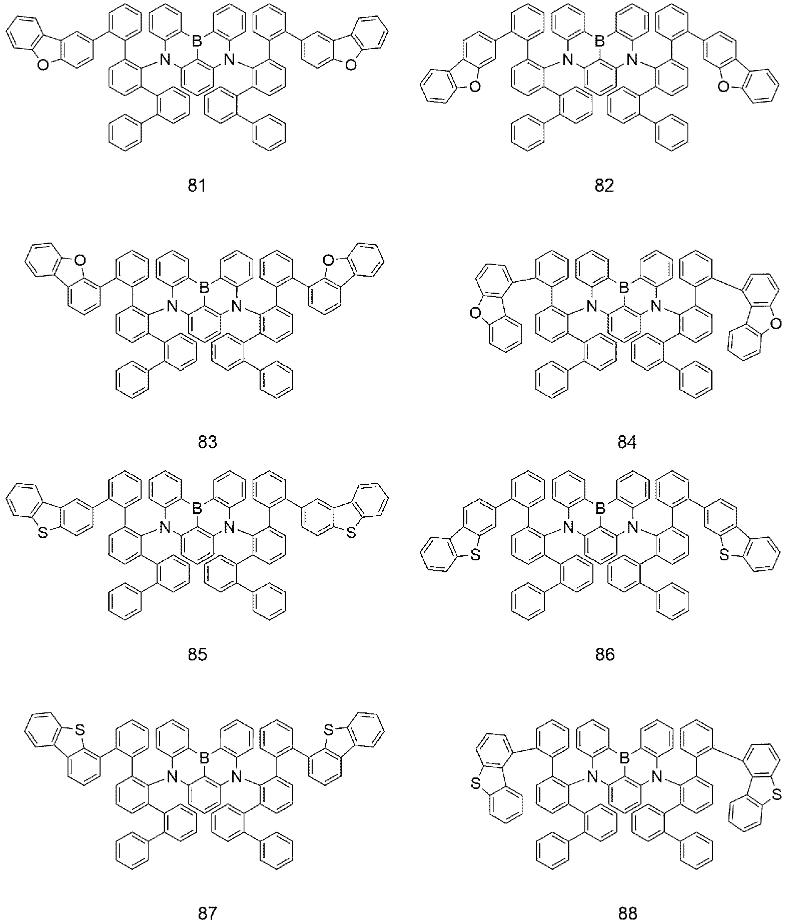

In example compounds present in Compound Group 1, "D" refers to deuterium. "Ph" refers to an unsubstituted phenyl group. "Me" refers to a methyl group. "C₆D₅" refers to a phenyl group substituted with deuterium. "CD₃" refers to a methyl group substituted with deuterium.

An emission spectrum of the fused polycyclic compound according to one or more embodiments represented by Formula 1 has a full width at half maximum of about 10 nm to about 50 nm, or about 20 nm to about 40 nm. Because the emission spectrum of a first dopant/first compound according to one or more embodiments represented by Formula 1 falls within the above-described range, if (e.g., when) the fused polycyclic compound according to one or more embodiments is applied to the light emitting element, the light emitting element may have improved luminous efficiency. In addition, if (e.g., when) the fused compound according to one or more embodiments is used as materials for a blue light emitting element, lifespan of the light emitting element may be improved.

In one or more embodiments, the fused polycyclic compound according to one or more embodiments represented by Formula 1 may be a thermally activated delayed fluorescence emission material. In one or more embodiments, the fused polycyclic compound according to one or more embodiments represented by Formula 1 may be a thermally activated delayed fluorescence dopant of which a difference (ΔE_{ST}) between a lowest triplet excited state energy level (T1 level) and a lowest singlet excited state energy level (S1 level) is about 0.6 eV or less. In one or more embodiments, the fused polycyclic compound according to one or more embodiments represented by Formula 1 may be a thermally activated delayed fluorescence dopant of which a difference (ΔE_{ST}) between the energy level (T1 level) of the lowest triplet excited state and the energy level (S1 level) of the lowest singlet excited state is about 0.2 eV or less. However, embodiments of the present disclosure are not limited thereto.

In one or more embodiments, the fused polycyclic compound according to one or more embodiments represented by Formula 1 may include a first substituent and a second substituent within the compound. The energy level of the singlet state and the energy level of the triplet state of the overall compound may be appropriately or suitably adjusted by controlling the substitution number and the substitution position of the first and second substituents. Therefore, the fused polycyclic compound according to one or more embodiments may have improved thermally activated delayed fluorescence characteristics.

The fused polycyclic compound according to one or more embodiments represented by Formula 1 may be an emission material having an emission peak wavelength in a wavelength region of about 430 nm to about 490 nm. For example, the fused polycyclic compound according to one or more embodiments represented by Formula 1 may be a blue thermally activated delayed fluorescence (TADF) dopant. However, embodiments of the present disclosure are not limited thereto, and if (e.g., when) the fused polycyclic compound according to one or more embodiments is used for the emission material, the first dopant/first compound may be used as a dopant material, such as a red emission dopant or a green emission dopant, which emits light in one or more suitable wavelength regions.

In the light emitting element ED according to one or more embodiments, the emission layer EML may be to emit a delayed fluorescence. For example, in one or more embodiments, the emission layer EML may be to emit a thermally activated delayed fluorescence (TADF).

In one or more embodiments, the emission layer EML of the light emitting element ED may be to emit blue light. For example, the emission layer EML of an organic electroluminescence element ED may be to emit blue light in a wavelength region of about 490 nm or less. However, embodiments of the disclosure are not limited thereto, and the emission layer EML may be to emit green light or red light.

In one or more embodiments, the fused polycyclic compound according to one or more embodiments may be included in the emission layer EML. The fused polycyclic compound according to one or more embodiments may be included in the emission layer EML as a dopant material. The fused polycyclic compound according to one or more embodiments may be a thermally activated delayed fluorescence material. The fused polycyclic compound according to one or more embodiments may be used as a thermally activated fluorescence dopant. For example, in the light emitting element ED according to one or more embodiments, the emission layer EML may include at least one selected from among the fused polycyclic compounds present in Compound Group 1 described previously as a thermally activated delayed fluorescence dopant. However, utilization of the fused polycyclic compound according to one or more embodiments is not limited thereto.

In one or more embodiments, the light emitting layer EML(i.e., emission layer EML) may include a plurality of compounds. The light emitting layer EML of one or more embodiments may include a fused polycyclic compound represented by Formula 1, that is, a first compound, in addition, a second compound represented by Formula HT-1, and/or a third compound represented by Formula ET-1, and it may further include at least one of a fourth compound represented by Formula D-1.

In one or more embodiments, the emission layer EML may include the first compound represented by Formula 1, and may further include at least one of the second compound represented by Formula HT-1, the third compound represented by Formula ET-1, or the fourth compound represented by Formula D-1.

In one or more embodiments, the second compound may be used as a hole transporting host material of the emission layer EML.

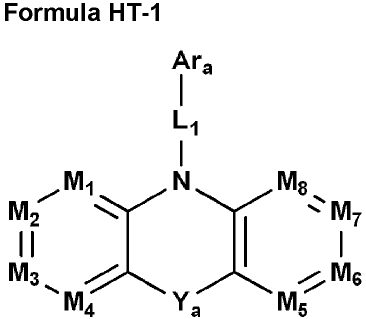

In Formula HT-1, M₁ to M₈ may each independently be N or CR₅₁. For example, in one or more embodiments, all of M₁ to M₈ may be CR₅₁. In one or more embodiments, any one selected from among M₁ to M₈ may be N, and the rest may be CR₅₁.

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, in one or more embodiments, L₁ may be a direct linkage, a substituted or unsubstituted phenylene group, a substituted or unsubstituted divalent biphenyl group, a substituted or unsubstituted divalent carbazole group, and/or the like, but embodiments of the present disclosure are not limited thereto.

In Formula HT-1, Yₐ may be a direct linkage, CR₅₂R₅₃, or SiR₅₄R₅₅. For example, it may refer to that the two 6-membered rings (e.g., two benzene rings) linked to the nitrogen atom in Formula HT-1 are linked via a direct linkage, 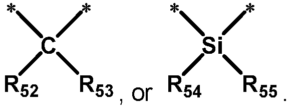 In one or more embodiments, in Formula HT-1, if (e.g., when) Yₐ is a direct linkage, the second compound represented by Formula HT-1 may include a carbazole moiety.

In Formula HT-1, Arₐ may be a substituted or unsubstituted aryl group having 6 to 30 ring-forming carbon atoms or a substituted or unsubstituted heteroaryl group having 2 to 30 ring-forming carbon atoms. For example, in one or more embodiments, Arₐ may be a substituted or unsubstituted carbazole group, a substituted or unsubstituted dibenzofuran group, a substituted or unsubstituted dibenzothiophene group, a substituted or unsubstituted biphenyl group, and/or the like, but embodiments of the present disclosure are not limited thereto.

In Formula HT-1, R₅₁ to R₅₅ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, one or more selected from among R₅₁ to R₅₅ may each independently be bonded to an adjacent group to form a ring. For example, in one or more embodiments, R₅₁ to R₅₅ may each independently be hydrogen or deuterium. In one or more embodiments, R₅₁ to R₅₅ may each independently be an unsubstituted methyl group or an unsubstituted phenyl group.

In one or more embodiments, the second compound represented by Formula HT-1 may be any one selected from among compounds represented by Compound Group 2. The emission layer EML may include at least one selected from among the compounds represented by Compound Group 2 as a hole transporting host material.

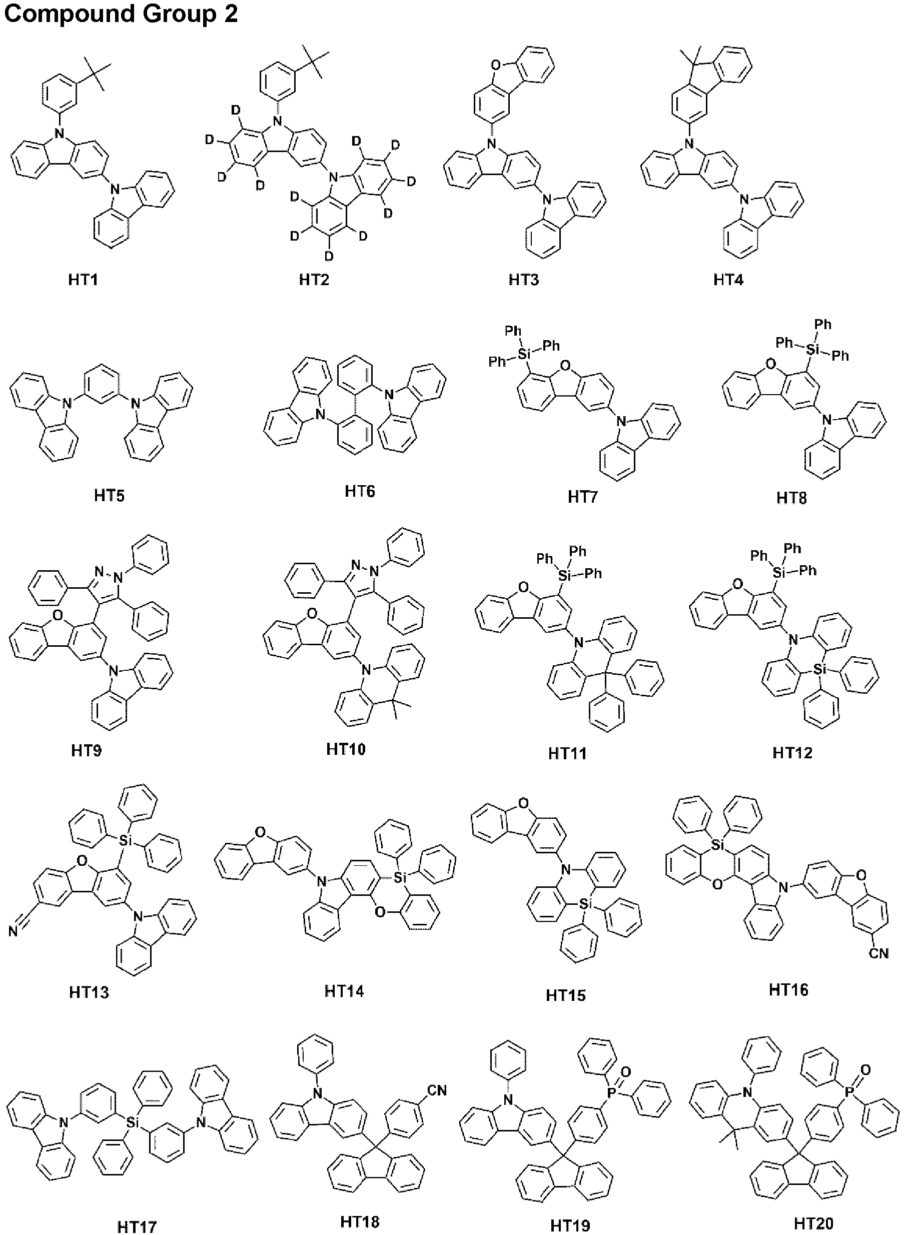

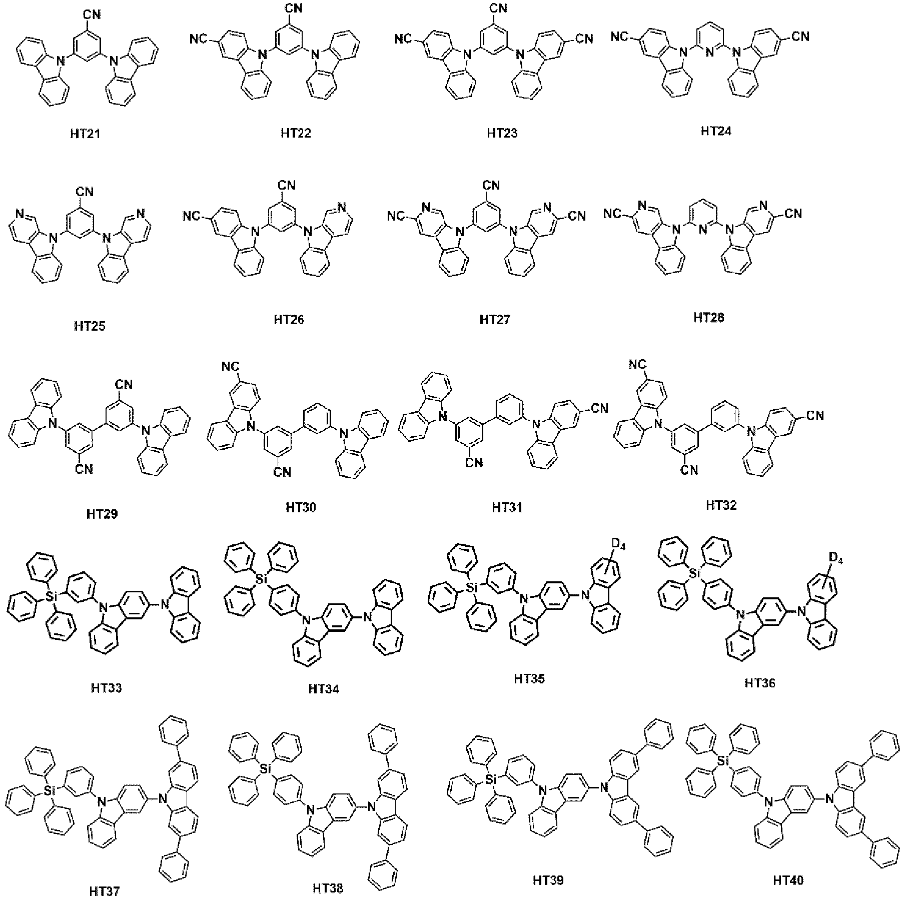

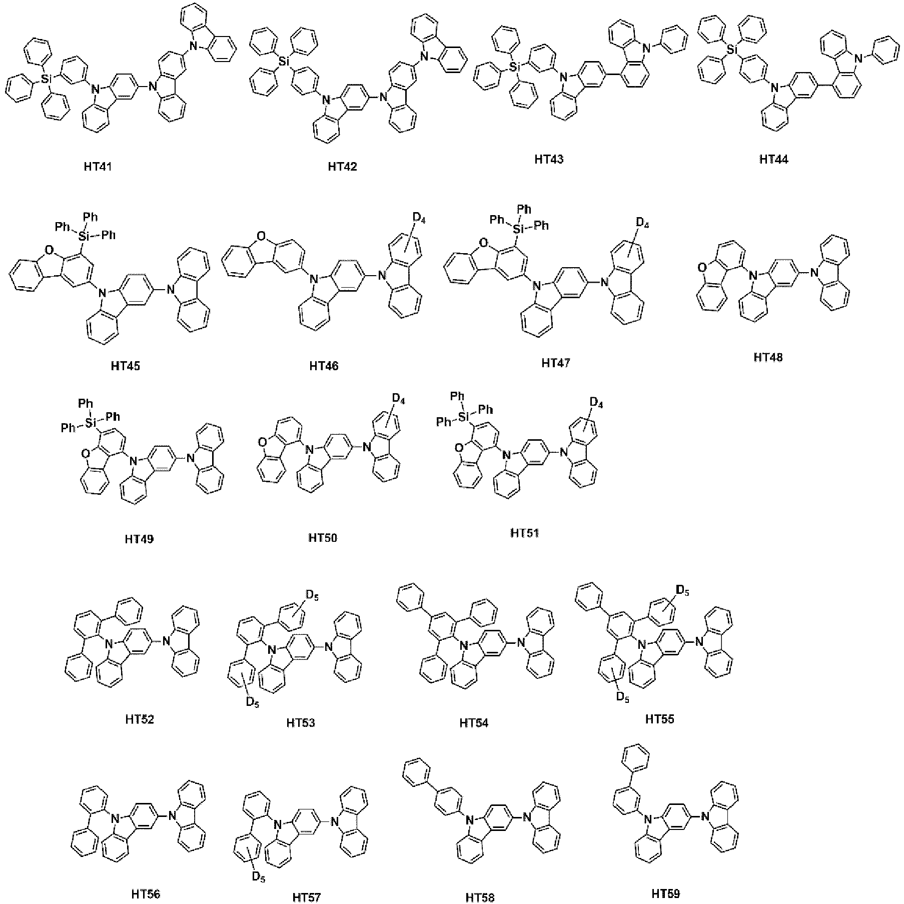

In embodiment compounds presented in Compound Group 2, "D" may refer to deuterium, and "Ph" may refer to a substituted or unsubstituted phenyl group. For example, in embodiment compounds presented in Compound Group 2, "Ph" may refer to an unsubstituted phenyl group.

In one or more embodiments, the emission layer EML may include the third compound represented by Formula ET-1. For example, the third compound may be used as an electron transporting host material for the emission layer EML.

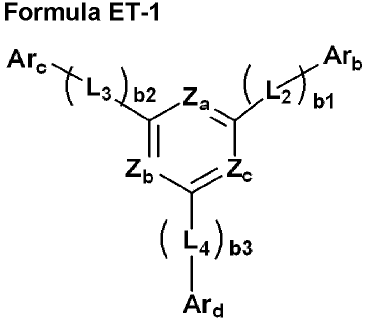

In Formula ET-1, at least one selected from among Zₐ to Z_{c} may be N, and the rest are CR₅₆. For example, in one or more embodiments, any one (e.g., one) selected from among Zₐ to Z_{c} may be N, and the rest (i.e., reminders or unselected ones) may each independently be CR₅₆. In those embodiments, the third compound represented by Formula ET-1 may include a pyridine moiety. In one or more embodiments, two selected from among Zₐ to Z_{c} may be N, and the rest may be CR₅₆. In those embodiments, the third compound represented by Formula ET-1 may include a pyrimidine moiety. In one or more embodiments, Zₐ to Z_{c} may all be N. In those embodiments, the third compound represented by Formula ET-1 may include a triazine moiety.

In Formula ET-1, R₅₆ may be hydrogen, deuterium, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may each independently be an integer of 0 to 10.

In Formula ET-1, Ar_{b} to Ar_{d} may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in one or more embodiments, Ar_{b} to Ar_{d} may each independently be a substituted or unsubstituted phenyl group or a substituted or unsubstituted carbazole group.

In Formula ET-1, L₂ to L₄ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) b1 to b3 are each an integer of 2 or greater, L₂(s) to L₄(s) may each independently be a substituted or unsubstituted arylene group having 6 to 30 ring-forming carbon atoms, or a substituted or unsubstituted heteroarylene group having 2 to 30 ring-forming carbon atoms.

In one or more embodiments, the third compound may be any one selected from among compounds in Compound Group 3. The light emitting device ED of one or more embodiments may include at least one selected from among the compounds in Compound Group 3.

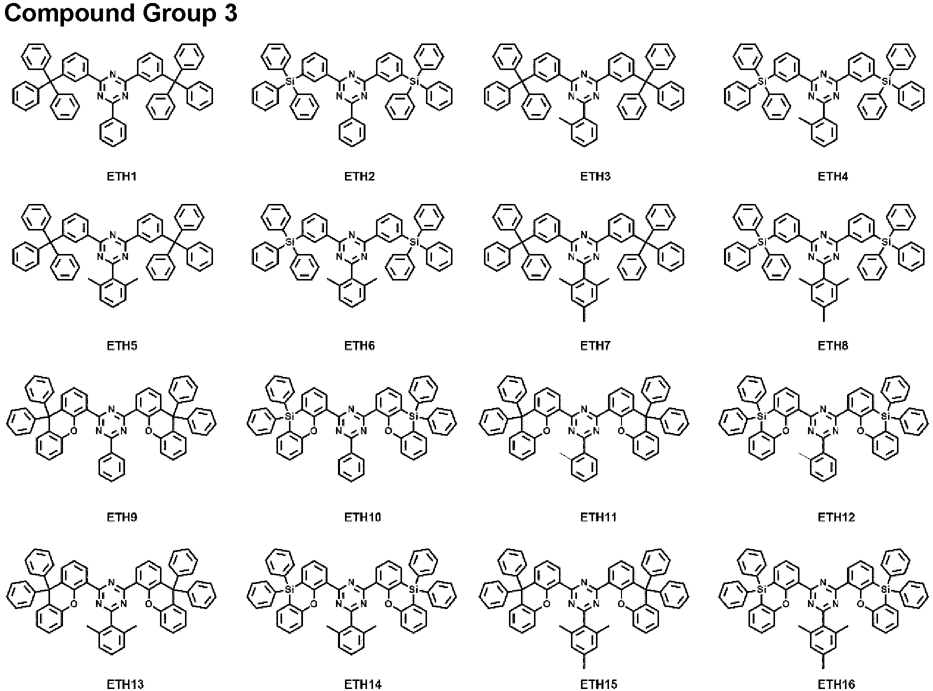

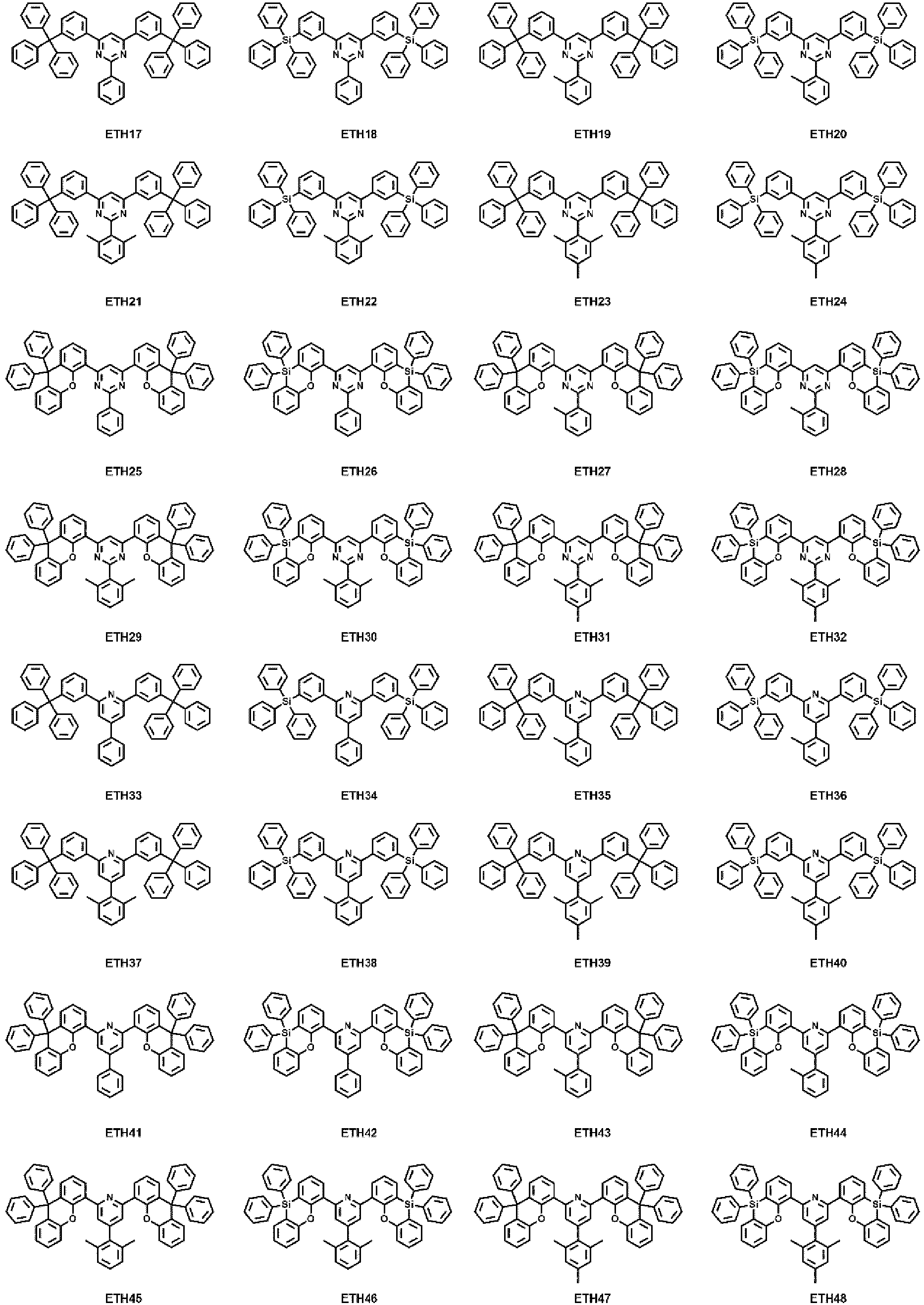

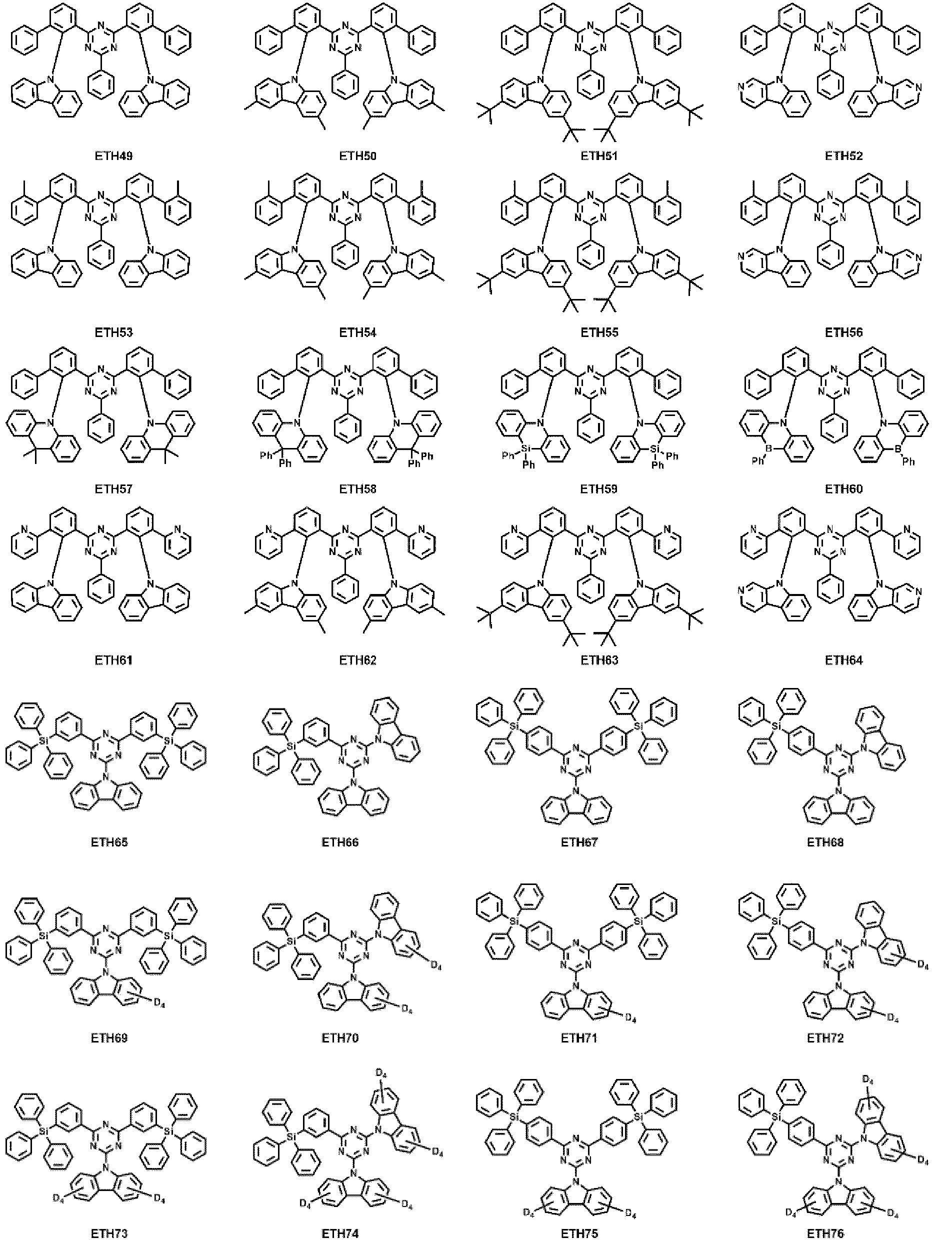

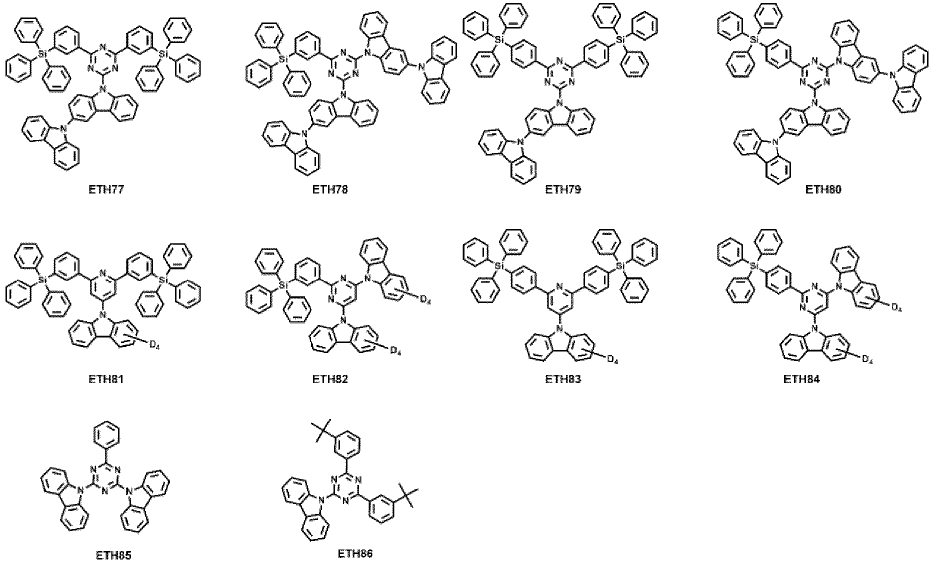

In the embodiment compounds presented in Compound Group 3, "D" refers to deuterium and "Ph" refers to an unsubstituted phenyl group.

In one or more embodiments, the emission layer EML may include the second compound and the third compound, and the second compound and the third compound may form an exciplex. In the emission layer EML, an exciplex may be formed by the hole transporting host and the electron transporting host. In these embodiments, a triplet energy of the exciplex formed by the hole transporting host and the electron transporting host may correspond to a difference between a lowest unoccupied molecular orbital (LUMO) energy level of the electron transporting host and a highest occupied molecular orbital (HOMO) energy level of the hole transporting host.

For example, in one or more embodiments, an absolute value of the triplet energy (T1) of the exciplex formed by the hole transporting host and the electron transporting host may be about 2.4 eV to about 3.0 eV. In addition, the triplet energy of the exciplex may be a value smaller than an energy gap of each host material. The exciplex may have a triplet energy of about 3.0 eV or less that is an energy gap between the hole transporting host and the electron transporting host.

In one or more embodiments, the emission layer EML may include a fourth compound in addition to the first compound to the third compound as described above. The fourth compound may be used as a phosphorescent sensitizer of the emission layer EML. The energy may be transferred from the fourth compound to the first compound, thereby emitting light.

For example, in one or more embodiments, the emission layer EML may include, as the fourth compound, an organometallic complex containing platinum (Pt) as a central metal atom and ligands linked to the central metal atom. The emission layer EML in the light emitting device ED of one or more embodiments may include, as the fourth compound, a compound represented by Formula D-1:

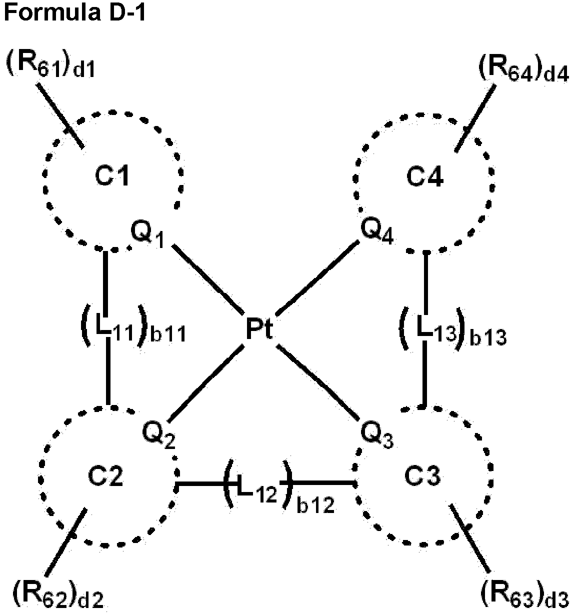

In Formula D-1, Q₁ to Q₄ may each independently be C or N.

In Formula D-1, C1 to C4 may each independently be a substituted or unsubstituted hydrocarbon ring having 5 to 30 ring-forming carbon atoms or a substituted or unsubstituted heterocycle having 2 to 30 ring-forming carbon atoms.

In Formula D-1, L₁₁ to L₁₃ may each independently be a direct linkage, 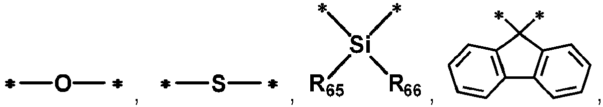 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, " * " refers to a part linked to C1 to C4.

In Formula D-1, b11 to b13 may each independently be 0 or 1. If (e.g., when) b11 is 0, C1 and C2 may not be linked to each other. If (e.g., when) b12 is 0, C2 and C3 may not be linked to each other. If (e.g., when) b13 is 0, C3 and C4 may not be linked to each other.

In Formula D-1, R₆₁ to R₆₆ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, one or more selected from among R₆₁ to R₆₆ may be independently bonded to an adjacent group to form a ring. In one or more embodiments, R₆₁ to R₆₆ may each independently be a substituted or unsubstituted methyl group or a substituted or unsubstituted t-butyl group.

In Formula D-1, d1 to d4 may each independently be an integer of 0 to 4. In Formula D-1, if each of d1 to d4 is 0, the fourth compound may not be substituted with each of R₆₁ to R₆₄. The embodiment in which each of d1 to d4 is 4 and R₆₁'s to R₆₄' are each hydrogen may be the same as the embodiment in which each of d1 to d4 is 0. When each of d1 to d4 is an integer of 2 or more, a plurality of R₆₁'s to Rsa's may each be the same or at least one selected from among the plurality of R₆₁'s to R₆₄'s may be different from the others.

In Formula D-1, C1 to C4 may each independently be a substituted or unsubstituted hydrocarbon ring or a substituted or unsubstituted heterocycle represented by any one selected from among C-1 to C-4:

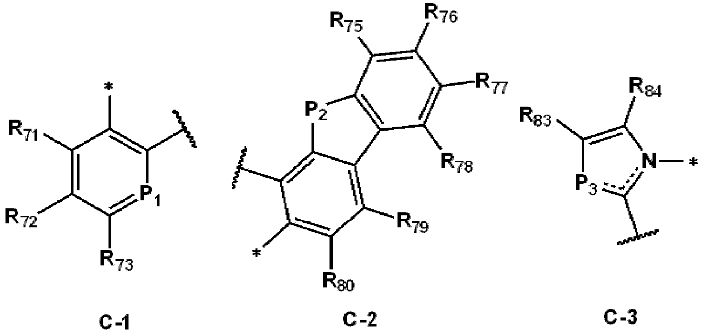

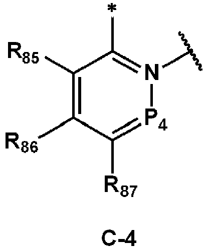

In C-1 to C-4, P₁ may be C-* or CR₇₄, P₂ may be N-* or NR₈₁, P₃ may be N-* or NR₈₂, and P₄ may be C-* or CR₈₈. R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring.

In addition, in C-1 to C-4, " 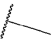 " corresponds to a part linked to Pt that is a central metal atom, and "-*" corresponds to a part linked to a neighboring cyclic group (C1 to C4) or a linker (L₁₁ to L₁₃).

The emission layer EML of one or more embodiments may include the first compound, which is a fused polycyclic compound of the present disclosure, and at least one selected from among the second to fourth compounds. For example, in one or more embodiments, the emission layer EML may include the first compound, the second compound, and the third compound. In the emission layer EML, the second compound and the third compound may form an exciplex, and the energy may be transferred from the exciplex to the first compound, thereby emitting light.

In one or more embodiments, the emission layer EML may include the first compound, the second compound, the third compound, and the fourth compound. In the emission layer EML, the second compound and the third compound may form an exciplex, and the energy may be transferred from the exciplex to the fourth compound and the first compound, thereby emitting light. In one or more embodiments, the fourth compound may be a sensitizer. The fourth compound included in the emission layer EML in the light emitting element ED of one or more embodiments may serve as a sensitizer to deliver energy from the host to the first compound that is a light emitting dopant. For example, in some embodiments, the fourth compound serving as an auxiliary dopant accelerates energy delivery to the first compound that is a light emitting dopant, thereby increasing the emission ratio of the first compound. Therefore, the emission layer EML of one or more embodiments may improve luminous efficiency. In addition, if (e.g., when) the energy delivery to the first compound is increased, an exciton formed in the emission layer EML is not accumulated inside the emission layer EML and emits light rapidly, and thus deterioration of the element may be reduced. Therefore, the service life of the light emitting element ED of one or more embodiments may increase.

The light emitting element ED of one or more embodiments may include all of the first compound, the second compound, the third compound, and the fourth compound, and the emission layer EML may include the combination of two host materials and two dopant materials. In the light emitting element ED of one or more embodiments, the emission layer EML may concurrently (e.g., simultaneously) include the second compound and the third compound, which are two different hosts, the first compound that emits a delayed fluorescence, and the fourth compound including an organometallic complex, thereby exhibiting excellent or suitable luminous efficiency characteristics.

In one or more embodiments, the fourth compound represented by Formula D-1 may include at least one selected from among compounds represented in Compound Group 4. The emission layer EML may include at least one selected from among the compounds represented in Compound Group 4 as a sensitizer material.

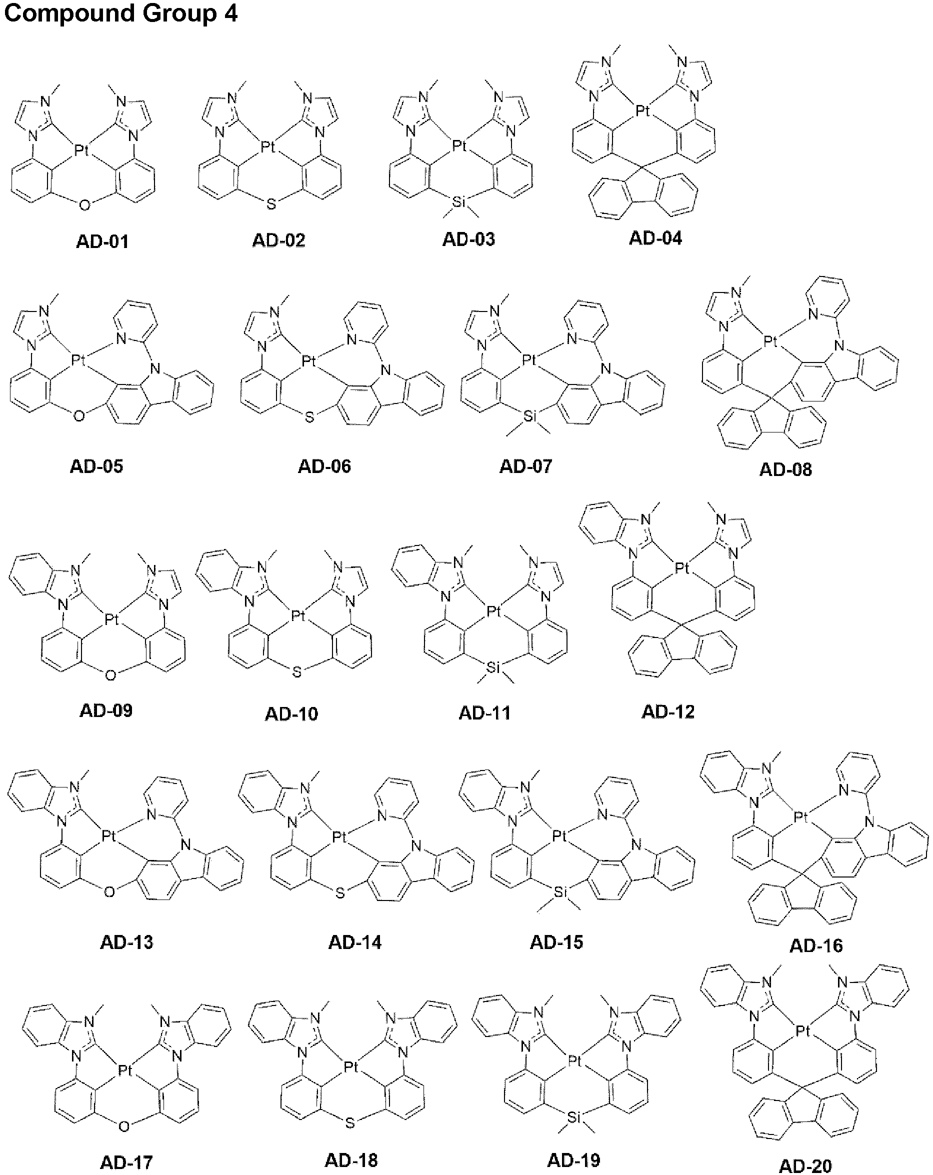

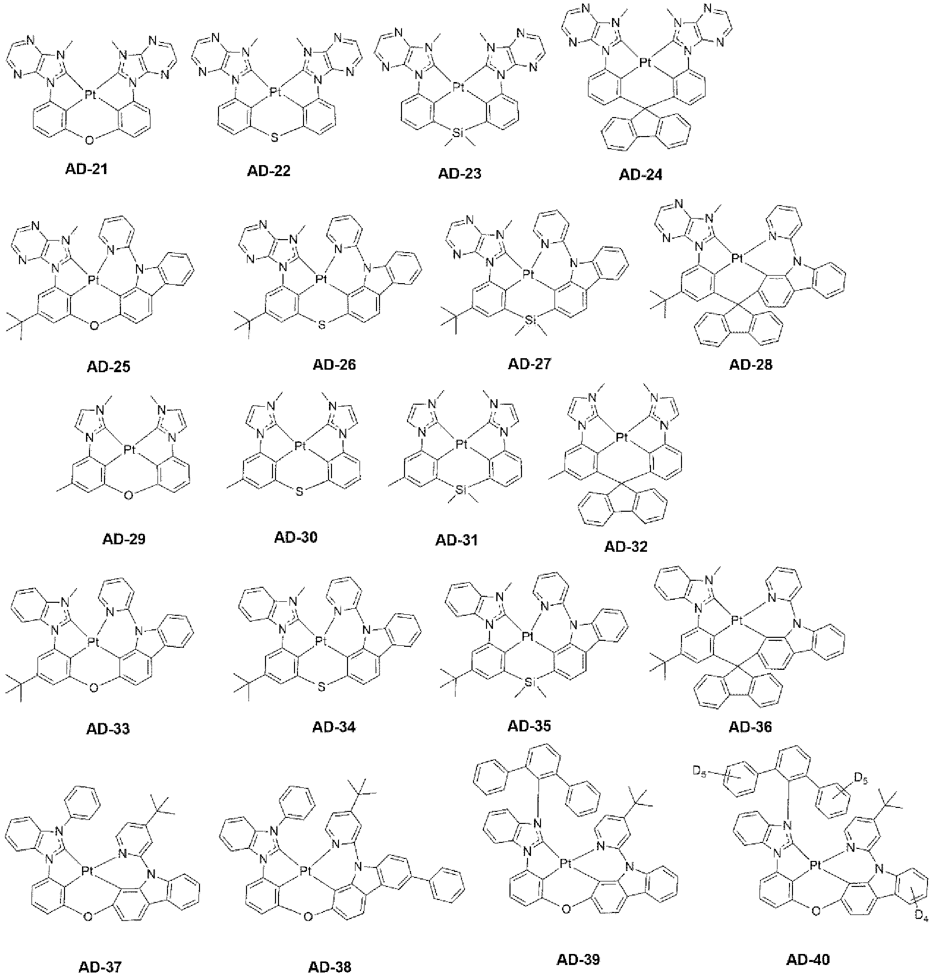

In the embodiment compounds presented in Compound Group 4, "D" refers to deuterium.

When the emission layer EML in the light emitting element ED of one or more embodiments includes all of the first compound, the second compound, and the third compound, with respect to the total weight of (100 wt% of) the first compound, the second compound, and the third compound, a content (e.g., amount) of the first compound may be about 0.1 wt% to about 5 wt%. However, embodiment of the present disclosure are not limited thereto. When the content (e.g., amount) of the first compound satisfy the above-described proportion, the energy transfer from the second compound and the third compound to the first compound may increase, and thus the luminous efficiency and element service life may increase.

The contents (e.g., amounts) of the second compound and the third compound in the emission layer EML may be the rest excluding the weight of the first compound. For example, the contents of the second compound and the third compound in the emission layer EML may be about 65 wt% to about 95 wt% with respect to the total weight of 100 wt% of the first compound, the second compound, and the third compound.

In the total weight of the second compound and the third compound, a weight ratio of the second compound to the third compound may be about 3:7 to about 7:3.

When the contents of the second compound and the third compound satisfy the above-described ratio, charge balance characteristics in the emission layer EML are improved, and thus the luminous efficiency and element service life may increase. When the contents of the second compound and the third compound deviate from the above-described ratio range, a charge balance in the emission layer EML is broken, and thus the luminous efficiency may be reduced and the element may be easily deteriorated.

In one or more embodiments, when the emission layer EML further includes the fourth compound, a content (e.g., amount) of the fourth compound in the emission layer EML may be about 10 wt% to about 30 wt% with respect to the total weight of 100 wt% of the first compound, the second compound, the third compound, and the fourth compound. However, embodiments of the present disclosure are not limited thereto. When the content (e.g., amount) of the fourth compound satisfies the above-described content (e.g., amount), the energy delivery from the host to the first compound which is a light emitting dopant may be increased, thereby a luminous ratio may be improved, and thus the luminous efficiency of the emission layer EML may be improved. When the first compound, the second compound, the third compound, and the fourth compound included in the emission layer EML satisfy the above-described content (e.g., amount) ratio range, excellent or suitable luminous efficiency and long service life of the light emitting element may be achieved.

In the light emitting element ED of one or more embodiments, the emission layer EML may include an anthracene derivative, a pyrene derivative, a fluoranthene derivative, a chrysene derivative, a dihydrobenzanthracene derivative, or a triphenylene derivative. For example, in some embodiments, the emission layer EML may include one or more anthracene derivative(s) or one or more pyrene derivative(s).

In each light emitting element ED of embodiments illustrated in FIGS. 3 to 6, the emission layer EML may further include a suitable host and dopant besides the above-described host and dopant, and for example, in some embodiments, the emission layer EML may include a compound represented by Formula E-1. The compound represented by Formula E-1 may be used as a fluorescent host material.

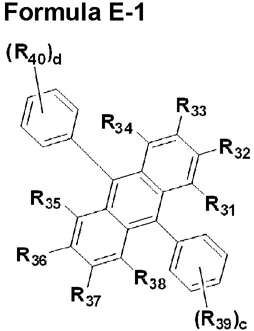

In Formula E-1, R₃₁ to R₄₀ may each independently be hydrogen, deuterium, a halogen, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In one or more embodiments, one or more selected from among R₃₁ to R₄₀ may be each independently bonded to an adjacent group to form a saturated hydrocarbon ring, an unsaturated hydrocarbon ring, a saturated heterocycle, or an unsaturated heterocycle.

In Formula E-1, c and d may each independently be an integer of 0 to 5.

The compound represented by Formula E-1 may be any one selected from among Compound E1 to Compound E19:

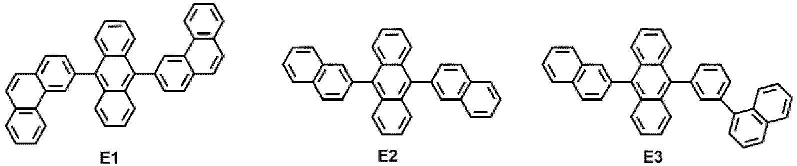

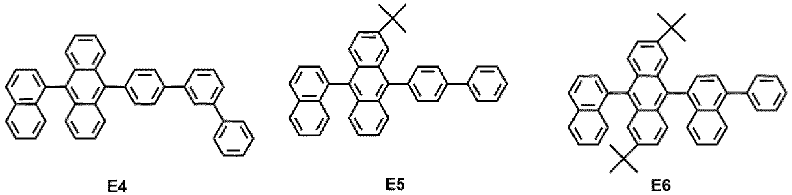

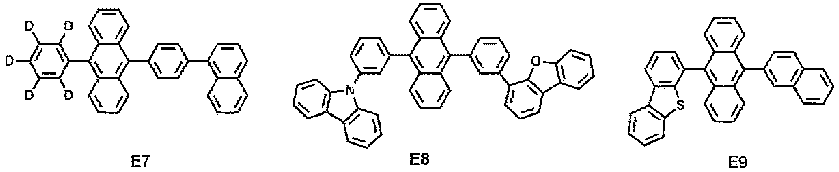

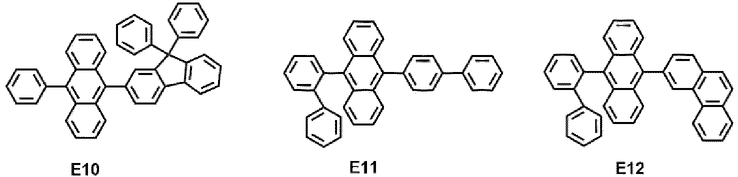

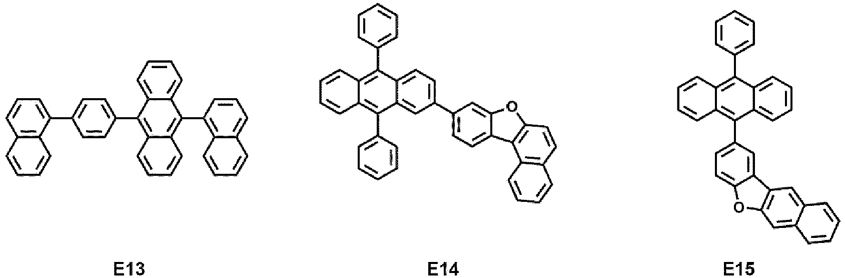

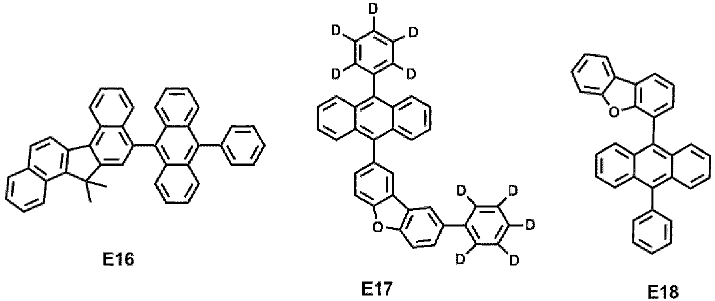

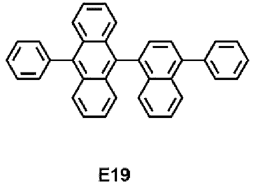

In one or more embodiments, the emission layer EML may include a compound represented by Formula E-2a or Formula E-2b. The compound represented by Formula E-2a or Formula E-2b may be used as a phosphorescent host material.

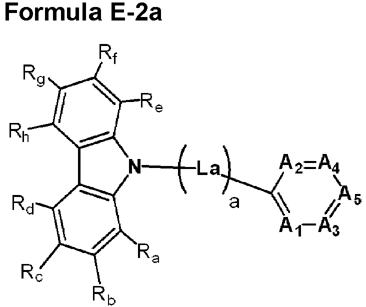

In Formula E-2a, a may be an integer of 0 to 10, and Lₐ may be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) a is an integer of 2 or greater, a plurality of Lₐ's may each independently be a substituted or unsubstituted arylene group having 6 to 30 ring-forming carbon atoms, or a substituted or unsubstituted heteroarylene group having 2 to 30 ring-forming carbon atoms.

In addition, in Formula E-2a, A₁ to A₅ may each independently be N or CRᵢ. Rₐ to Rᵢ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In one or more embodiments, one or more selected from among Rₐ to Rᵢ may be independently bonded to an adjacent group to form a hydrocarbon ring or a heterocycle containing N, O, S, and/or the like, as a ring-forming atom.

In one or more embodiments, in Formula E-2a, two or three selected from among A₁ to A₅ may be N, and the rest may be CRᵢ.

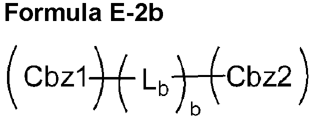

In Formula E-2b, Cbz1 and Cbz2 may each independently be an unsubstituted carbazole group or a carbazole group substituted with an aryl group having 6 to 30 ring-forming carbon atoms. L_{b} may be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, b may be an integer of 0 to 10, and if (e.g., when) b is an integer of 2 or more, a plurality of L_{b}'s may each independently be a substituted or unsubstituted arylene group having 6 to 30 ring-forming carbon atoms or a substituted or unsubstituted heteroarylene group having 2 to 30 ring-forming carbon atoms.

The compound represented by Formula E-2a or Formula E-2b may be any one selected from among compounds of Compound Group E-2. However, the compounds listed in Compound Group E-2 are mere examples, and the compound represented by Formula E-2a or Formula E-2b is not limited to those represented in Compound Group E-2.

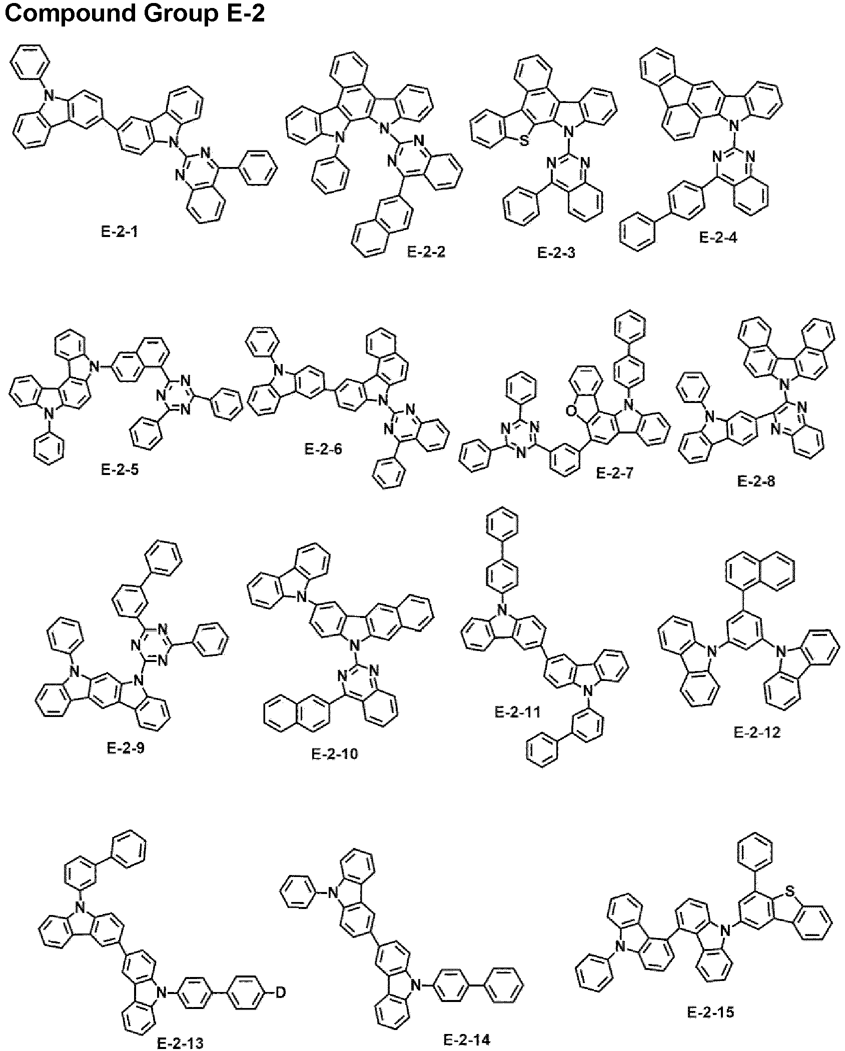

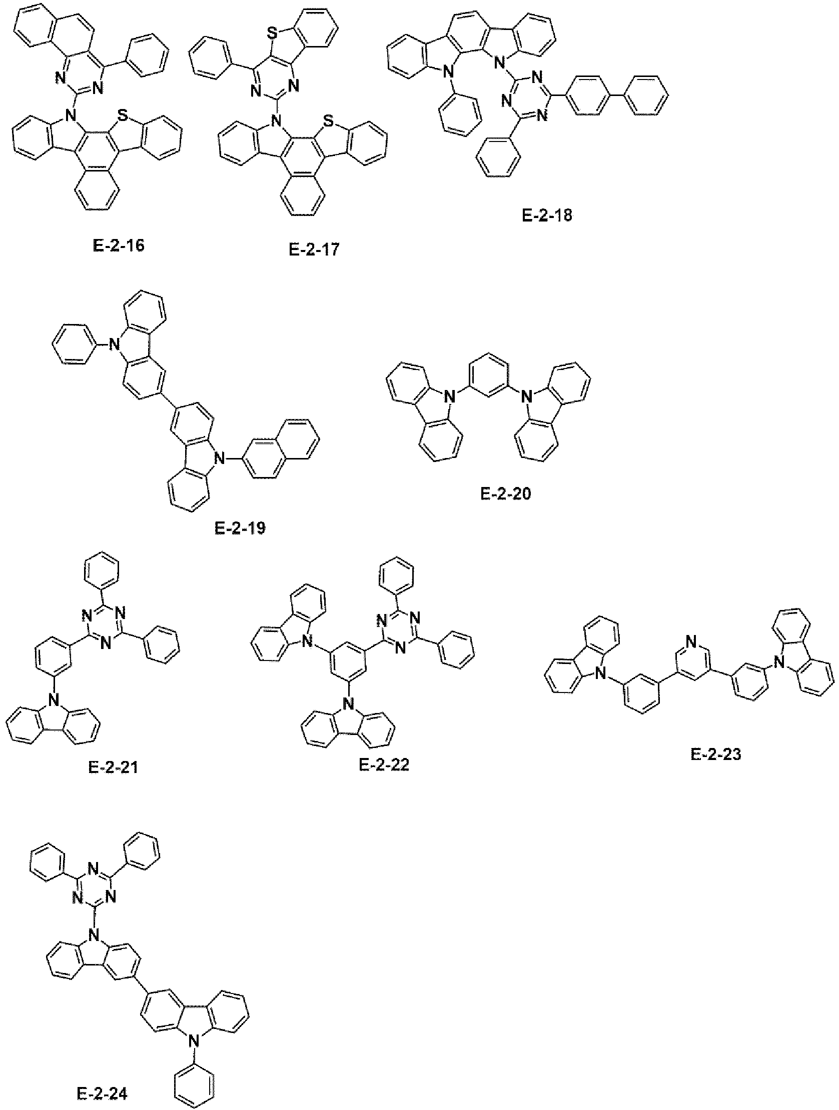

In one or more embodiments, the emission layer EML may further include a material suitable in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazol-2-yl)benzene (TPBi). However, embodiments of the present disclosure are not limited thereto, for example, tris(8-hydroxyquinolinato)aluminum (Alqs), 9,10-di(naphthalen-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiOs), octaphenylcyclotetrasiloxane (DPSiO₄), and/or the like, may be used as a host material.

In one or more embodiments, the emission layer EML may include a compound represented by Formula M-a. The compound represented by Formula M-a may be used as a phosphorescent dopant material.

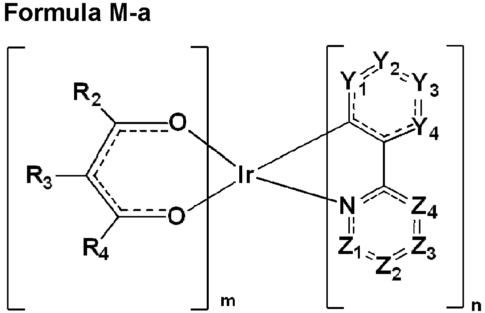

In Formula M-a, Y₁ to Y₄ and Z₁ to Z₄ may each independently be CR₁ or N, R₁ to R₄ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In Formula M-a, m is 0 or 1, and n is 2 or 3. In Formula M-a, if (e.g., when) m is 0, n is 3, and if (e.g., when) m is 1, n is 2.

The compound represented by Formula M-a may be used as a phosphorescent dopant.

The compound represented by Formula M-a may be any one selected from among Compound M-a1 to Compound M-a25. However, Compounds M-a1 to M-a25 are mere examples, and the compound represented by Formula M-a is not limited to those represented by Compounds M-a1 to M-a25.

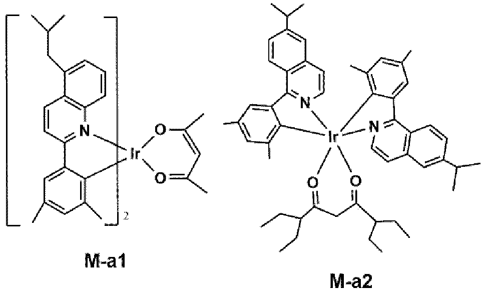

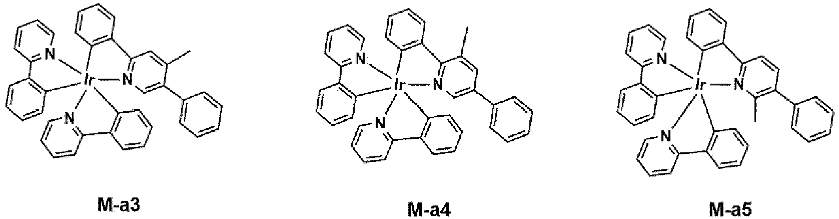

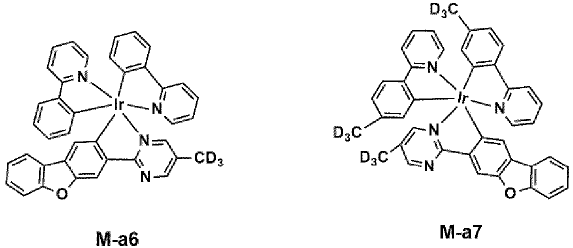

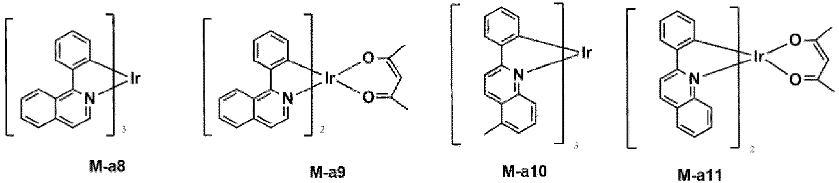

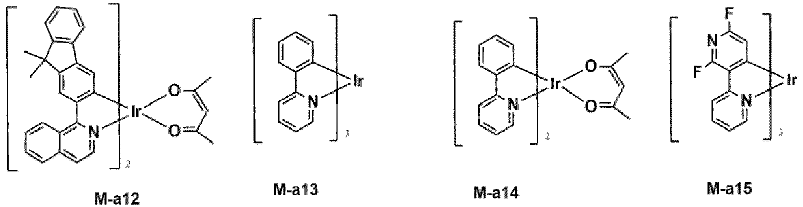

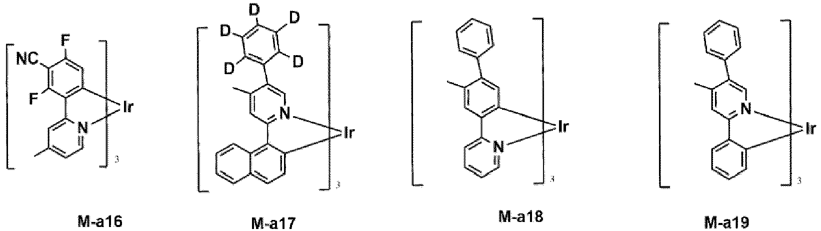

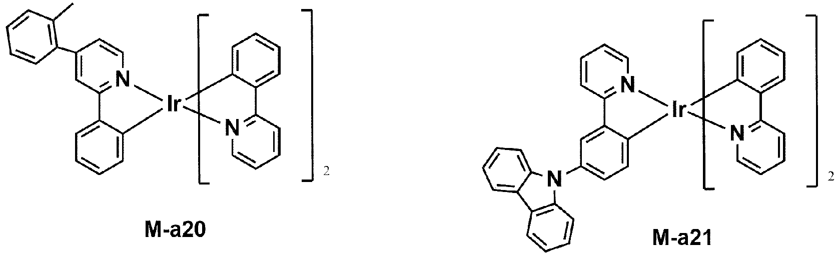

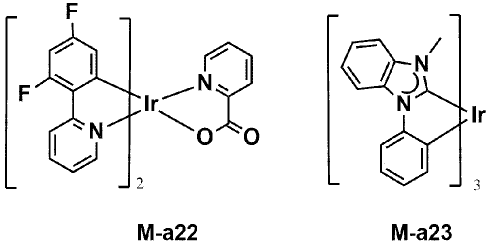

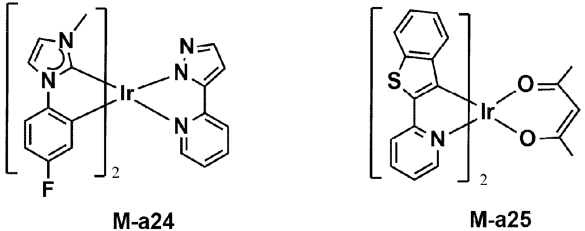

In one or more embodiments, the emission layer EML may include a compound represented by any one selected from among Formula F-a to Formula F-c. The compound represented by Formula F-a to Formula F-c may be used as a fluorescence dopant material.

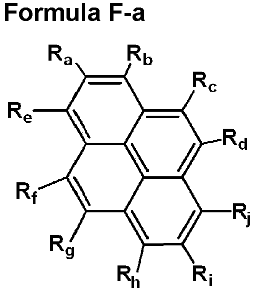

In Formula F-a, two selected from among Rₐ to Rⱼ may each independently be substituted with *-NAr₁Ar₂. The others, which are not substituted with *-NAr₁Ar₂ , among Rₐ to Rⱼ may each independently be hydrogen, deuterium, a halogen, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. For example, in some embodiments, at least one of Ar₁ or Ar₂ may be a heteroaryl group containing O or S as a ring-forming atom.

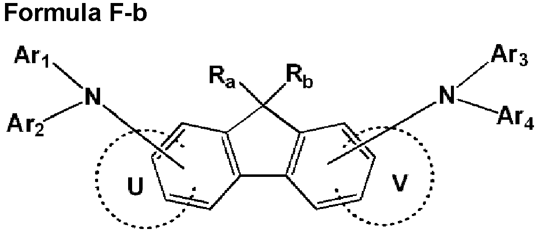

In Formula F-b, Rₐ and R_{b} may each independently be hydrogen, deuterium, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. Ar₁ to Ar₄ may each independently be a substituted or unsubstituted aryl group having 6 to 30 ring-forming carbon atoms or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms or a substituted or unsubstituted heterocycle having 2 to 30 ring-forming carbon atoms. In some embodiments, at least one selected from among Ar₁ to Ar₄ may be a heteroaryl group containing O or S as a ring-forming atom.

In Formula F-b, the number of rings represented by U and V may each independently be 0 or 1. For example, in Formula F-b, it refers to that if (e.g., when) the number of U or V is 1, one ring constitutes a part of a fused ring at a portion indicated by U or V, and if (e.g., when) the number of U or V is 0, a ring indicated by U or V does not exist. For example, if (e.g., when) the number of U is 0 and the number of V is 1, or if (e.g., when) the number of U is 1 and the number of V is 0, the fused ring having a fluorene core in Formula F-b may be a cyclic compound having four rings. In one or more embodiments, if (e.g., when) each number of U and V is 0, the fused ring in Formula F-b may be a cyclic compound having three rings. In one or more embodiments, if (e.g., when) each number of U and V is 1, the fused ring having a fluorene core in Formula F-b may be a cyclic compound having five rings.

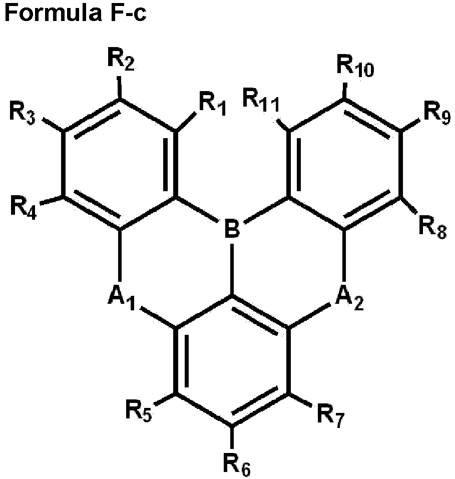

In Formula F-c, A₁ and A₂ may each independently be O, S, Se, or NRₘ, and Rₘ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ may each independently be hydrogen, deuterium, a halogen, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring.

In one or more embodiments, in Formula F-c, A₁ and A₂ may each independently be bonded to substituents of an adjacent ring to form a fused ring. For example, if (e.g., when) A₁ and A₂ may each independently be NRₘ, A₁ may be bonded to R₄ or Rs to form a ring. In addition, A₂ may be bonded to R₇ or R₈ to form a ring.

In one or more embodiments, the emission layer EML may further include, as a suitable dopant material, one or more selected from among styryl derivative(s) (e.g., 1,4-bis[2-(3-N-ethylcarbazolyl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi)), perylene and derivative(s) thereof (e.g., 2,5,8,11-tetra-t-butylperylene (TBP)), pyrene and derivative(s) thereof (e.g., 1,1-dipyrene, 1,4-dipyrenylbenzene, 1,4-bis(N,N-diphenylamino)pyrene), and/or the like.

In one or more embodiments, the emission layer EML may further include a suitable phosphorescence dopant material. For example, a metal complex containing iridium (Ir), platinum (Pt), osmium (Os), aurum (Au), titanium (Ti), zirconium (Zr), hafnium (Hf), europium (Eu), terbium (Tb), or thulium (Tm) may be used as a phosphorescent dopant. For example, iridium(III) bis(4,6-difluorophenylpyridinato-N,C2) (Flrpic), bis(2,4-difluorophenylpyridinato)-tetrakis(1-pyrazolyl)borate iridium(III) (Fir6), or platinum octaethyl porphyrin (PtOEP) may be used as a phosphorescent dopant. However, embodiments of the present disclosure are not limited thereto.

In one or more embodiments, the emission layer EML may include a quantum dot material. In one or more embodiments, the quantum dot may have a core/shell structure. The core of the quantum dot may be selected from among a Group II-VI compound, a Group III-VI compound, a Group I-III-IV compound, a Group III-V compound, a Group III-II-V compound, a Group IV-VI compound, a Group IV element, a Group IV compound, and/or a (e.g., any suitable) combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a (e.g., any suitable) mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a (e.g., any suitable) mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a (e.g., any suitable) mixture thereof.

The Group III-VI compound may include a binary compound such as In₂S₃ and/or In₂Se₃, a ternary compound such as InGaSs and/or InGaSes, or any combination thereof.

The Group I-III-VI compound may be selected from a ternary compound selected from the group consisting of AgInS, AgInS₂, CuInS, CuInS₂, AgGaS₂, CuGaS₂ CuGaO₂, AgGaO₂, AgAlO₂, and a (e.g., any suitable) mixture thereof, and/or a quaternary compound such as AgInGaS₂ or CuInGaS₂.

The Group III-V compound may be selected from the group consisting of a binary compound selected from the group consisting of GaN, GaP, GaAs, GaSb, AlN, AlP, AlAs, AlSb, InN, InP, InAs, InSb, and a (e.g., any suitable) mixture thereof, a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a (e.g., any suitable) mixture thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a (e.g., any suitable) mixture thereof. In one or more embodiments, the Group III-V compound may further include a Group II metal. For example, InZnP, and/or the like, may be selected as a Group III-II-V compound.

The Group IV-VI compound may be selected from the group consisting of a binary compound selected from the group consisting of SnS, SnSe, SnTe, PbS, PbSe, PbTe, and a (e.g., any suitable) mixture thereof, a ternary compound selected from the group consisting of SnSeS, SnSeTe, SnSTe, PbSeS, PbSeTe, PbSTe, SnPbS, SnPbSe, SnPbTe, and a (e.g., any suitable) mixture thereof, and a quaternary compound selected from the group consisting of SnPbSSe, SnPbSeTe, SnPbSTe, and a (e.g., any suitable) mixture thereof. The Group IV element may be selected from the group consisting of Si, Ge, and a (e.g., any suitable) mixture thereof. The Group IV compound may be a binary compound selected from the group consisting of SiC, SiGe, and a (e.g., any suitable) mixture thereof.

Each element included in a polynary compound such as the binary compound, the ternary compound, or the quaternary compound may be present in a particle with a substantially uniform or non-uniform concentration distribution. For example, the formulae refer to the types (kinds) of elements included in the compounds, and elemental ratios in the compound may be different. For example, AgInGaS₂ may refer to AgInₓGa₁₋ₓS₂ (where x is a real number of 0 to 1).

In one or more embodiments, the quantum dot may have a single structure or a double structure of core-shell in which the concentration of each element included in the quantum dot is substantially uniform. For example, a material included in the core may be different from a material included in the shell.

The shell of the quantum dot may serve as a protection layer to prevent or reduce the chemical deformation of the core to maintain semiconductor properties, and/or a charging layer to impart electrophoresis properties to the quantum dot. The shell may be a single layer or multiple layers. An interface between the core and the shell may have a concentration gradient in which the concentration of an element present in the shell becomes lower towards the center.

In one or more embodiments, the quantum dot may have the above-described core/shell structure including a core containing nanocrystals and a shell around (e.g., surrounding) the core. Examples of the shell of the quantum dots may include a metal or non-metal oxide, a semiconductor compound, and/or a (e.g., any suitable) combination thereof.

For example, the metal or non-metal oxide for the shell may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, and/or a ternary compound such as MgAl₂O₄, CoFe₂O₄, NiFe₂O₄, and/or CoMn₂O₄, but embodiments of the present disclosure are not limited thereto.

Also, examples of the semiconductor compound suitable as a shell may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but embodiments of the present disclosure are not limited thereto.

Each element included in a polynary compound such as the binary compound, or the ternary compound may be present in a particle with a substantially uniform or non-uniform concentration distribution. For example, the formulae refer to the types (kinds) of elements included in the compounds, and elemental ratios in the compound may be different.

The quantum dot may have a full width at half maximum (FWHM) of an emission spectrum of about 45 nm or less, about 40 nm or less, or about 30 nm or less, and the color purity or color reproducibility of the quantum dot may be improved within the above range. In addition, light emitted through such quantum dot is emitted in all directions so that a wide viewing angle may be improved.

In addition, although the form (or shape) of the quantum dot is not particularly limited as long as it is a form commonly used in the art, in one or more embodiments, the quantum dot in the form of spherical nanoparticles, pyramidal nanoparticles, multi-arm nanoparticles, or cubic nanoparticles, nanotubes, nanowires, nanofibers, nanoplate particles, or the like. may be used.

As the size of the quantum dot is adjusted or the elemental ratio in the quantum dot compound is adjusted, it may control the energy band gap of the quantum dots, and thus light in one or more suitable wavelength ranges may be obtained in a quantum dot emission layer. Therefore, the quantum dots as described above (using different sizes of quantum dots or different elemental ratios in the quantum dot compound) may be used, and thus the light emitting element, which emits light in one or more suitable wavelengths, may be implemented. For example, the adjustment of the size of the quantum dot and/or the elemental ratio in the quantum dot compound may enable the quantum dots to emit red, green, and/or blue light. In one or more embodiments, the quantum dots may be configured to emit white light by combining one or more suitable colors of light.

In each of the light emitting elements ED of embodiments illustrated in FIGS. 3 to 6, the electron transport region ETR may be provided on the emission layer EML. The electron transport region ETR may include at least one of a hole blocking layer HBL, an electron transport layer ETL, or an electron injection layer EIL, but embodiments of the present disclosure are not limited thereto.

The electron transport region ETR may have a single layer formed of a single material, a single layer formed of a plurality of different materials, or a multilayer structure including a plurality of layers formed of a plurality of different materials.

For example, in one or more embodiments, the electron transport region ETR may have a single layer structure of an electron injection layer EIL or an electron transport layer ETL, or may have a single layer structure formed of an electron injection material and an electron transport material. In one or more embodiments, the electron transport region ETR may have a single layer structure formed of a plurality of different materials, or may have a structure in which an electron transport layer ETL/electron injection layer EIL, or a hole blocking layer HBL/electron transport layer ETL/electron injection layer EIL are stacked in order (e.g., in the stated order) from the emission layer EML, but embodiments of the present disclosure are not limited thereto. The electron transport region ETR may have a thickness, for example, from about 1,000 Å to about 1,500 Å.

The electron transport region ETR may be formed using one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the electron transport region ETR may include a compound represented by Formula ET-2:

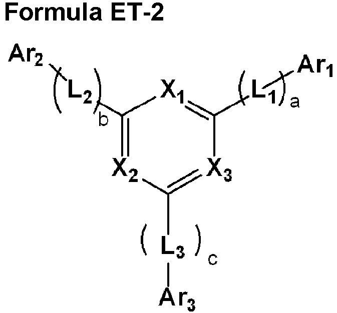

In Formula ET-2, at least one selected from among X₁ to X₃ may be N, and the rest are CRₐ. Rₐ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) a to c may each independently be an integer of 2 or more, L₁'s to Ls's may each independently be a substituted or unsubstituted arylene group having 6 to 30 ring-forming carbon atoms or a substituted or unsubstituted heteroarylene group having 2 to 30 ring-forming carbon atoms.

In one or more embodiments, the electron transport region ETR may include an anthracene-based compound. However, embodiments of the present disclosure are not limited thereto, for example, in some embodiments, the electron transport region ETR may include, for example, at least one selected from among tris(8-hydroxyquinolinato)aluminum (Alqs), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1 - yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(biphenyl-4-yl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), beryllium bis(benzoquinolin-10-olate) (Bebq₂), 9,10-di(naphthalen-2-yl)anthracene (ADN), 1,3-bis[3,5-di(pyridin-3-yl)phenyl]benzene (BmPyPhB), and/or a (e.g., any suitable) mixture (or combination) thereof.

In one or more embodiments, the electron transport region ETR may include at least one selected from among Compound ET1 to Compound ET36:

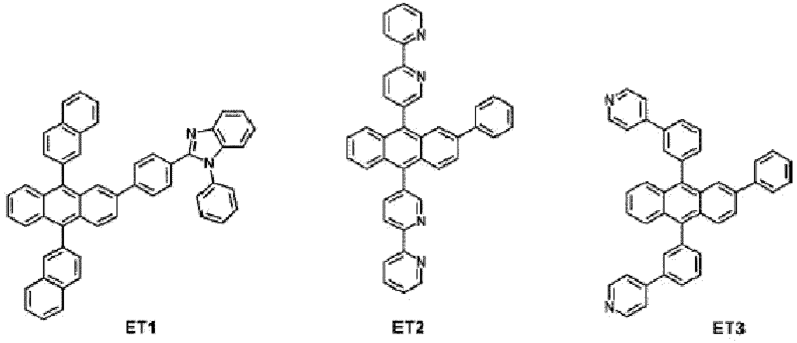

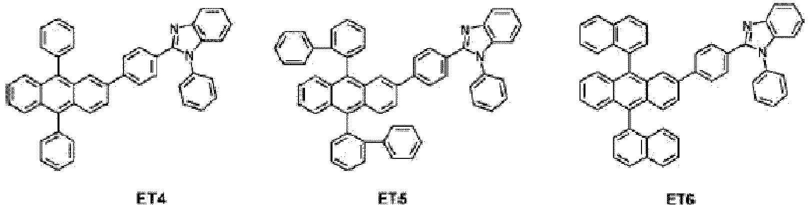

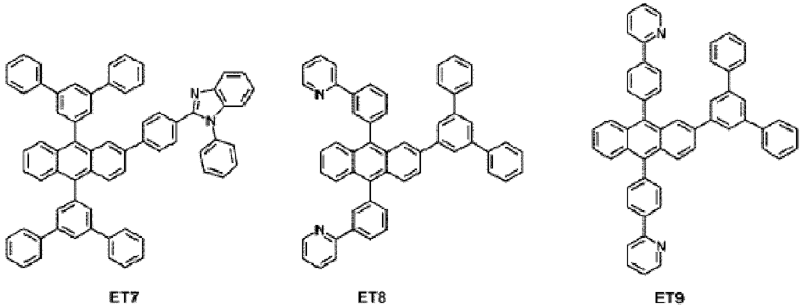

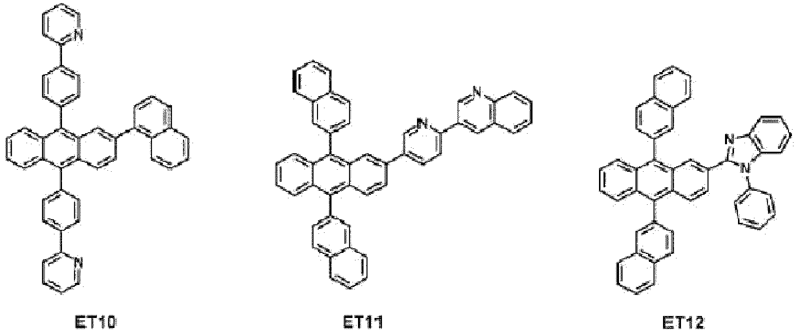

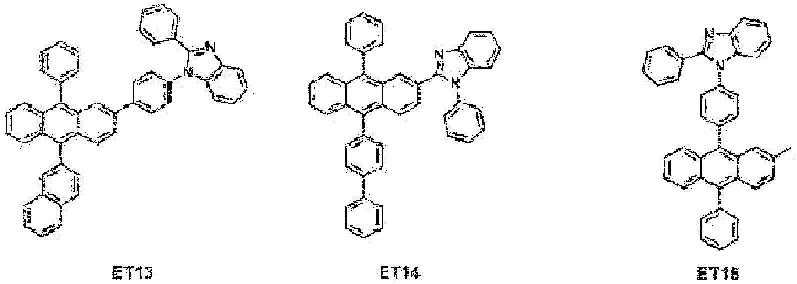

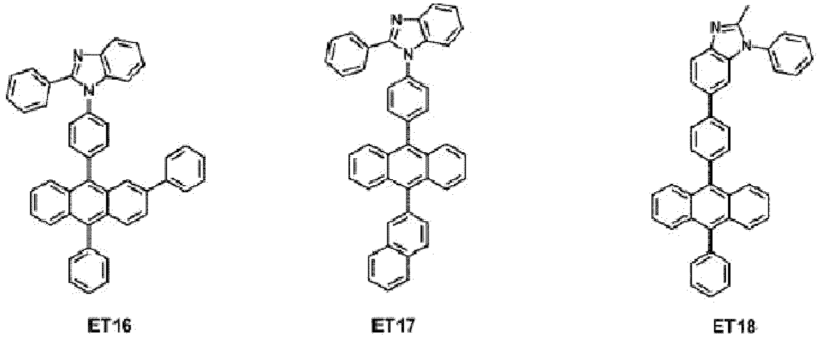

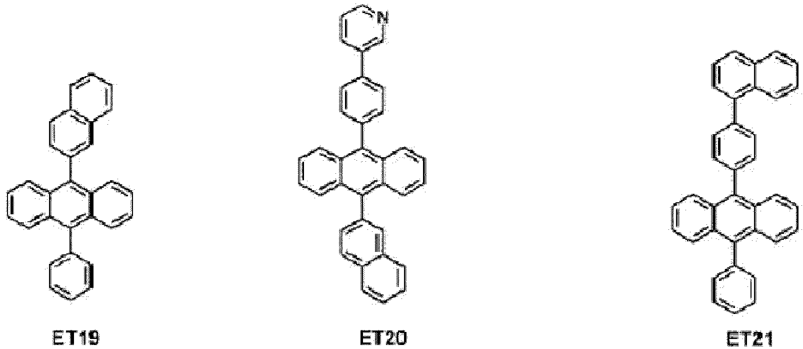

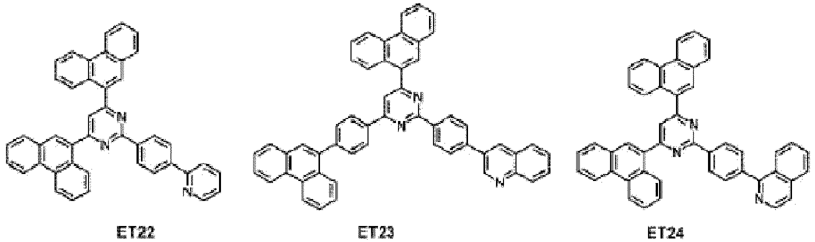

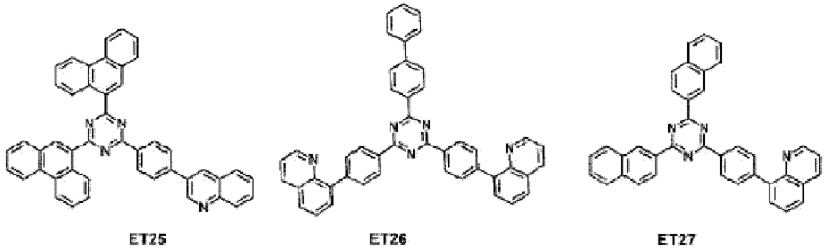

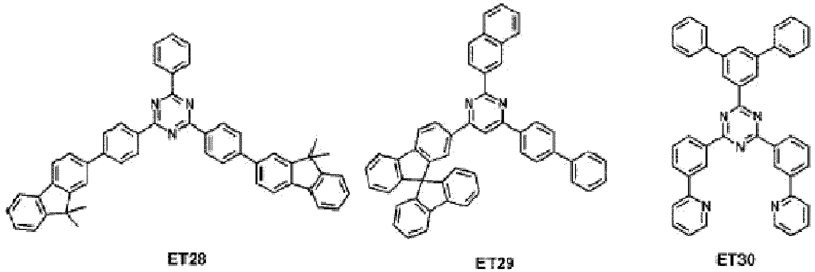

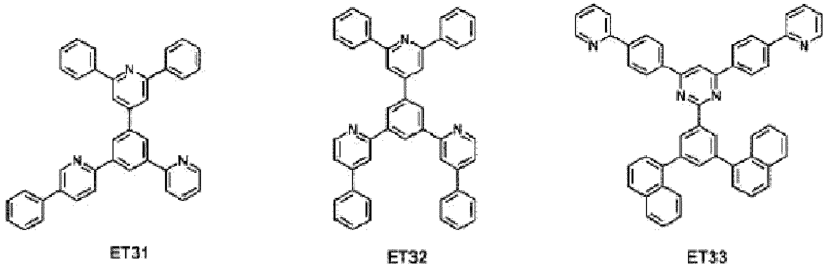

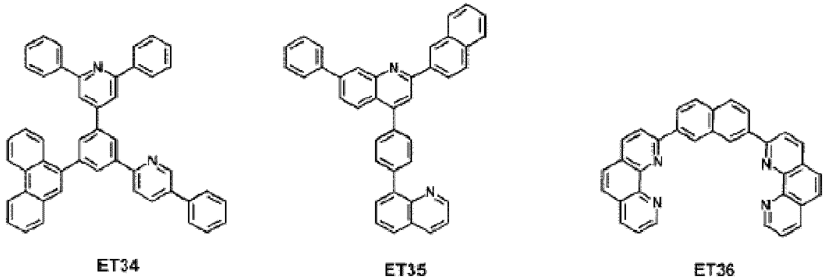

In one or more embodiments, the electron transport region ETR may include a metal halide such as LiF, NaCl, CsF, RbCl, Rbl, Cui, and/or KI, a lanthanide metal such as Yb, or a co-deposited material of the metal halide and the lanthanide metal. For example, in some embodiments, the electron transport region ETR may include KI:Yb, RbI:Yb, LiF:Yb, and/or the like, as a co-deposited material. In one or more embodiments, the electron transport region ETR may be formed using a metal oxide such as Li₂O and/or BaO, or 8-hydroxyl-lithium quinolate (Liq), and/or the like, but embodiments of the present disclosure are not limited thereto. In some embodiments, the electron transport region ETR may also be formed of a mixture material of an electron transport material and an insulating organometallic salt. The insulating organometallic salt may be a material having an energy band gap of about 4 eV or more. For example, the insulating organometallic salt may include, for example, a metal acetate, a metal benzoate, a metal acetoacetate, a metal acetylacetonate, and/or a metal stearate.

In one or more embodiments, the electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to one or more of the above-described materials, but embodiments of the present disclosure are not limited thereto.

The electron transport region ETR may include one or more of the above-described compounds of the electron transport region in at least one of an electron injection layer EIL, an electron transport layer ETL, or a hole blocking layer HBL.

When the electron transport region ETR includes an electron transport layer ETL, the electron transport layer ETL may have a thickness of about 100 Å to about 1,000 Å, for example, about 150 Å to about 500 Å. If the thickness of the electron transport layer ETL satisfies the aforementioned range, satisfactory electron transport characteristics may be obtained without a substantial increase in driving voltage. When the electron transport region ETR includes an electron injection layer EIL, the electron injection layer EIL may have a thickness of about 1 Å to about 100 Å, for example, about 3 Å to about 90 Å. If the thickness of the electron injection layer EIL satisfies the above-described range, satisfactory electron injection characteristics may be obtained without a substantial increase in driving voltage.

The second electrode EL2 may be provided on the electron transport region ETR. The second electrode EL2 may be a common electrode. The second electrode EL2 may be a cathode or an anode, but embodiments of the present disclosure are not limited thereto. For example, if (e.g., when) the first electrode EL1 is an anode, the second electrode EL2 may be a cathode, and if (e.g., when) the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a (e.g., any suitable) compound thereof, or a (e.g., any suitable) mixture thereof (e.g., AgMg, AgYb, or MgYb). In one or more embodiments, the second electrode EL2 may have a multilayer structure including a reflective film or a transflective film formed of one or more of the above-described materials, and a transparent conductive film formed of ITO, IZO, ZnO, ITZO, and/or the like. For example, the second electrode EL2 may include one of the above-described metal materials, a combination of at least two metal materials of the above-described metal materials, one or more oxide of the above-described metal materials, and/or the like.

In one or more embodiments, the second electrode EL2 may be connected with an auxiliary electrode. If (e.g., when) the second electrode EL2 is connected with the auxiliary electrode, the resistance of the second electrode EL2 may be decreased.

In one or more embodiments, a capping layer CPL may further be arranged on the second electrode EL2 of the light emitting element ED. The capping layer CPL may include a multilayer or a single layer.

In one or more embodiments, the capping layer CPL may be an organic layer or an inorganic layer. For example, if (e.g., when) the capping layer CPL contains an inorganic material, the inorganic material may include an alkali metal compound (e.g., LiF), an alkaline earth metal compound (e.g., MgF₂), SiON, SiNₓ, SiOy, and/or the like.

For example, in some embodiments, if (e.g., when) the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol-9-yl)triphenylamine (TCTA), and/or the like, or an epoxy resin, or acrylate such as methacrylate. However, embodiments of the present disclosure are not limited thereto, for example, in one or more embodiments, the capping layer CPL may include at least one selected from among Compounds P1 to P5:

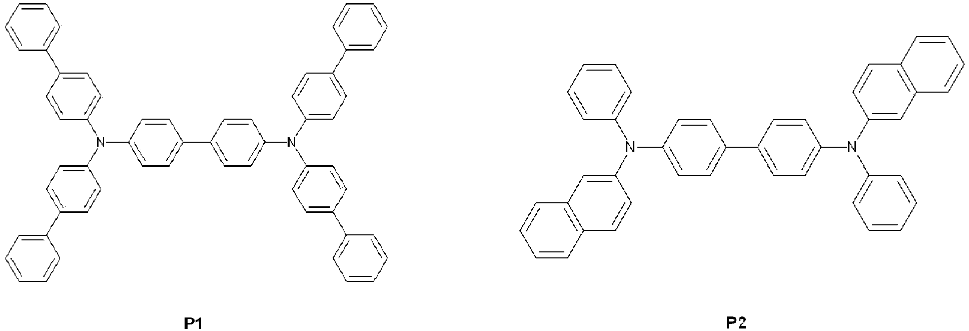

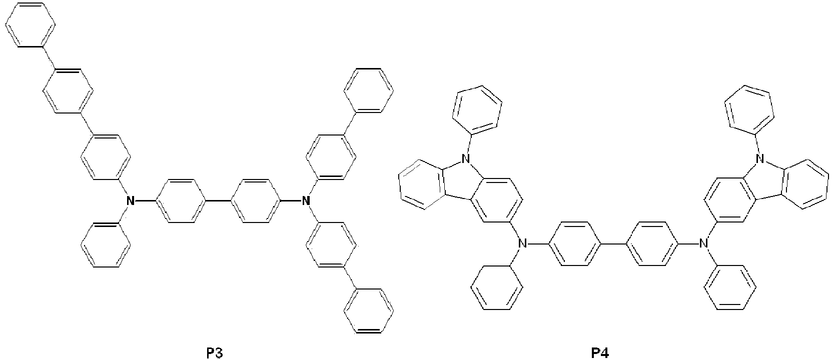

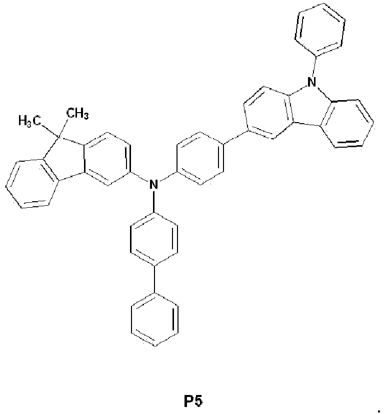

In one or more embodiments, the refractive index of the capping layer CPL may be about 1.6 or more. For example, in one or more embodiments, the refractive index of the capping layer CPL may be about 1.6 or more with respect to light in a wavelength range of about 550 nm to about 660 nm.

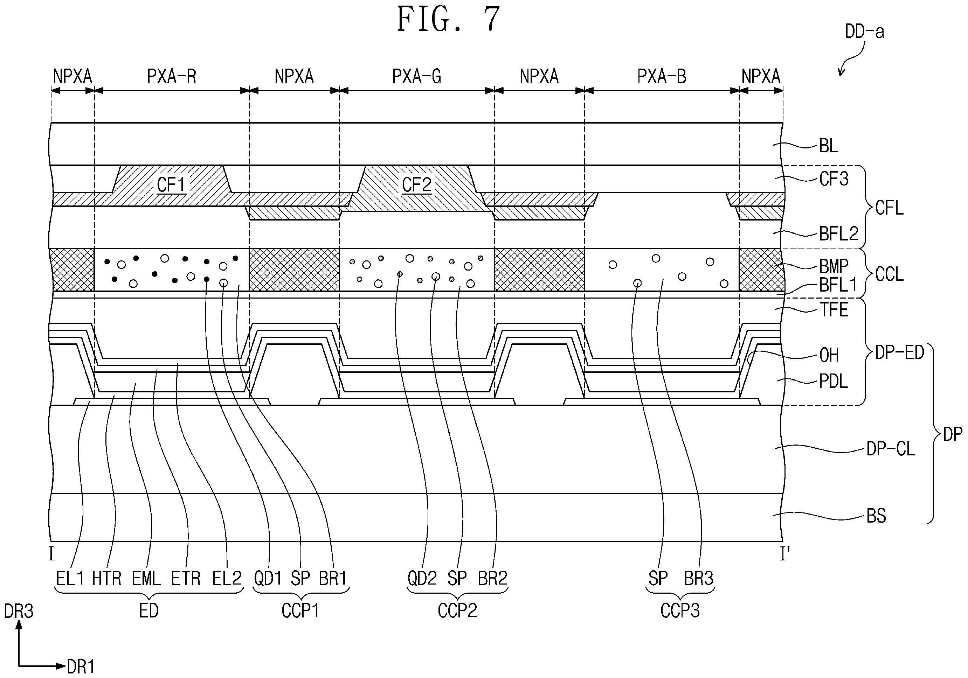

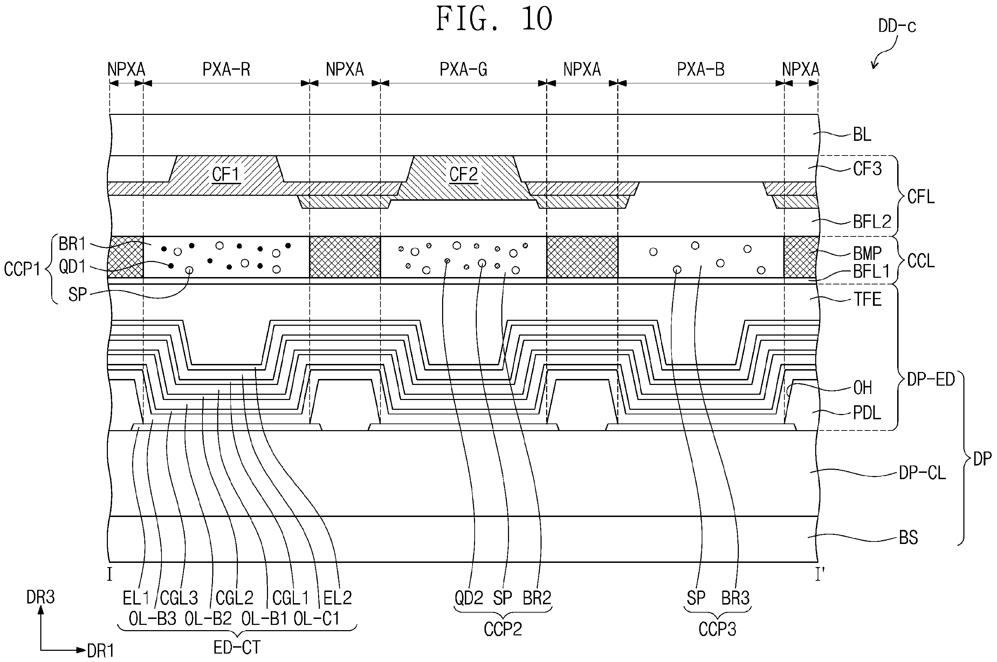

Each of FIGS. 7 to 10 is a cross-sectional view of a display apparatus according to one or more embodiments of the present disclosure. Hereinafter, in describing the display apparatuses of embodiments with reference to FIGS. 7 to 10, the duplicated features which have been described in FIGS. 1 to 6 are not described again for conciseness, only their differences will be mainly described.

Referring to FIG. 7, the display apparatus DD-a according to one or more embodiments may include a display panel DP including a display device layer DP-ED, a light control layer CCL arranged on the display panel DP, and a color filter layer CFL. In one or more embodiments illustrated in FIG. 7, the display panel DP may include a base layer BS, a circuit layer DP-CL provided on the base layer BS, and the display device layer DP-ED, and the display device layer DP-ED may include a light emitting device ED.

The light emitting device ED may include a first electrode EL1, a hole transport region HTR arranged on the first electrode EL1, an emission layer EML arranged on the hole transport region HTR, an electron transport region ETR arranged on the emission layer EML, and a second electrode EL2 arranged on the electron transport region ETR. In one or more embodiments, the structure of any one of the light emitting elements of FIGS. 3 to 6 described above may be equally applied to the structure of the light emitting device ED illustrated in FIG. 7.

The emission layer EML of the light emitting device ED included in the display device DD-a according to one or more embodiments may include the fused polycyclic compound of one or more embodiments described above.

Referring to FIG. 7, the emission layer EML may be arranged in an opening OH defined in a pixel defining film PDL. For example, the emission layer EML which is divided by the pixel defining film PDL and provided corresponding to each of light emitting regions PXA-R, PXA-G, and PXA-B may be to emit light in substantially the same wavelength range. In the display apparatus DD-a of one or more embodiments, the emission layer EML may be to emit blue light. In one or more embodiments, the emission layer EML may be provided as a common layer in the entire light emitting regions PXA-R, PXA-G, and PXA-B.

The light control layer CCL may be arranged on the display panel DP. The light control layer CCL may include a light conversion body. The light conversion body may be a quantum dot, a phosphor, and/or the like. The light conversion body may be to emit provided light by converting the wavelength thereof. For example, the light control layer CCL may a layer containing a quantum dot or a layer containing a phosphor.

The light control layer CCL may include a plurality of light control parts CCP1, CCP2, and CCP3. The light control parts CCP1, CCP2, and CCP3 may be spaced and/or apart (e.g., spaced apart or separated) from each other.

Referring to FIG. 7, divided patterns BMP may be arranged between the light control parts CCP1, CCP2, and CCP3 which are spaced and/or apart (e.g., spaced apart or separated) from each other, but embodiments of the present disclosure are not limited thereto. FIG. 7 illustrates that the divided patterns BMP do not overlap the light control parts CCP1, CCP2, and CCP3, but, in some embodiments, at least a portion of the edges of the light control parts CCP1, CCP2, and CCP3 may overlap the divided patterns BMP.

The light control layer CCL may include a first light control part CCP1 containing a first quantum dot QD1 which converts first color light provided from the light emitting device ED into second color light, a second light control part CCP2 containing a second quantum dot QD2 which converts the first color light into third color light, and a third light control part CCP3 which transmits the first color light.

In one or more embodiments, the first light control part CCP1 may provide red light that is the second color light, and the second light control part CCP2 may provide green light that is the third color light. The third light control part CCP3 may provide blue light by transmitting the blue light that is the first color light provided from the light emitting device ED. For example, in one or more embodiments, the first quantum dot QD1 may be a red quantum dot to emit red light, and the second quantum dot QD2 may be a green quantum dot to emit green light. The same as described above on quantum dots may be applied with respect to the quantum dots QD1 and QD2.

In one or more embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) any quantum dot but include the scatterer SP.

The scatterer SP may be inorganic particles. For example, the scatterer SP may include at least one of TiO₂, ZnO, Al₂O₃, SiO₂, or hollow sphere silica. In one or more embodiments, the scatterer SP may include any one selected from among TiO₂, ZnO, Al₂O₃, SiO₂, and hollow sphere silica, or may be a mixture of at least two materials selected from among TiO₂, ZnO, Al₂O₃, SiO₂, and hollow sphere silica.

The first light control part CCP1, the second light control part CCP2, and the third light control part CCP3 may respectively include base resins BR1, BR2, and BR3 in which the quantum dots QD1 and QD2 and the scatterer SP are dispersed. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may be formed of one or more suitable resin compositions, which may be generally referred to as a binder. For example, the base resins BR1, BR2, and BR3 may each independently be acrylic-based resins, urethane-based resins, silicone-based resins, epoxy-based resins, and/or the like. The base resins BR1, BR2, and BR3 may be transparent resins. In one or more embodiments, the first base resin BR1, the second base resin BR2, and the third base resin BR3 may be the same as or different from each other.

In one or more embodiments, the light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may block the light control parts CCP1, CCP2, and CCP3 from being exposed to moisture/oxygen. In one or more embodiments, the barrier layer BFL1 may cover the light control parts CCP1, CCP2, and CCP3. In one or more embodiments, a barrier layer BFL2 may be provided between the light control parts CCP1, CCP2, and CCP3 and the color filter layer CFL.

The barrier layers BFL1 and BFL2 may include at least one inorganic layer. For example, in some embodiments, the barrier layers BFL1 and BFL2 may each include an inorganic material. For example, the barrier layers BFL1 and BFL2 may each independently include a silicon nitride, an aluminum nitride, a zirconium nitride, a titanium nitride, a hafnium nitride, a tantalum nitride, a silicon oxide, an aluminum oxide, a titanium oxide, a tin oxide, a cerium oxide, a silicon oxynitride, a metal thin film which secures a transmittance, and/or the like. In one or more embodiments, the barrier layers BFL1 and BFL2 may further include an organic film. The barrier layers BFL1 and BFL2 may be formed of a single layer or a plurality of layers.

In the display apparatus DD-a of one or more embodiments, the color filter layer CFL may be arranged on the light control layer CCL. For example, in one or more embodiments, the color filter layer CFL may be directly arranged on the light control layer CCL. In these embodiments, the barrier layer BFL2 may not be provided.

The color filter layer CFL may include color filters CF1, CF2, and CF3. The color filter layer CFL may include a first filter CF1 configured to transmit the second color light, a second filter CF2 configured to transmit the third color light, and a third filter CF3 configured to transmit the first color light. For example, in one or more embodiments, the first filter CF1 may be a red filter, the second filter CF2 may be a green filter, and the third filter CF3 may be a blue filter. The filters CF1, CF2, and CF3 each may include a polymeric photosensitive resin and a pigment and/or a dye. The first filter CF1 may include a red pigment and/or a red dye, the second filter CF2 may include a green pigment and/or a green dye, and the third filter CF3 may include a blue pigment and/or a blue dye.

In one or more embodiments, the third filter CF3 may not include (e.g., may exclude) a pigment and/or a dye. The third filter CF3 may include a polymeric photosensitive resin and may not include (e.g., may exclude) any pigment and/or dye. The third filter CF3 may be transparent. The third filter CF3 may be formed of a transparent photosensitive resin.

Furthermore, in one or more embodiments, the first filter CF1 and the second filter CF2 may each be a yellow filter. The first filter CF1 and the second filter CF2 may not be separated but be provided as one filter.

In one or more embodiments, the color filter layer CFL may further include a light shielding part. The light shielding part may be a black matrix. The light shielding part may include an organic light shielding material or an inorganic light shielding material containing a black pigment and/or a black dye. The light shielding part may prevent or reduce light leakage, and may separate boundaries between the adjacent filters CF1, CF2, and CF3.

The first to third filters CF1, CF2, and CF3 may be arranged corresponding to the red light emitting region PXA-R, the green light emitting region PXA-G, and the blue light emitting region PXA-B, respectively.

In one or more embodiments, a base substrate BL may be arranged on the color filter layer CFL. The base substrate BL may be a member which provides a base surface on which the color filter layer CFL, the light control layer CCL, and/or the like are arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In addition, in one or more embodiments, the base substrate BL may not be provided.

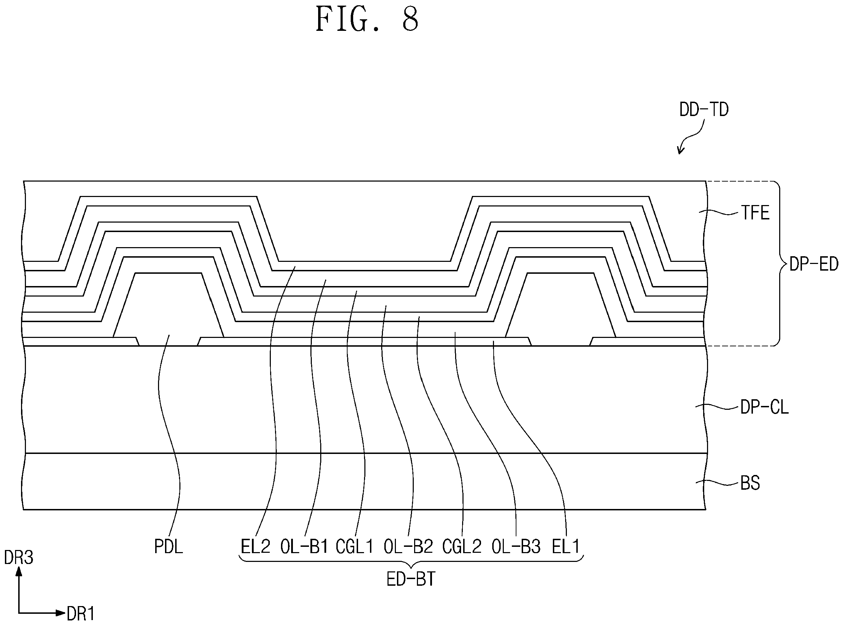

FIG. 8 is a cross-sectional view illustrating a portion of a display apparatus according to one or more embodiments. In a display apparatus DD-TD of one or more embodiments, the light emitting device ED-BT may include a plurality of light emitting structures OL-B1, OL-B2, and OL-B3. The light emitting device ED-BT may include a first electrode EL1 and a second electrode EL2 which face each other, and the plurality of light emitting structures OL-B1, OL-B2, and OL-B3 sequentially stacked in a thickness direction between the first electrode EL1 and the second electrode EL2. The light emitting structures OL-B1, OL-B2, and OL-B3 each may include an emission layer EML (FIG. 7) and a hole transport region HTR and an electron transport region ETR arranged with the emission layer EML (FIG. 7) located therebetween.

For example, the light emitting device ED-BT included in the display apparatus DD-TD of one or more embodiments may be a light emitting device having a tandem structure and including a plurality of emission layers.

In one or more embodiments illustrated in FIG. 8, all light beams respectively emitted from the light emitting structures OL-B1, OL-B2, and OL-B3 may be blue light. However, embodiments of the present disclosure are not limited thereto, for example, in one or more embodiments, the light beams respectively emitted from the light emitting structures OL-B1, OL-B2, and OL-B3 may have wavelength ranges different from each other. For example, in one or more embodiments, the light emitting device ED-BT including the plurality of light emitting structures OL-B1, OL-B2, and OL-B3 which emit light beams having wavelength ranges different from each other may be to emit white light (e.g., combined white light).

Charge generation layers CGL1 and CGL2 may be respectively arranged between two of the neighboring light emitting structures OL-B1, OL-B2, and OL-B3. The charge generation layers CGL1 and CGL2 may include a p-type or kind charge (e.g., P-charge) generation layer and/or an n-type or kind charge (e.g., N-charge) generation layer. At least one of the light emitting structures OL-B1, OL-B2, or OL-B3 included in the display device DD-TD of one or more embodiments may include the fused polycyclic compound of one or more embodiments described above. For example, in one or more embodiments, at least one selected from among the plurality of emission layers included in the light emitting element ED-BT may include the fused polycyclic compound of one or more embodiments.

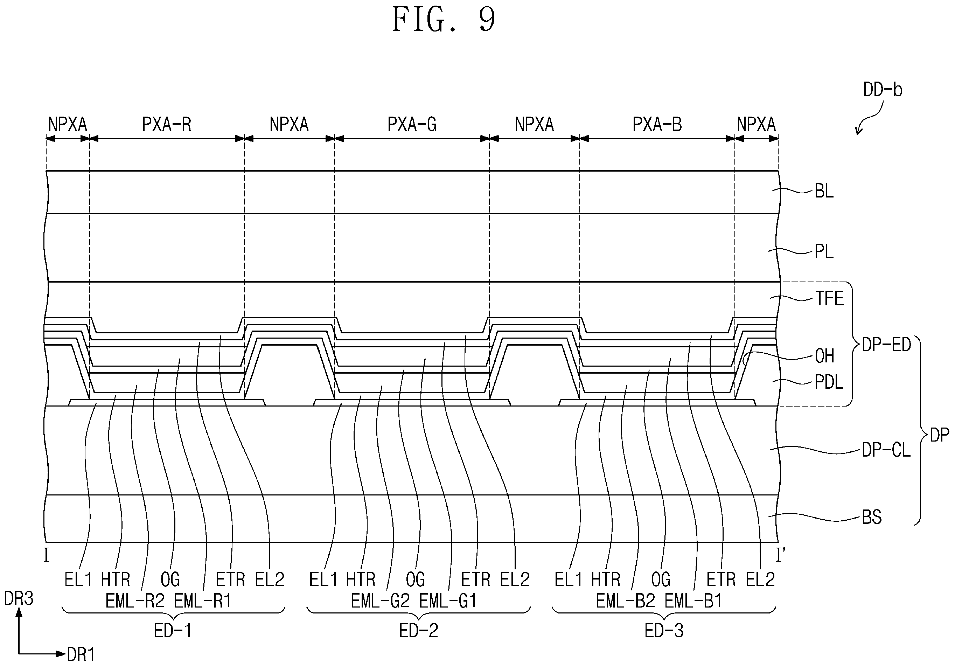

Referring to FIG. 9, a display apparatus DD-b according to one or more embodiments may include light emitting devices ED-1, ED-2, and ED-3 in which two emission layers are stacked. Compared with the display apparatus DD illustrated in FIG. 2, the display apparatus DD-b illustrated in FIG. 9 has a difference in that the first to third light emitting devices ED-1, ED-2, and ED-3 each include two emission layers stacked in a thickness direction. In each of the first to third light emitting devices ED-1, ED-2, and ED-3, the two emission layers may be to emit light in substantially the same wavelength region.

In one or more embodiments, the first light emitting device ED-1 may include a first red emission layer EML-R1 and a second red emission layer EML-R2. The second light emitting device ED-2 may include a first green emission layer EML-G1 and a second green emission layer EML-G2. In addition, the third light emitting device ED-3 may include a first blue emission layer EML-B1 and a second blue emission layer EML-B2. An emission auxiliary part OG may be separately arranged between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. In one or more embodiments, the emission auxiliary part OG may include an electron transport region, a charge generation layer, and a hole transport region that are sequentially stacked (e.g., in the stated order). The emission auxiliary part OG may be provided as a common layer in the whole of the first to third light emitting devices ED-1, ED-2, and ED-3. However, embodiments of the present disclosure are not limited thereto, and the emission auxiliary part OG may be provided by being patterned within the openings OH defined in the pixel defining film PDL.

The first red emission layer EML-R1, the first green emission layer EML-G1, and the first blue emission layer EML-B1 may each be arranged between the emission auxiliary part OG and the electron transport region ETR. The second red emission layer EML-R2, the second green emission layer EML-G2, and the second blue emission layer EML-B2 may each be arranged between the hole transport region HTR and the emission auxiliary part OG.

For example, in one or more embodiments, the first light emitting device ED-1 may include a first electrode EL1, a hole transport region HTR, a second red emission layer EML-R2, an emission auxiliary part OG, a first red emission layer EML-R1, an electron transport region ETR, and a second electrode EL2 that are sequentially stacked (e.g., in the stated order). The second light emitting device ED-2 may include a first electrode EL1, a hole transport region HTR, a second green emission layer EML-G2, an emission auxiliary part OG, a first green emission layer EML-G1, an electron transport region ETR, and a second electrode EL2 that are sequentially stacked (e.g., in the stated order). The third light emitting device ED-3 may include a first electrode EL1, a hole transport region HTR, a second blue emission layer EML-B2, an emission auxiliary part OG, a first blue emission layer EML-B1, an electron transport region ETR, and a second electrode EL2 that are sequentially stacked (e.g., in the stated order).

In one or more embodiments, an optical auxiliary layer PL may be arranged on the display device layer DP-ED. The optical auxiliary layer PL may include a polarizing layer. The optical auxiliary layer PL may be arranged on the display panel DP and control reflected light in the display panel DP due to external light. In one or more embodiments, the optical auxiliary layer PL may not be provided in the display apparatus.

At least one emission layer included in the display device DD-b of one or more embodiments shown in FIG. 9 may include the fused polycyclic compound of one or more embodiments described above. For example, in one or more embodiments, at least one of the first blue emission layer EML-B1 or the second blue emission layer EML-B2 may include the fused polycyclic compound of one or more embodiments.

Unlike FIGS. 8 and 9, FIG. 10 illustrates that a display apparatus DD-c includes four light emitting structures OL-B1, OL-B2, OL-B3, and OL-C1. A light emitting device ED-CT may include a first electrode EL1 and a second electrode EL2 which face each other, and first to fourth light emitting structures OL-B1, OL-B2, OL-B3, and OL-C1 that are stacked in a thickness direction between the first electrode EL1 and the second electrode EL2. Charge generation layers CGL1, CGL2, and CGL3 may each be separately arranged between the first to fourth light emitting structures OL-B1, OL-B2, OL-B3, and OL-C1. In some embodiments, among the four light emitting structures, the first to third light emitting structures OL-B1, OL-B2, and OL-B3 may be to emit blue light, and the fourth light emitting structure OL-C1 may be to emit green light. However, embodiments of the present disclosure are not limited thereto, and the first to fourth light emitting structures OL-B1, OL-B2, OL-B3, and OL-C1 may be to emit light beams in different wavelength regions.

The charge generation layers CGL1, CGL2, and CGL3 arranged between adjacent light emitting structures OL-B1, OL-B2, OL-B3, and OL-C1 may include a p-type or kind charge (e.g., P-charge) generation layer and/or an n-type or kind charge (N-charge) generation layer.

At least one selected from among the light emitting structures OL-B1, OL-B2, OL-B3, and OL-C1 included in the display device DD-c according to one or more embodiments may include the fused polycyclic compound of one or more embodiments described above. For example, in one or more embodiments, at least one selected from among the first to third light emitting structures OL-B1, OL-B2, and OL-B3 may include the fused polycyclic compound of one or more embodiments described above.

The light emitting device/element ED described above according to one or more embodiments of the disclosure may include the fused polycyclic compound of one or more embodiments in at least one functional layer arranged between the first electrode EL1 and the second electrode EL2, and may thus exhibit excellent or suitable light emitting efficiency and improved lifespan. For example, the fused polycyclic compound according to one or more embodiments may be included in the emission layer EML of the light emitting device/element ED of one or more embodiments, and the light emitting device/element of one or more embodiments may exhibit long lifespan.

In one or more embodiments, an electronic apparatus may include a display apparatus including a plurality of light emitting devices, and a control part which controls the display apparatus. The electronic apparatus of one or more embodiments may be a device that is activated according to an electrical signal. The electronic apparatus may include display apparatuses of one or more suitable embodiments. For example, the electronic apparatus may include not only large-sized electronic apparatuses such as a television set, a monitor, or an outdoor billboard but also include small- and medium-sized electronic apparatuses such as a personal computer, a laptop computer, a personal digital terminal, a display apparatus for a vehicle, a game console, a portable electronic device, or a camera.

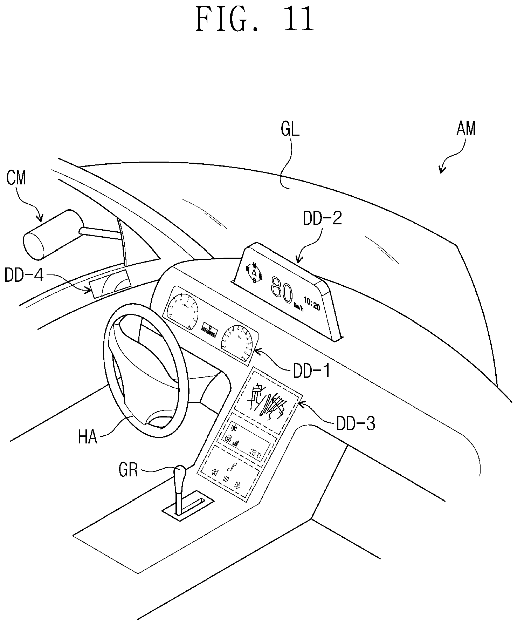

FIG. 11 is a view illustrating a vehicle AM in which first to fourth display apparatuses DD-1, DD-2, DD-3, and DD-4 are arranged. At least one selected from among the first to fourth display apparatuses DD-1, DD-2, DD-3, and DD-4 may include substantially the same configuration as the display apparatuses DD, DD-TD, DD-a, DD-b, and/or DD-c as described with reference to FIGS. 1, 2, and 7 to 10.

FIG. 11 illustrates a vehicle AM, but this is an example, and the first to fourth display apparatuses DD-1, DD-2, DD-3, and DD-4 may be arranged in other transportation apparatuses such as bicycles, motorcycles, trains, ships, and/or airplanes. In addition, at least one selected from among the first to fourth display apparatuses DD-1, DD-2, DD-3, and DD-4 including substantially the same configuration as the display apparatuses DD, DD-TD, DD-a, DD-b, and/or DD-c of one or more embodiments may be employed in a personal computer, a laptop computer, a personal digital terminal, a game console, a portable electronic device, a television, a monitor, an outdoor billboard, and/or the like. These are merely provided as embodiments, and thus the display apparatuses may be employed in other electronic apparatuses unless departing from the disclosure.

In one or more embodiments, at least one selected from among the first to fourth display devices DD-1, DD-2, DD-3, and DD-4 may include the light emitting element ED of one or more embodiments described with reference to FIGS. 3 to 6. The light emitting element ED of one or more embodiments may include the fused polycyclic compound of one or more embodiments. At least one selected from among the first to fourth display devices DD-1, DD-2, DD-3, and DD-4 may include the light emitting element ED including the fused polycyclic compound of one or more embodiments, and may thus have increased display lifespan.

Referring to FIG. 11, the vehicle AM may include a steering wheel HA and a gear GR for driving the vehicle AM. In addition, the vehicle AM may include a front window GL arranged so as to face a driver.

The first display apparatus DD-1 may be arranged in a first region overlapping the steering wheel HA. For example, the first display apparatus DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, and/or the like. The first scale and the second scale may each be indicated as a digital image.

The second display apparatus DD-2 may be arranged in a second region facing a driver seat and overlapping the front window GL. The driver seat may be a seat in which the steering wheel HA faces. For example, the second display apparatus DD-2 may be a head up display (HUD) which displays second information of the vehicle AM. The second display apparatus DD-2 may be optically transparent. The second information may include digital numbers which indicate a driving speed, and may further include information such as the current time. In some embodiments, the second information of the second display apparatus DD-2 may be projected to the front window GL to be displayed.

The third display apparatus DD-3 may be arranged in a third region adjacent to the gear GR. For example, the third display apparatus DD-3 may be arranged between the driver seat and a passenger seat and may be a center information display (CID) for the vehicle for displaying third information. The passenger seat may be a seat spaced and/or apart (e.g., spaced apart or separated) from the driver seat with the gear GR arranged therebetween. The third information may include information about traffic (e.g., navigation information), playing music or radio or a video (or an image), temperatures inside the vehicle AM, and/or the like.

The fourth display apparatus DD-4 may be spaced and/or apart (e.g., spaced apart or separated) from the steering wheel HA and the gear GR, and may be arranged in a fourth region adjacent to a side of the vehicle AM. For example, the fourth display apparatus DD-4 may be a digital side-view mirror which displays fourth information. The fourth display apparatus DD-4 may display an image outside the vehicle AM taken by a camera module CM arranged outside the vehicle AM. The fourth information may include an image outside the vehicle AM.

The above-described first to fourth information may be examples, and the first to fourth display apparatuses DD-1, DD-2, DD-3, and DD-4 may further display information about the inside and outside of the vehicle AM. The first to fourth information may each include different information. However, embodiments of the present disclosure are not limited thereto, and a part of the first to fourth information may include the same information as one another.

Hereinafter, with reference to Examples and Comparative Examples, a fused polycyclic compound according to one or more embodiments of the disclosure and a light-emitting element according to one or more embodiments will be described in more detail. In addition, Examples described are shown only for understanding the present disclosure, and the scope of the disclosure is not limited thereto.

### Examples

### 1. Synthesis of fused polycyclic compound

First, synthetic methods of fused polycyclic compounds according to one or more embodiments will be described in more detail by exemplifying synthetic methods of Compounds 3, 4, 15, 22, 28, 29, and 54. In addition, the synthetic methods of the fused polycyclic compounds, which will be described hereinafter, are provided as examples, and thus the synthetic methods of the fused polycyclic compounds according to one or more embodiments of the present disclosure are not limited to Examples.

### (1) Synthesis of Intermediate Compounds 1a to 1c

### Synthesis of Intermediate Compound 1a

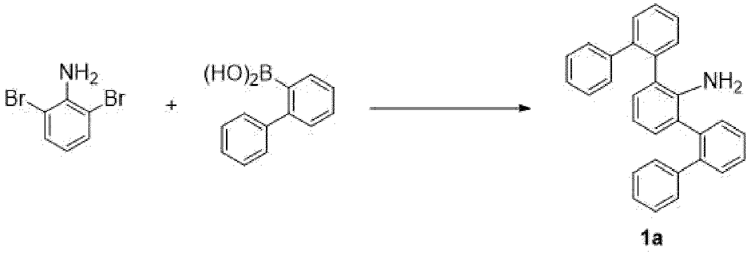

Under argon (Ar) atmosphere, 2,6-dibromoaniline (25.1 g), 2-biphenylboronic acid (49.1 g), Pd(PPh₃)₄ (12.5 g), and K₂CO₃ (27.1 g) were put in a 3000 mL three-neck flask, toluene (700 mL), EtOH (200 mL), and water (200 mL) were added, and the mixture was heated and refluxed for 12 hours. The temperature was then returned to room temperature, then water was added, the product was extracted with CH₂Cl₂, an organic layer was collected, dried over MgSO₄, and a solvent was removed by evaporation under reduced pressure. The obtained crude product was purified with silica gel column chromatography to thereby obtain Intermediate Compound **1a** of 31.4 g (yield: 78%). The mass of Intermediate Compound **1a** measured by fast atom bombardment mass spectrometry (FAB-MS) was 397.

### Synthesis of Intermediate Compound 1b

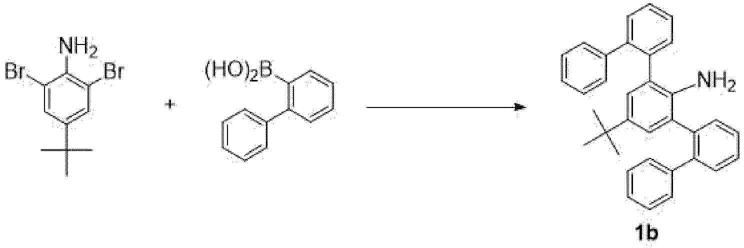

Intermediate Compound **1b** (33.0 g, yield of 72%) was synthesized in substantially the same manner as Intermediate Compound **1a** using 2,6-dibromo-4-tert-butyl-aniline (31.6 g) in place of 2,6-dibromoaniline. The mass of Intermediate Compound **1b** measured by FAB-MS was 453.

### Synthesis of Intermediate Compound 1c

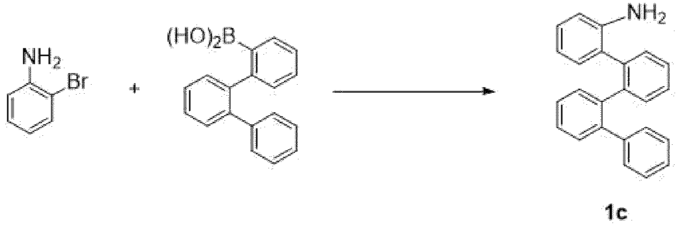

Intermediate Compound **1c** (16 g, yield of 49%) was synthesized in substantially the same manner as Intermediate Compound **1a** using 2-bromoaniline (17.2 g) and {2'-phenyl-[1,1'-biphenyl]-2-yl}boronic acid (33.9 g) in place of 2,6-dibromoaniline and 2-biphenylboronic acid. The mass of Intermediate Compound **1c** measured by FAB-MS was 321.

### (2) Synthesis of Intermediate Compounds 2a to 2e

### Synthesis of Intermediate Compound 2a

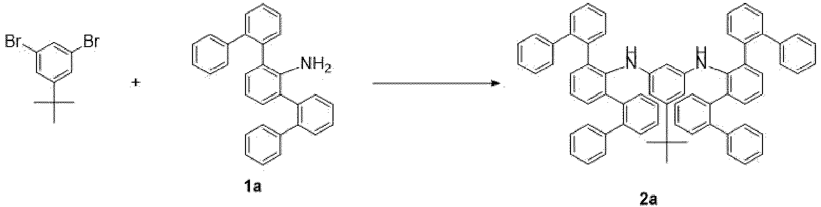

Under Ar atmosphere, 1,3-dibromo-5-tert-butylbenzene (10.2 g), Intermediate Compound **1a** (28.6 g), bis(dibenzylideneacetone)palladium(0) (Pd(dba)₂) (2.1 g), 2-dicyclohexylphosphino-2',6'-dimethoxybiphenyl (Sphos) (1.6 g), and NaOtBu (6.7 g) were put in a 2000 mL three-neck flask, and were dissolved in toluene (350 mL), and the mixture was heated and refluxed for 2 hours. The temperature was then returned to room temperature, then water was added, the product was extracted with CH₂Cl₂, an organic layer was collected, and dried over MgSO₄, and a solvent was removed by evaporation under reduced pressure. The obtained crude product was purified with silica gel column chromatography to thereby obtain Intermediate Compound **2a** of 24.7 g (yield: 78%). The mass of Intermediate Compound **2a** measured by FAB-MS was 925.

### Synthesis of Intermediate Compound 2b

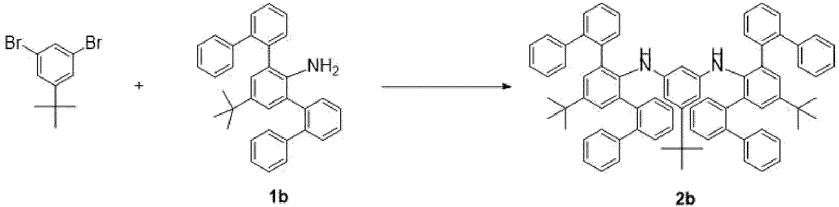

Intermediate Compound **2b** was synthesized in substantially the same manner as Intermediate Compound **2a** using Intermediate Compound **1b** (32.5 g) in place of Intermediate Compound **1a** (29.4 g, yield of 83 %). The mass of Intermediate Compound **2b** measured by FAB-MS was 1036.

### Synthesis of Intermediate Compound 2c

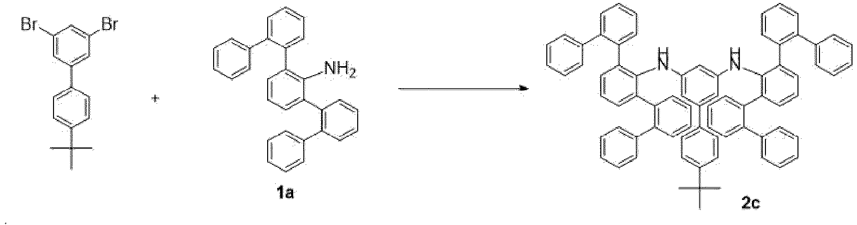

Intermediate Compound **2c** (30.1 g, yield of 88 %) was synthesized in substantially the same manner as Intermediate Compound **2a** using t-Bu-C₆H₄-4-(C₆H₃-3,5-Br₂)(12.3 g) and Intermediate Compound **1a** (28.6 g) in place of 1,3-dibromo-5-tert-butylbenzene and Intermediate Compound **1a.** The mass of Intermediate Compound **2c** measured by FAB-MS was 1001. The t-Bu-C₆H₄-4-(C₆H₃-3,5-Br₂) used in the synthesis was synthesized using the method described in the patent document (World Intellectual Property Organization, WO2013090185 A1 2013-06-20), the relevant part of which is incorporated herein by reference.

### Synthesis of Intermediate Compound 2d

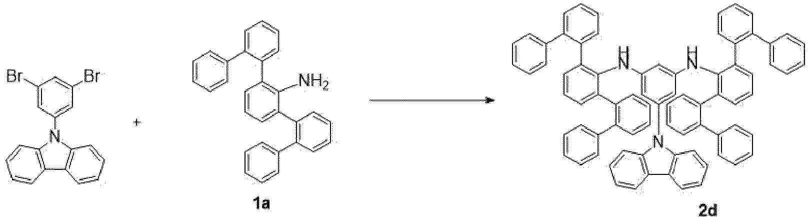

Intermediate Compound **2d** (25.5 g, yield of 72 %) was synthesized in substantially the same manner as Intermediate Compound **2a** using 9-(3,5-dibromophenyl)-9H-carbazole (13.3 g) in place of 1,3-dibromo-5-tert-butylbenzene. The mass of Intermediate Compound **2d** measured by FAB-MS was 1033.

### Synthesis of Intermediate Compound 2e

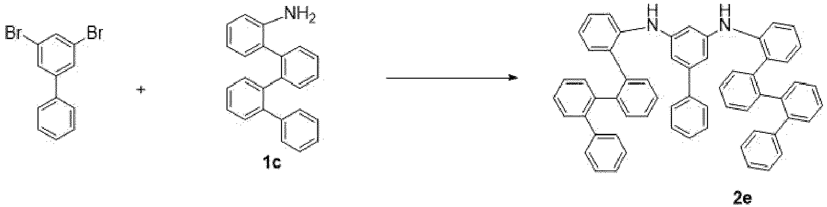

Intermediate Compound **2e** (23.9 g, yield of 91 %) was synthesized in substantially the same manner as Intermediate Compound **2a** using 3,5-dibromo-1,1'-biphenyl (10.3 g) and Intermediate Compound **1c** (22.3 g) in place of 1,3-dibromo-5-tert-butylbenzene and Intermediate Compound **1a.** The mass of Intermediate Compound **2e** measured by FAB-MS was 792.

### (3) Synthesis of Intermediate Compounds 3a to 3g

### Synthesis of Intermediate Compound 3a

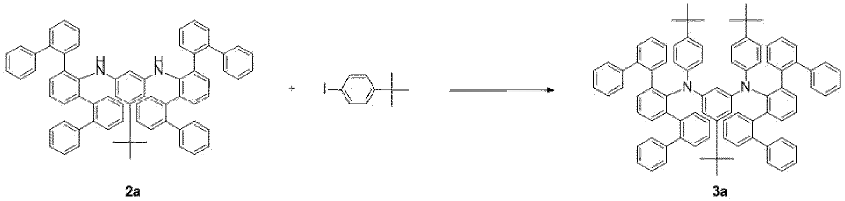

Under Ar atmosphere, Intermediate Compound **2a** (22.6 g), I-C₆H₄-4-tBu (86.3 g), CuI (14.1 g), and K₂CO₃ (20.3 g) were put in a 1000 mL three-neck flask, and the mixture was heated at 190 °C and stirred for 96 hours. The temperature was then returned to room temperature, then water was added, the product was extracted with CH₂Cl₂, an organic layer was collected, and dried over MgSO₄, and a solvent was removed by evaporation under reduced pressure. The obtained crude product was purified with silica gel column chromatography to thereby obtain Intermediate Compound **3a** of 15.9 g (yield: 55%). The mass of Intermediate Compound **3a** measured by FAB-MS was 1189.

### Synthesis of Intermediate Compound 3b

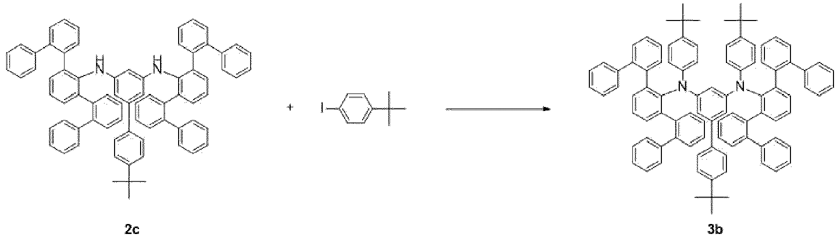

Intermediate Compound **3b** (18.4 g, yield of 59 %) was synthesized in substantially the same manner as Intermediate Compound **3a** using Intermediate Compound **2c** (24.5 g) in place of Intermediate Compound **2a.** The mass of Intermediate Compound **3b** measured by FAB-MS was 1265.

### Synthesis of Intermediate Compound 3c

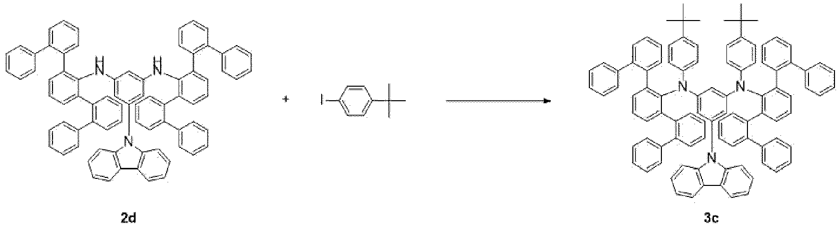

Intermediate Compound **3c** (20.1 g, yield of 65 %) was synthesized in substantially the same manner as Intermediate Compound **3a** using Intermediate Compound **2d** (25.3 g) in place of Intermediate Compound **2a.** The mass of Intermediate Compound **3c** measured by FAB-MS was 1298.

### Synthesis of Intermediate Compound 3d

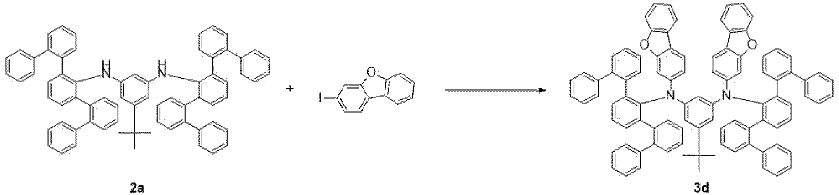

Intermediate Compound **3d** (17.1 g, yield of 56 %) was synthesized in substantially the same manner as Intermediate Compound **3a** using 3-!ododibenzofuran (86.3 g) in place of I-C₆H₄-4-tBu. The mass of Intermediate Compound **3d** measured by FAB-MS was 1257.

### Synthesis of Intermediate Compound 3e

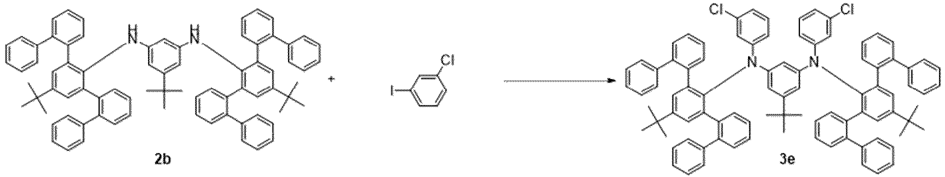

Intermediate Compound **3e** (17.9 g, yield of 58 %) was synthesized in substantially the same manner as Intermediate Compound **3a** using Intermediate Compound **2b** (25.4 g) and 1-Chloro-3-iodobenzene (70.2 g) in place of Intermediate Compound **2a** and I-C₆H₄-4-tBu. The mass of Intermediate Compound **3e** measured by FAB-MS was 1265.

### Synthesis of Intermediate Compound 3f

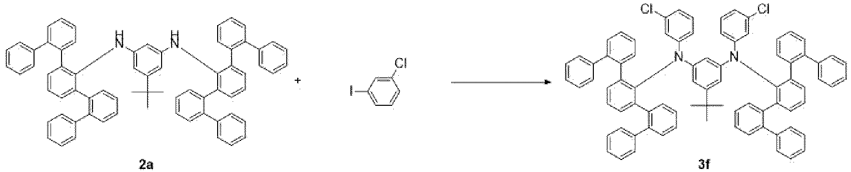

Intermediate Compound **3f** (16.8 g, yield of 60 %) was synthesized in substantially the same manner as Intermediate Compound **3a** using 1-chloro-3-iodobenzene (70.2 g) in place of I-C₆H₄-4-tBu. The mass of Intermediate Compound **3f** measured by FAB-MS was 1144.

### Synthesis of Intermediate Compound 3g

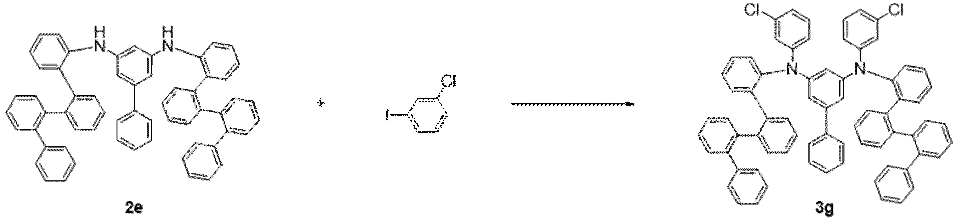

Intermediate Compound **3g** (17.2 g, yield of 69 %) was synthesized in substantially the same manner as Intermediate Compound **3a** using Intermediate Compound **2e** (19.4 g) and 1-chloro-3-iodobenzene (70.2 g) in place of Intermediate Compound **2a** and I-C₆H₄-4-tBu. The mass of Intermediate Compound **3g** measured by FAB-MS was 1020.

### (4) Synthesis of Compounds 3, 4, 15, 22, and Intermediate Compounds 28-1, 29-1, 54-1

### Synthesis of Compound 3

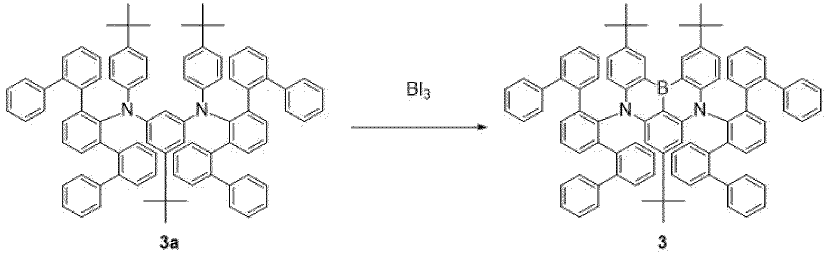

Under Ar atmosphere, Intermediate Compound **3a** (15.9 g) was put in a 1000 mL three-neck flask and dissolved in o-dichlorobenzene (70 mL), the mixture was cooled to 0 °C in an ice bath, boron triiodide (15.7 g) was put thereto, and then the mixture was heated at 180 °C and stirred for 18 hours. The mixture was then cooled to 0 °C in an ice bath, and triethylamine (100 mL) was added. The temperature was returned to room temperature, then water was added, the reaction solution was filtered through silica gel, and the filtrate solvent was removed by evaporation under reduced pressure. The obtained crude product was purified with silica gel column chromatography, preparative HPLC (eluent: CHCl₃), and recrystallization in toluene to thereby obtain Intermediate Compound **3** of 2.4 g (yield: 15%). The mass of Intermediate Compound **3** measured by FAB-MS was 1197.

### Synthesis of Compound 4

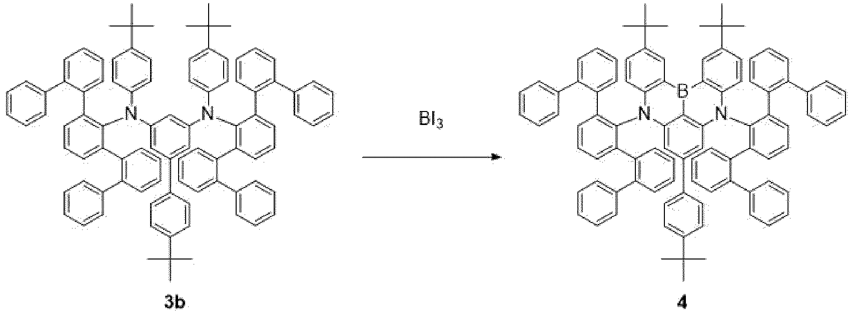

Compound **4** (3.6 g, yield of 21 %) was synthesized in substantially the same manner as Compound **3** using Intermediate Compound **3b** (16.9 g) in place of Intermediate Compound **3a.** The mass of Compound **4** measured by FAB-MS was 1273.

### Synthesis of Compound 15

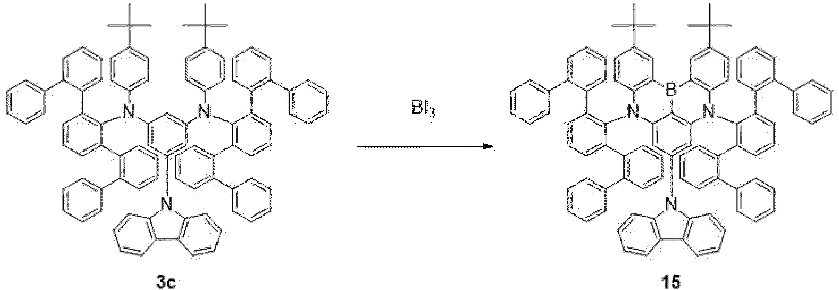

Compound **15** (6.8 g, yield of 39 %) was synthesized in substantially the same manner as Compound **3** using Intermediate Compound **3c** (17.4 g) in place of Intermediate Compound **3a.** The mass of Compound **15** measured by FAB-MS was 1307.

### Synthesis of Compound 22

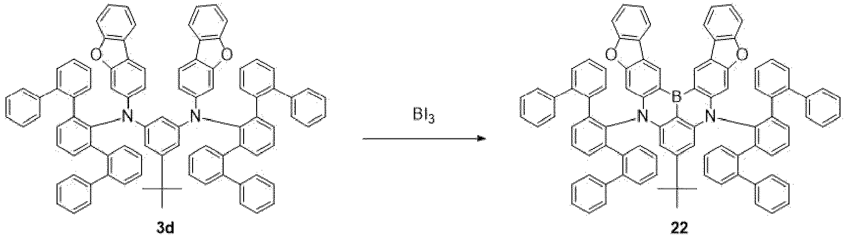

Compound **22** (2.4 g, yield of 14 %) was synthesized in substantially the same manner as Compound **3** using Intermediate Compound **3d** (16.8 g) in place of Intermediate Compound **3a.** The mass of Compound **22** measured by FAB-MS was 1265.

### Synthesis of Intermediate Compound 28-1

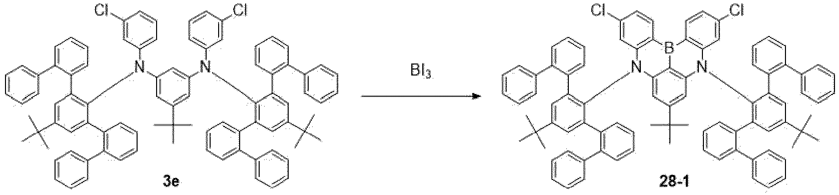

Intermediate Compound **28-1** (4.5 g, yield of 27 %) was synthesized in substantially the same manner as Compound 3 using Intermediate Compound **3e** (16.7 g) in place of Intermediate Compound **3a.** The mass of Intermediate Compound **28-1** measured by FAB-MS was 1265.

### Synthesis of Intermediate Compound 29-1

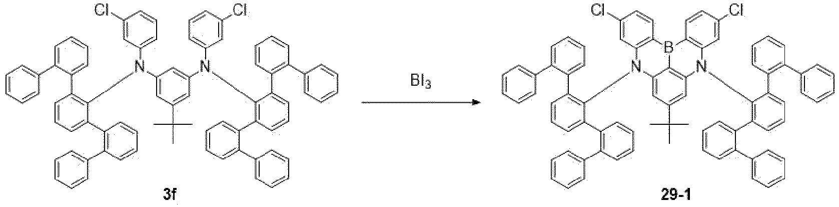

Intermediate Compound **29-1** (4.1 g, yield of 24 %) was synthesized in substantially the same manner as Compound **3** using Intermediate Compound **3f** (15.3 g) in place of Intermediate Compound **3a.** The mass of Intermediate Compound **29-1** measured by FAB-MS was 1178.

### Synthesis of Intermediate Compound 54-1

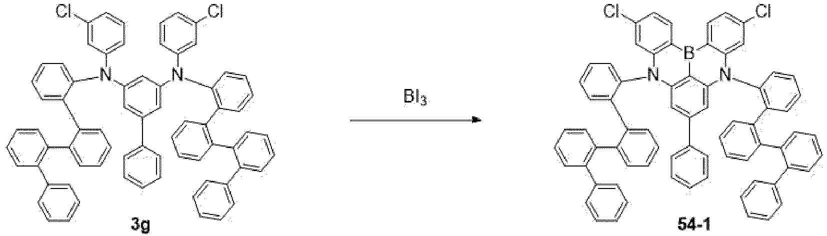

Intermediate Compound **54-1** (3.8 g, yield of 28 %) was synthesized in substantially the same manner as Compound 3 using Intermediate Compound **3g** (13.6 g) in place of Intermediate Compound **3a.** The mass of Intermediate Compound **54-1** measured by FAB-MS was 1020.

### (5) Synthesis of Compounds 28, 29, and 54

### Synthesis of Compound 28

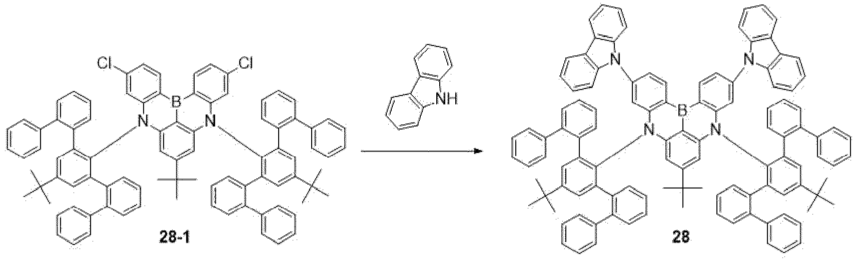

Under Ar atmosphere, intermediate compound 28-1 (4.5 g), carbazole (28.6 g), Pd(dba)2 (0.2 g), Tri-tert-butylphosphonium Tetrafluoroborate ([P(tBu)₃H]BF₄, 0.2 g), and NaOtBu (1.7 g) were added to a 500 mL three-necked flask, dissolved in toluene (20 mL), and heated and refluxed for 24 hours. After returning to room temperature, water was added, and the product was extracted with CH₂Cl₂, the organic layer was collected, and dried over MgSO₄, and the solvent was removed by evaporation under reduced pressure. The obtained crude product was purified by silica gel column chromatography to obtain 1.8 g (yield 33%) of compound 28. The mass number of compound 28 measured by FAB-MS was 1527.

### Synthesis of Compound 29

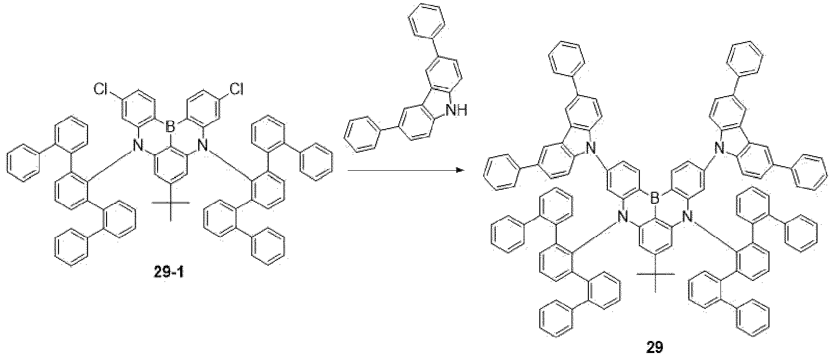

Compound **29** (2.3 g, yield of 38 %) was synthesized in substantially the same manner as Compound **28** using Intermediate Compound **29-1** (4.1 g) and 3,6-diphenylcarbazole (2.5 g) in place of Intermediate Compound **28-1** and carbazole. The mass of Compound **29** measured by FAB-MS was 1719.

### Synthesis of Compound 54

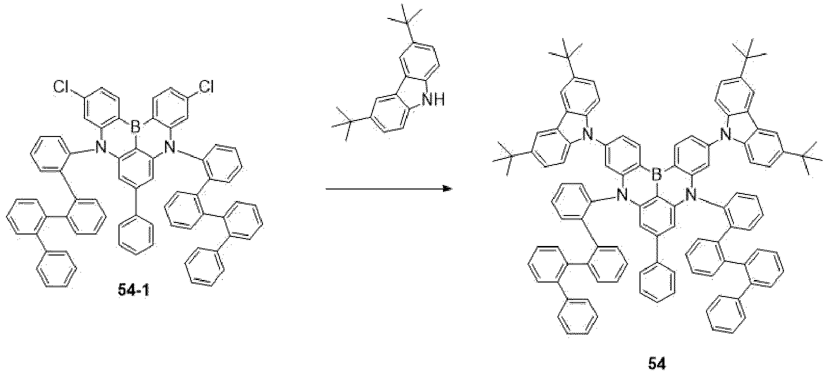

Compound **54** (4.5 g, yield of 27 %) was synthesized in substantially the same manner as Compound **28** using Intermediate Compound **54-1** (3.6 g) and 3,6-di-tert-butylcarbazole (2.2 g) in place of Intermediate Compound **28-1** and carbazole. The mass of Compound **54** measured by FAB-MS was 1507.

### 2. Manufacture and Evaluation of Light Emitting Element

Light-emitting elements according to one or more embodiments including the fused polycyclic compounds according to one or more embodiments in an emission layer were manufactured using a method described herein. Light-emitting elements according to Examples 1 to 7 were manufactured using Fused Polycyclic Compounds **3, 4, 15, 22, 28, 29,** and **54,** which were Example Compounds described previously, respectively, as a dopant material in the emission layer. Light-emitting elements according to Comparative Example 1 to Comparative Example 9 corresponded to light emitting elements manufactured by using Comparative Example Compounds X1 to X9, respectively, as a dopant material in the emission layer.

### Example Compounds

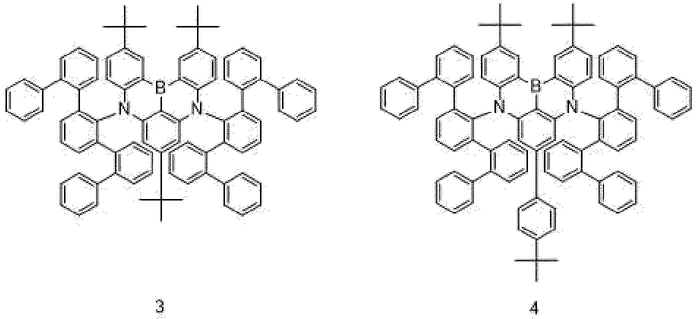

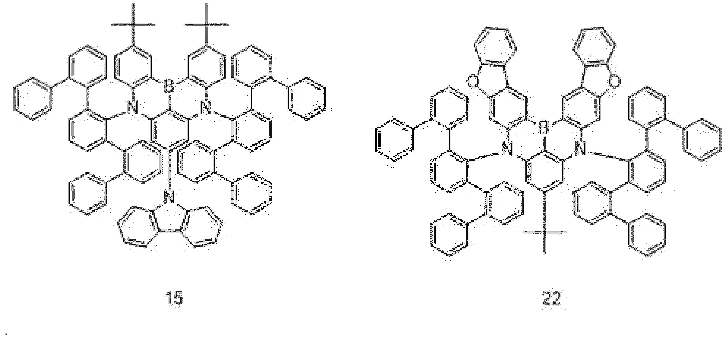

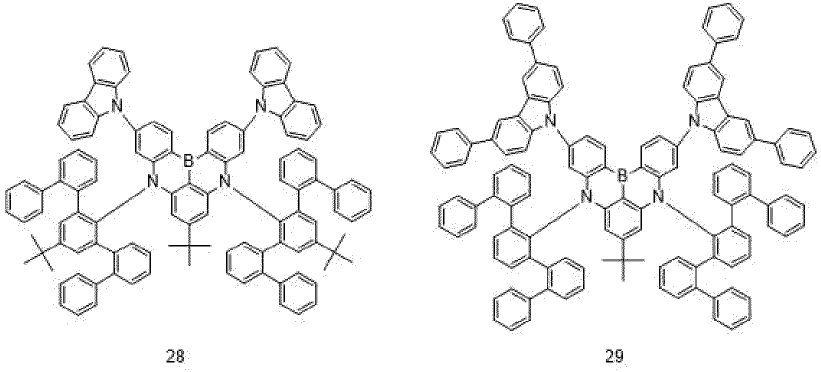

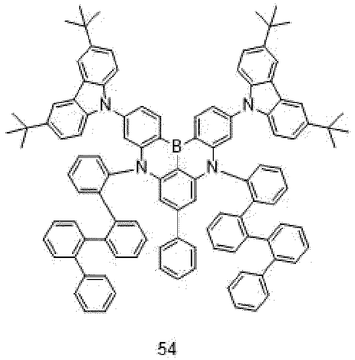

### Comparative Example Compounds

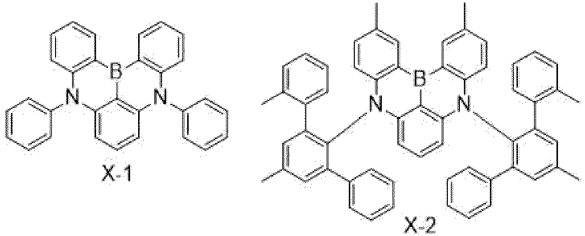

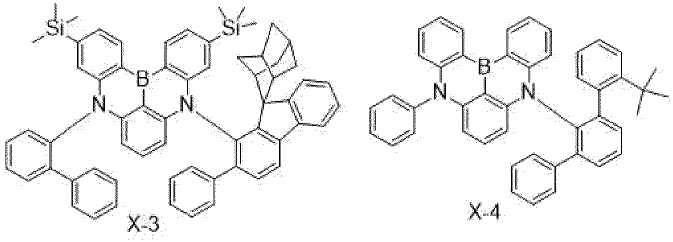

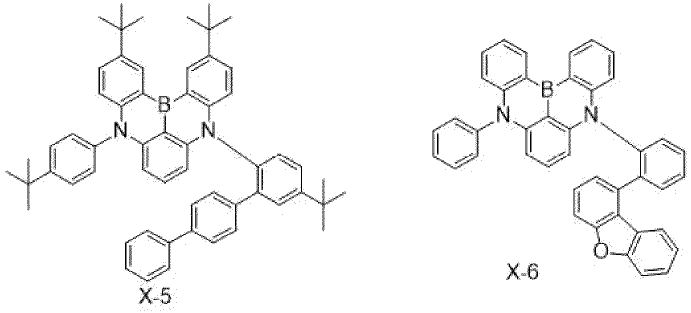

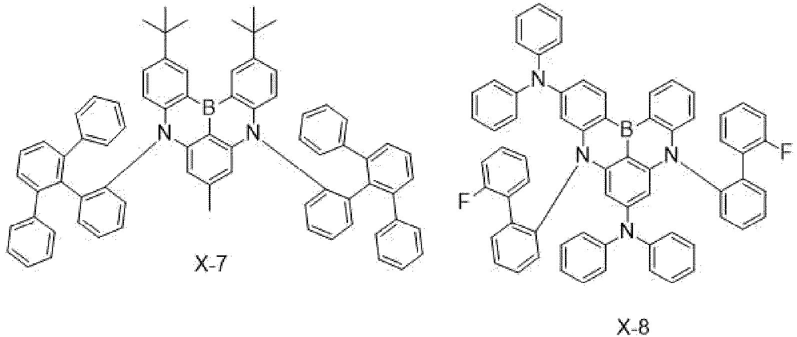

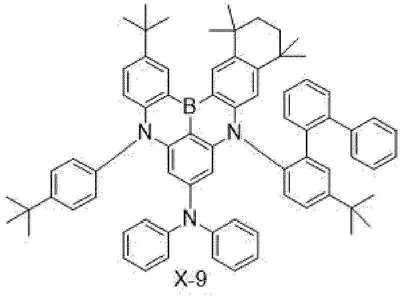

### Manufacture of Light Emitting Element

A first electrode having a thickness of 150 nm was formed using ITO, a hole injection layer having a thickness of 10 nm was formed on the first electrode using dipyrazino[2,3-f: 2',3'-h] quinoxaline-2,3,6,7,10,11-hexacarbonitrile (HATCN), a hole transport layer having a thickness of 80 nm was formed on the hole injection layer using 2,2'-dimethyl-N,N'-di-[(1-naphthyl)-N,N'-diphenyl]-1,1'-biphenyl-4,4'-diamine (α-NPD), an emission auxiliary layer having a thickness of 5 nm was formed on the hole transport layer using 1,3-bis(N-carbazolyl)benzene (mCP), an emission layer having a thickness of 20 nm in which 3,3'-di(9H-carbazol-9-yl)-1,1'-biphenyl (mCBP) were doped with example compounds or comparative example compounds on the emission auxiliary layer, an electron transport layer having a thickness of 30 nm was formed on the emission layer using 2,2',2"-(1,3,5-benzinetriyl)-tris(1-phenyl-1-H-benzimidazole) (TPBi), an electron injection layer having a thickness of 0.5 nm was formed on the electron transport layer using LiF, and a second electrode having a thickness of 100 nm was formed using aluminum (Al) on the electron injection layer. Each layer was formed under a vacuum atmosphere by a vapor deposition method.

Compounds used for manufacturing the light-emitting elements according to Examples and Comparative Examples were disclosed herein. The materials used were suitable materials and were used in the manufacture of elements by purifying commercial products by sublimation.

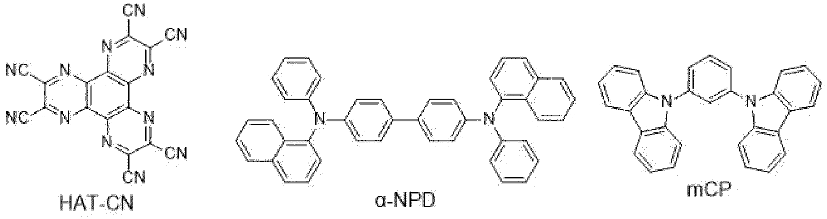

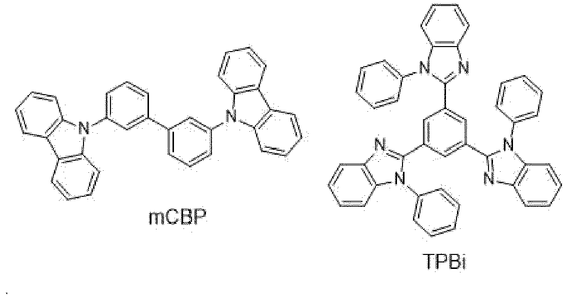

### Evaluation of Characteristics of Light Emitting Element

The luminous efficiency and element lifespan of each of light emitting elements, which were manufactured by using Example Compounds 3, 4, 15, 22, 28, 29, and 54 and Comparative Example Compounds X-1 to X-9 described previously, were evaluated. The evaluation results of the light emitting elements according to Example 1 to Example 7, and Comparative Example 1 to Comparative Example 9 are listed in Table 1. In Table 1, relative external luminous efficiency, and lifespan (LT50) on each of the manufactured light emitting elements are shown. In the evaluation results, in Table 1, of characteristics of the light emitting elements according to Examples and Comparative Examples, the relative external luminous efficiency was an external quantum efficiency evaluated at 800 cd/m² and was a relative value with respect to the value of Comparative Example 1. In addition, luminance half-decay time in hours was evaluated at an initial luminance of 800 cd/m² and the value was listed as the LT₅₀ lifespan.

**Table 1**

| Element Manufacture Example | Dopant | Relative external luminous efficiency EQE₈₀₀ₙᵢₜ | LT₅₀ Lifespan (h) |
|---|---|---|---|
| Example 1 | Compound 3 | 1.7 | 3.2 |
| Example 2 | Compound 4 | 2.1 | 4.5 |
| Example 3 | Compound 15 | 2.5 | 2.1 |
| Example 4 | Compound 22 | 2.7 | 4.1 |
| Example 5 | Compound 28 | 2.4 | 3.3 |
| Example 6 | Compound 29 | 2.6 | 3.6 |
| Example 7 | Compound 54 | 3.1 | 4.1 |
| Comparative Example 1 | Comparative Example Compound X-1 | 1.0 | 0.5 |
| Comparative Example 2 | Comparative Example Compound X-2 | 1.5 | 1.7 |
| Comparative Example 3 | Comparative Example Compound X-3 | 1.6 | 1.2 |
| Comparative Example 4 | Comparative Example Compound X-4 | 1.3 | 1.2 |
| Comparative Example 5 | Comparative Example Compound X-5 | 0.7 | 1.6 |
| Comparative Example 6 | Comparative Example Compound X-6 | 1.5 | 1.9 |
| Comparative Example 7 | Comparative Example Compound X-7 | 1.3 | 0.7 |
| Comparative Example 8 | Comparative Example Compound X-8 | 1.2 | 0.1 |
| Comparative Example 9 | Comparative Example Compound X-9 | 1.1 | 0.6 |

Referring to the results in Table 1, it can be confirmed that, the light emitting elements according to Examples, which use the fused polycyclic compounds according to one or more embodiments as emission materials, each have improved the luminous efficiency and lifespan compared to the light emitting elements according to Comparative Examples.

In embodiments of Example Compounds, a nitrogen atom constituting a fused ring includes a first substituent, and thus may effectively protect a boron atom. Therefore, high efficiency and long lifespan may be achieved.

Each of Example Compounds includes the first substituent connecting to the nitrogen atom of the fused ring core in which a boron atom is at the center. The first substituent includes 2-biphenyl moiety and a second substituent connecting to a second carbon of the 2-biphenyl moiety. The fused polycyclic compound according to one or more embodiments includes the first substituent connecting to the nitrogen atom of the fused ring core, and a trigonal planar structure of the boron atom may be effectively maintained through steric hindrance effect caused by the first substituent having a high steric bulkiness. Because the boron atom has electron-deficiency characteristics due to an unoccupied p-orbital, a structure thereof may change into a tetrahedral structure by forming a bond with other nucleophiles if without a suitable protection, which may cause device deterioration. According to the present disclosure, because in the fused polycyclic compound according to one or more embodiments, the first substituent is introduced to the fused ring core, the unoccupied p-orbital of the boron atom may be effectively protected, and thus the deterioration phenomenon due to structural deformation may be prevented or reduced. In Example Compounds, an intermolecular distance between adjacent molecules increases due to a structure having high steric hindrance, which may inhibit or reduce Dexter energy transfer. Therefore, deterioration of the lifespan due to an increase in a triplet concentration may be prevented or reduced. The light emitting element according to one or more embodiments includes the fused polycyclic compound according to one or more embodiments as an emission dopant of a thermally activated delayed fluorescence (TADF) light emitting element, and thus high element efficiency may be achieved in a blue light wavelength region, especially in the deep blue light wavelength region.

The light emitting element according to Comparative Example 1 shows a result that an element lifespan and efficiency are reduced compared to the light emitting elements according to Examples. Comparative Example Compound X-1 contained in the light emitting element according to Comparative Example 1 includes a fused ring structure in which one boron atom and two nitrogen atoms are at the center, but does not include the first substituent suggested in the present disclosure, thus the effect in that the boron atom is sterically protected within the plate-like structure of the fused ring core is reduced, and it is difficult to expect an intermolecular interaction effect and/or the like. Therefore, when Comparative Example Compound X-1 is applied to a light emitting element, it can be confirmed that the light emitting element has low luminous efficiency and lifespan compared to embodiments using Example Compounds.

Comparative Example Compounds X-2 and X-4 contained in the light emitting elements according to Comparative Example 2 and Comparative Example 4, respectively, each include a similar structure to the first substituent that is used in the compounds of the present disclosure, but it can be seen that when these comparative compound is applied to a respective of the light emitting elements, the light emitting element may not have improvements in luminous efficiency and element lifespan at a remarkable level because a substituent substituted at the position of the second substituent, that is a Z position in Formula 1 is an alkyl group having a small steric bulkiness.

In Comparative Example Compounds X-3 and X-9 contained in the light emitting elements according to Comparative Example 3 and Comparative Example 9, respectively, an additional ring is formed in a molecular structure, on the other hand, the additional ring contains *sp³* hybridized carbons, which are consecutively arranged, and thus a quaternary carbon structure that may be likely to deteriorate. Therefore, it can be confirmed that when these comparative compounds are applied to the light emitting elements, the light emitting elements each have relatively low luminous efficiency and element lifespan.

Comparative Example Compound X-8 contained in the light emitting element according to Comparative Example 8, includes a similar structure to the first substituent that is applied to the compound according to the present disclosure, but it can be confirmed that a substituent substituted at a position of the second substituent, that is, a Z position in Formula 1, is a fluorine atom that is a halogen atom and is an electron-affinity substituent, which causes the emission material to be decomposed by electron trapping, and thus the element lifespan is significantly reduced.

Comparative Example Compounds X-5 and X-7 contained, respectively, in the light emitting elements according to Comparative Examples 5 and 7, respectively, each include a similar structure to the first substituent that is applied to the compound of the disclosure, but include a phenyl substituent at another position instead of the position of the second substituent, that is, a Z position in Formula 1, it can be confirmed that when these comparative compounds are applied to the light emitting elements, improvements in luminous efficiency and element lifespan are not at a remarkable level, compared to Example Compounds.

Comparative Example Compound X-6 contained in the light emitting element according to Comparative Example 6, includes a dibenzofuran group bonded at an ortho position to a substituent corresponding to the first substituent that is applied to the compound according to the disclosure, thus has a partially similar structure, but, compared to Example Compounds, the bulkiness of the molecular structure decreases due to a fused structure of the dibenzofuran group. Therefore, it can be confirmed that when the Comparative Example Compound X-6 is applied to the light emitting element, the luminous efficiency and element lifespan are relatively lower than Example Compounds.

The light emitting element according to one or more embodiments may exhibit improved element characteristics of high efficiency and long lifespan.

The fused polycyclic compound according to one or more embodiments may be contained in the emission layer of the light emitting element, and thus may contribute to improvements in high efficiency and long lifespan of the light emitting element.

The display device according to one or more embodiments may exhibit excellent or suitable display quality by including the light emitting element of present disclosure.

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

In the present disclosure, when particles (e.g., quantum dots) are spherical, "size" indicates a particle diameter or an average particle diameter, and when the particles are non-spherical, the "size" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The light-emitting element/device, the display device, the display apparatus, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Descriptions of features or aspects within each embodiment should typically be considered as available for other similar features or aspects in other embodiments.

Hitherto, although one or more embodiments of disclosure have been described, it is understood that disclosure should not be limited to these embodiments but one or more suitable changes and modifications can be made by one ordinary skilled in the art within the spirit and scope of disclosure as hereinafter claimed. Each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Therefore, the technical scope of the present disclosure is not intended to be limited to the contents set forth in the detailed description of the disclosure, but is intended to be defined by the appended claims.

## Claims

1. A fused polycyclic compound represented by Formula 1: 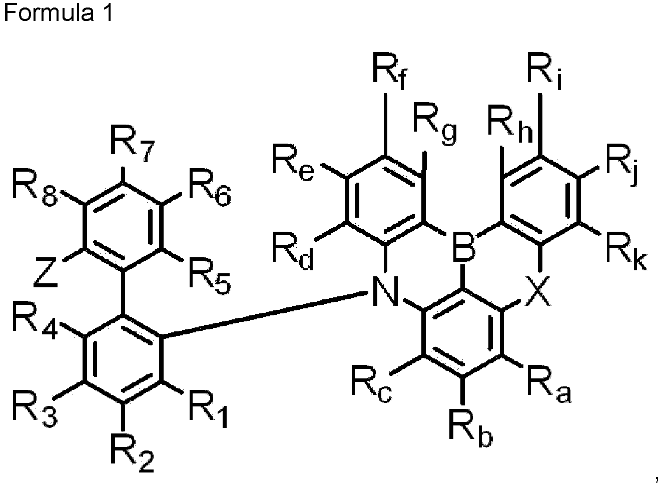 in Formula 1,
X being a direct linkage, O, S, Se, CR₃₁R₃₂, PR₃₃, SiR₃₄R₃₅, C=O, C=S, or NR₃₆,
Z being a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons,
R₁ to R₈, Rₐ to Rₖ, and R₃₁ to R₃₆ being each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons, and/or being bonded to an adjacent group to form a ring,
when any one selected from among R₁ to R₈, Rₐ to Rₖ, and R₃₁ to R₃₆ is bonded to an adjacent group to form a ring, then the formed ring does not comprise two consecutive *sp³* carbons that are bonded to each other, and
when Z is a substituted or unsubstituted aryl group, then R₅ is not a substituted or unsubstituted aryl group,
wherein the term "substituted" refers to the replacement of a hydrogen atom by a substituent selected from among the group consisting of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group, wherein each of the substituents may be substituted or unsubstituted.

2. The fused polycyclic compound of claim 1, wherein the fused polycyclic compound represented by Formula 1 is represented by any one selected from among Formula 2-1 to Formula 2-8: 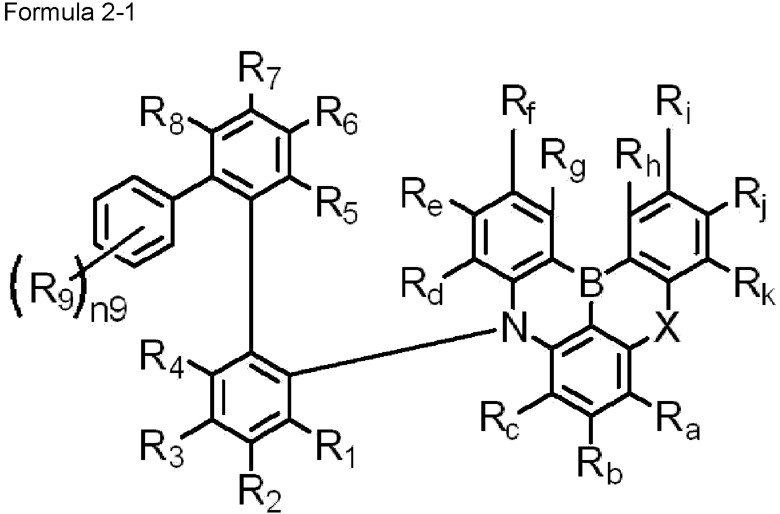 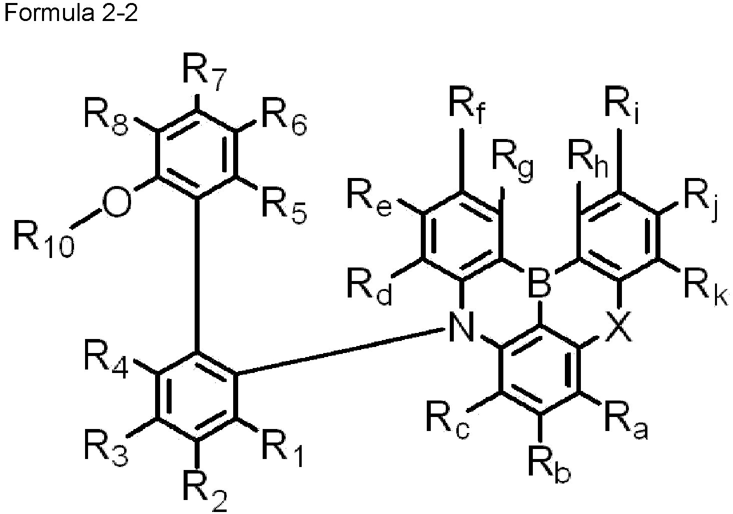 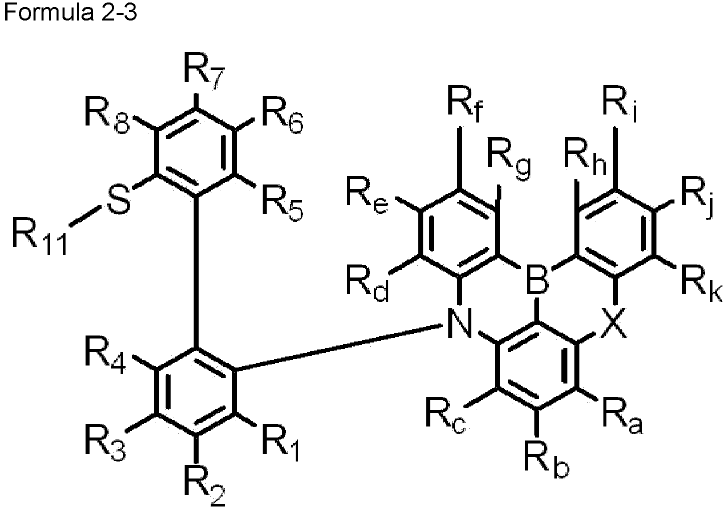 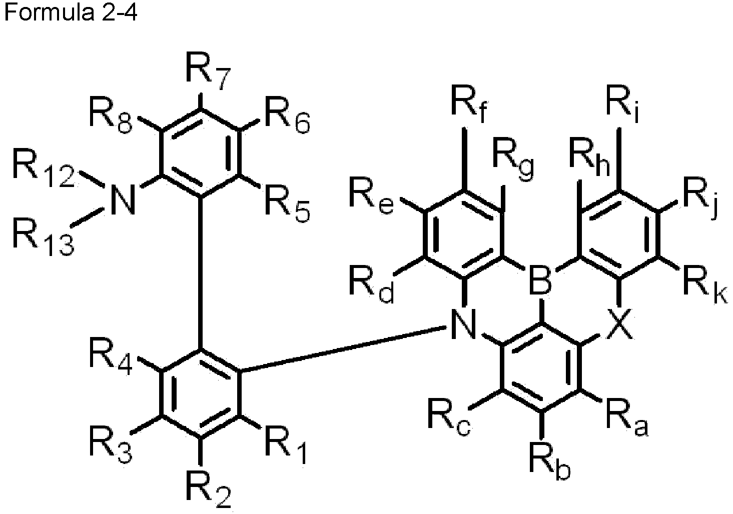 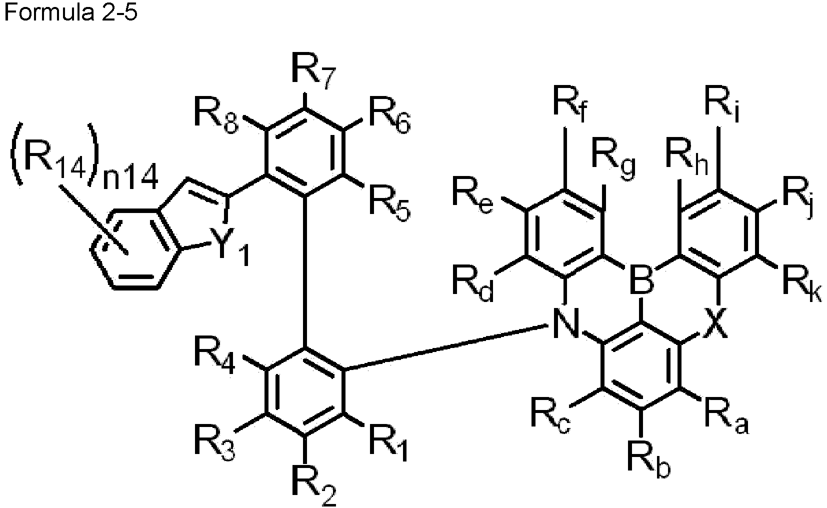 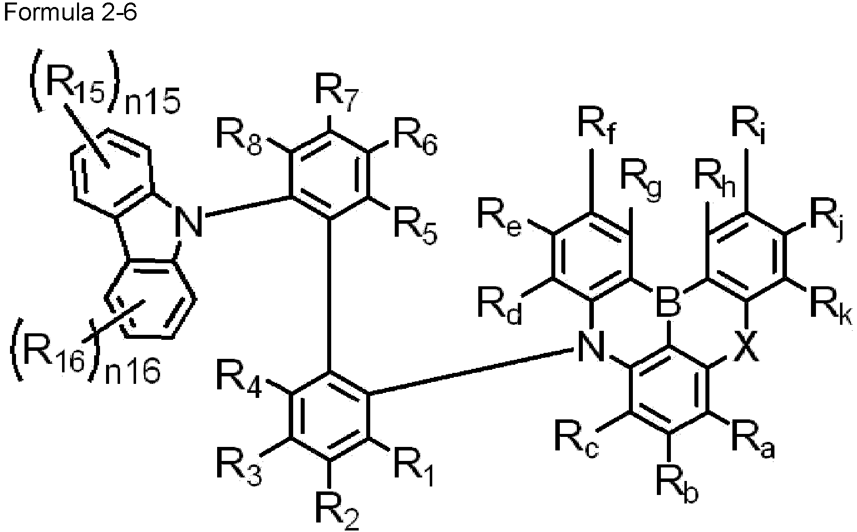 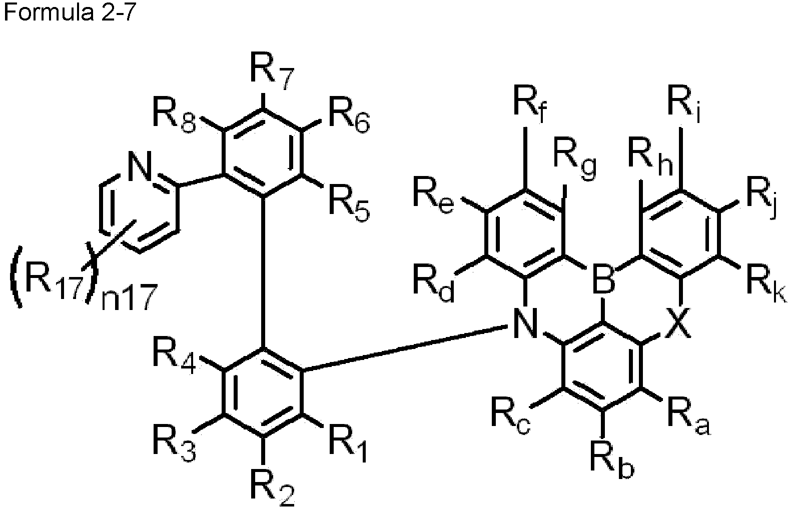 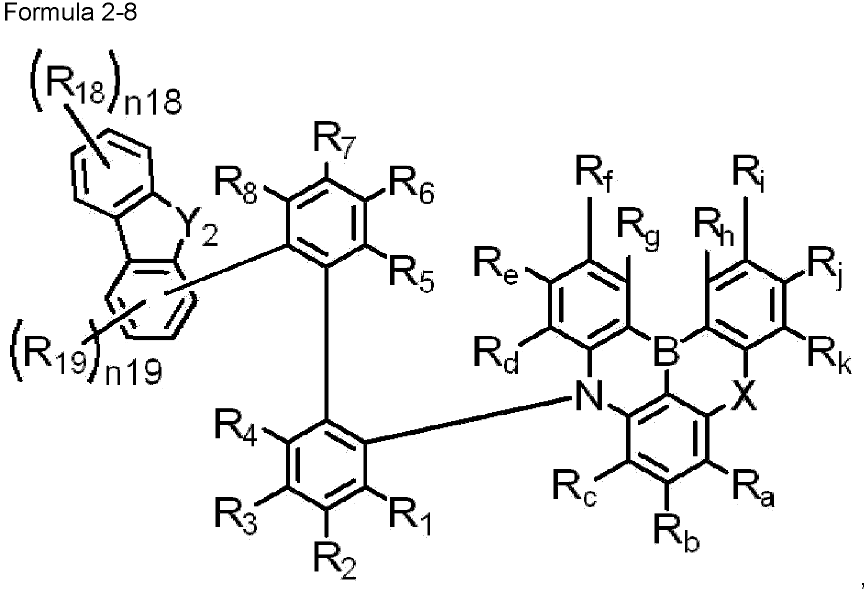 in Formula 2-1 to Formula 2-8,
R₉ to R₁₉ being each independently hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons,
Y₁ and Y₂ being each independently O or S,
n9 being an integer of 0 to 5,
n14 to n18 being each independently an integer of 0 to 4,
n19 is an integer of 0 to 3, and
X, R₁ to R₈, Rₐ to Rₖ, and R₃₁ to R₃₆ being the same as defined in Formula 1.

3. The fused polycyclic compound of claim 1, wherein the fused polycyclic compound represented by Formula 1 is represented by Formula 3-1 or Formula 3-2: 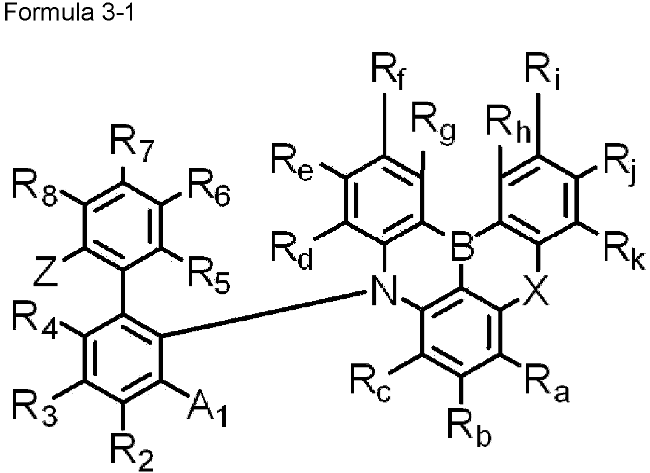 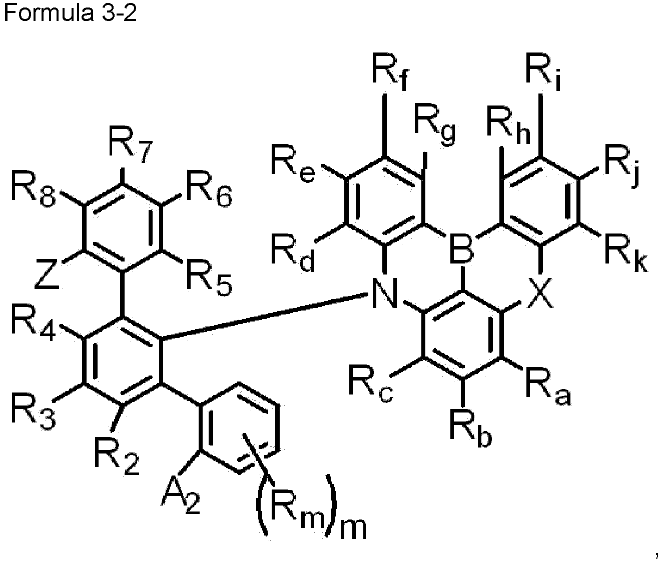 in Formula 3-1 and Formula 3-2,
A₁ being hydrogen, deuterium, a substituted or unsubstituted oxy group, or a substituted or unsubstituted amine group,
A₂ being hydrogen, deuterium, a substituted or unsubstituted oxy group, a substituted or unsubstituted thio group, a substituted or unsubstituted amine group, a substituted or unsubstituted aryl group having 6 to 30 ring-forming carbons, or substituted or unsubstituted heteroaryl group 2 to 30 ring-forming carbons,
Rₘ being hydrogen, deuterium, a halogen, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons,
m being an integer of 0 to 4, and
X, Z, R₂ to R₈, Rₐ to Rₖ, and R₃₁ to R₃₆ being the same as defined in Formula 1.

4. The fused polycyclic compound of claim 3, wherein, in Formula 3-2, Z and A₂ are the same.

5. The fused polycyclic compound of claim 1, wherein the fused polycyclic compound represented by Formula 1 is represented by any one selected from among Formula 4-1 to Formula 4-4: 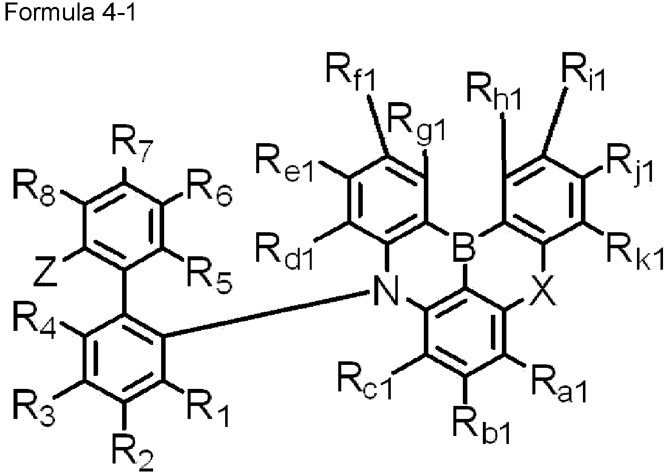 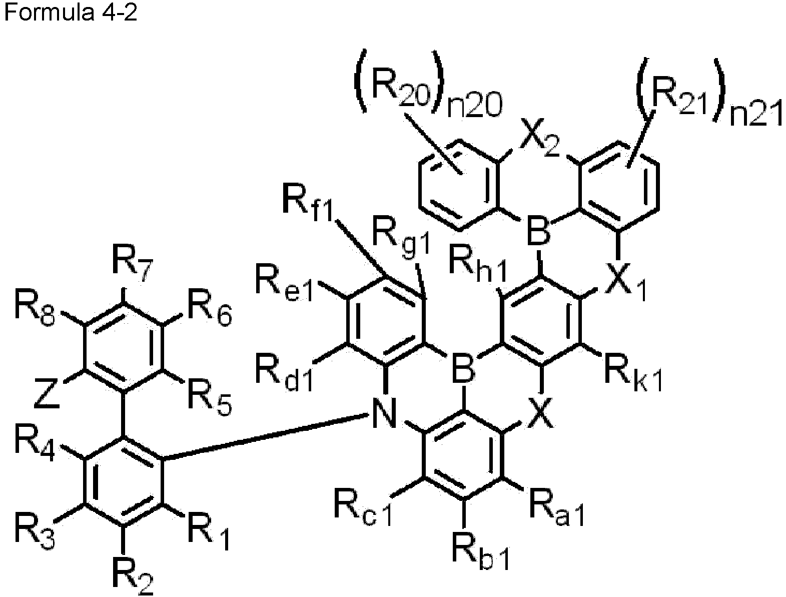 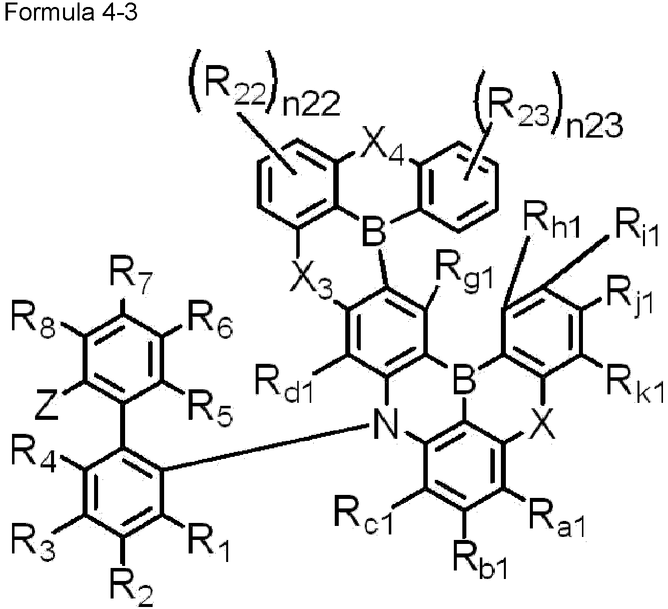 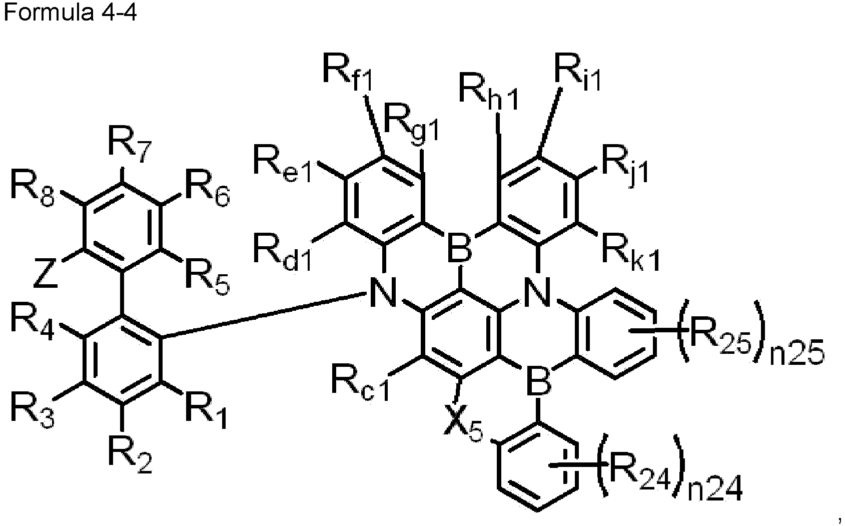 in Formula 4-1 to Formula 4-4,
X₁ to X₅ being each independently O, S, CR₂₆R₂₇, or NR₂₈,
Rₐ₁ to Rₖ₁, R₂₀ to R₂₈ being each independently hydrogen, deuterium, a halogen, a cyano group, a substituted or unsubstituted amine group, a substituted or unsubstituted oxy group, a substituted or unsubstituted thio group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and/or being bonded to an adjacent group to form a ring,
n20, and n23 to n25 being each independently an integer of 0 to 4,
n21 and n22 being each independently an integer of 0 to 3, and
X, Z, R₁ to R₈, and R₃₁ to R₃₆ being the same as defined in Formula 1.

6. The fused polycyclic compound of claim 1, wherein the fused polycyclic compound represented by Formula 1 is represented by Formula 5: 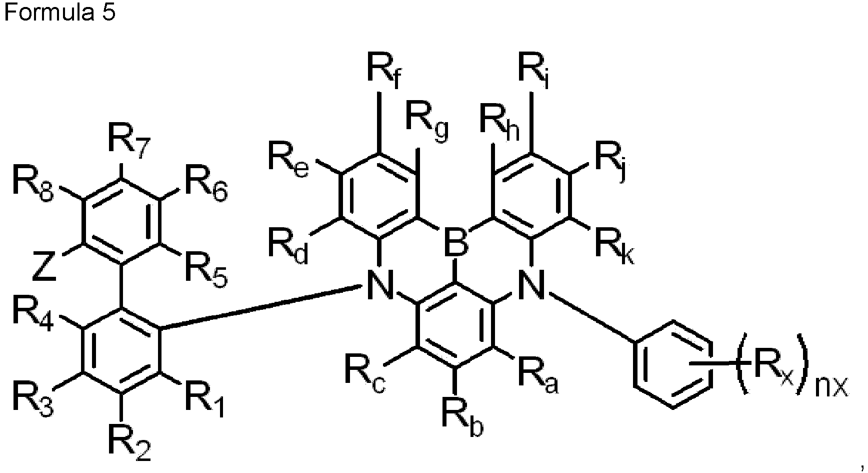 in Formula 5,
Rₓ being hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons, and/or being bonded to an adjacent group to form a ring,
nx being an integer of 0 to 5, and
Z, R₁ to R₈, and Rₐ to Rₖ being the same as defined in Formula 1.

7. The fused polycyclic compound of claim 1, wherein the fused polycyclic compound represented by Formula 1 is represented by Formula 6: 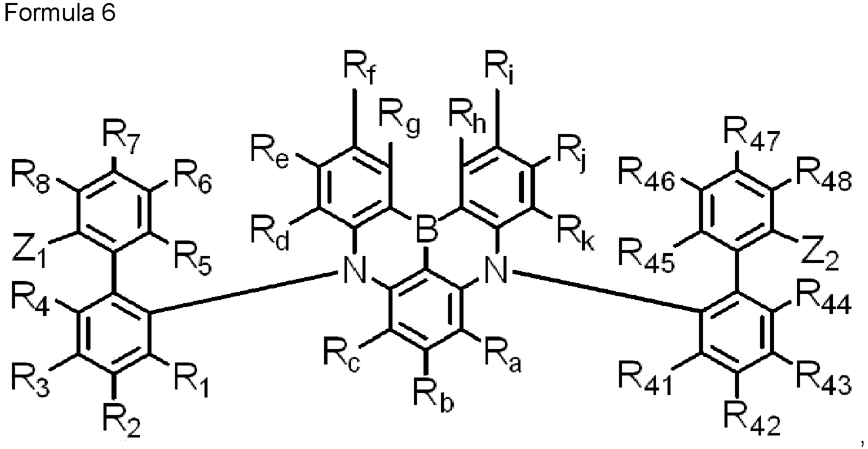 in Formula 6,
Z₁ and Z₂ being each independently a substituted or unsubstituted oxy group, a substituted or unsubstituted thio group, a substituted or unsubstituted amine group, a substituted or unsubstituted aryl group having 6 to 30 ring-forming carbons, or a substituted or unsubstituted heteroaryl group having 2 to 30 ring-forming carbons,
R₄₁ to R₄₈ being each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted carbonyl group, a substituted or unsubstituted alkyl group having 1 to 20 carbons, a substituted or unsubstituted alkenyl group having 2 to 20 carbons, a substituted or unsubstituted aryl group having 6 to 30 ring-forming carbons, or a substituted or unsubstituted heteroaryl group having 2 to 30 ring-forming carbons, and/or being bonded to an adjacent group to form a ring, and
R₁ to R₈ and Rₐ to Rₖ are the same as defined in Formula 1.

8. The fused polycyclic compound of claim 7, wherein, in Formula 6, R₁ and R₄₁ are each independently hydrogen, a substituted or unsubstituted phenyl group, a substituted or unsubstituted phenyloxy group, or a substituted or unsubstituted diphenylamine group.

9. The fused polycyclic compound of claim 1, wherein the fused polycyclic compound represented by Formula 1 is represented by any one selected from among Formula 7-1 to Formula 7-4: 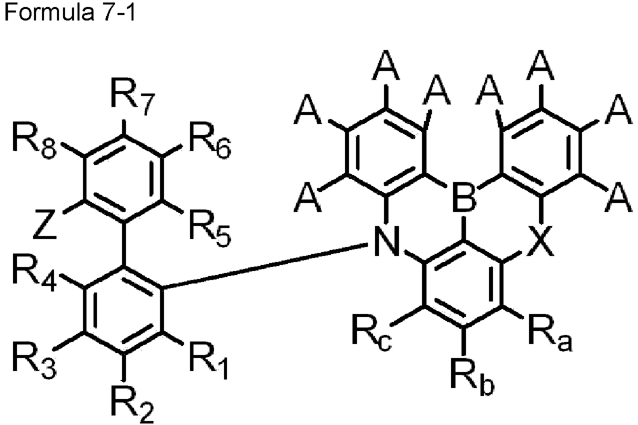 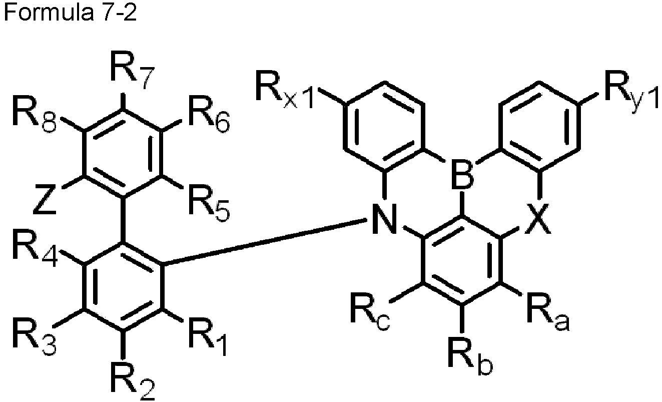 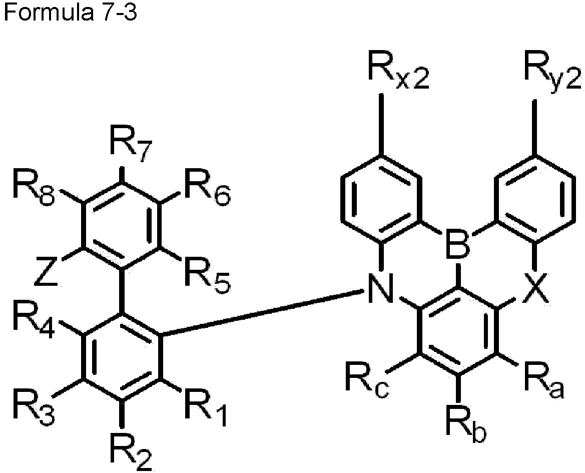 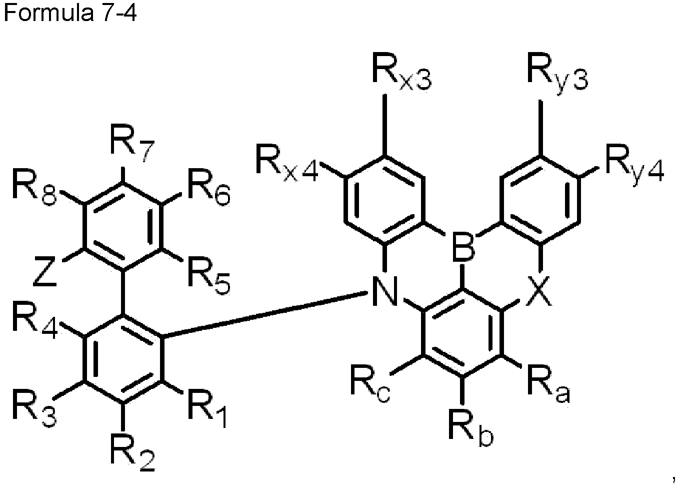 in Formula 7-1 to Formula 7-4,
A being hydrogen or deuterium,
Rₓ₁, Rₓ₂, R_{y1}, and R_{y2} being each independently deuterium, a halogen, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons,
Rₓ₃, Rₓ₄, R_{y3}, and R_{y4} being each independently deuterium, a halogen, a substituted or unsubstituted oxy group, a substituted or unsubstituted thio group, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and/or being bonded to an adjacent group to form a ring, and
X, Z, R₁ to R₈, Rₐ to R_{c}, and R₃₁ to R₃₆ being the same as defined in Formula 1.

10. The fused polycyclic compound of claim 1, wherein the fused polycyclic compound represented by Formula 1 is represented by Formula 8-1 or Formula 8-2: 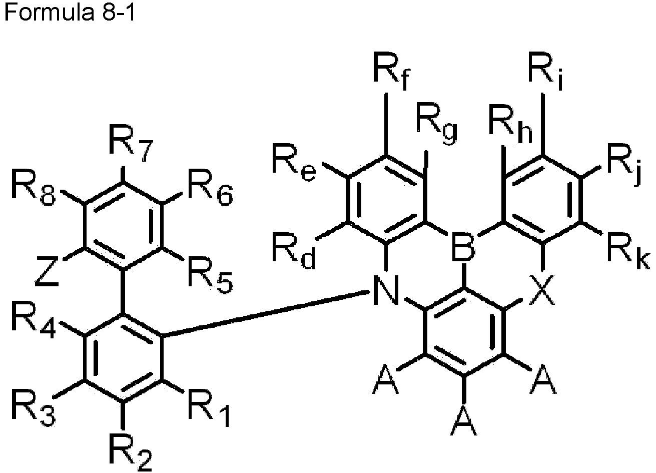 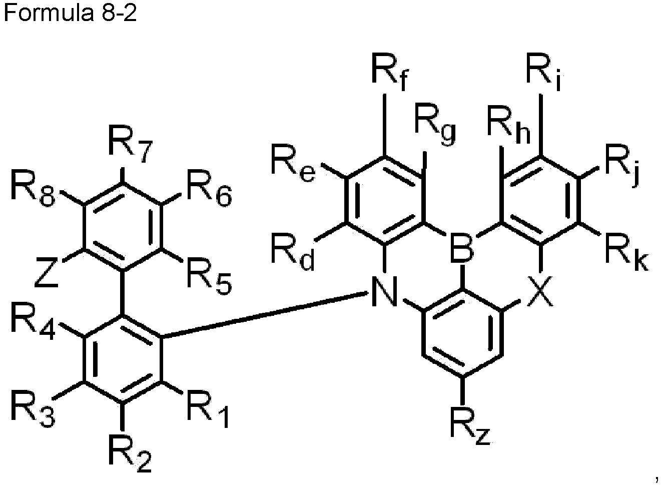 in Formula 8-1 and Formula 8-2,
A being hydrogen or deuterium,
R_{z} being deuterium, a halogen, a substituted or unsubstituted oxy group, a substituted or unsubstituted thio group, a substituted or unsubstituted amine group, a substituted or unsubstituted carbonyl group, a substituted or unsubstituted alkyl group having 1 to 20 carbons, a substituted or unsubstituted aryl group having 6 to 30 ring-forming carbons, or a substituted or unsubstituted heteroaryl group having 2 to 30 ring-forming carbons, and
X, Z, R₁ to R₈, R_{d} to Rₖ, and R₃₁ to R₃₆ being the same as defined in Formula 1.

11. The fused polycyclic compound of claim 1, wherein the fused polycyclic compound represented by Formula 1 is any one selected from among compounds in Compound Group 1:

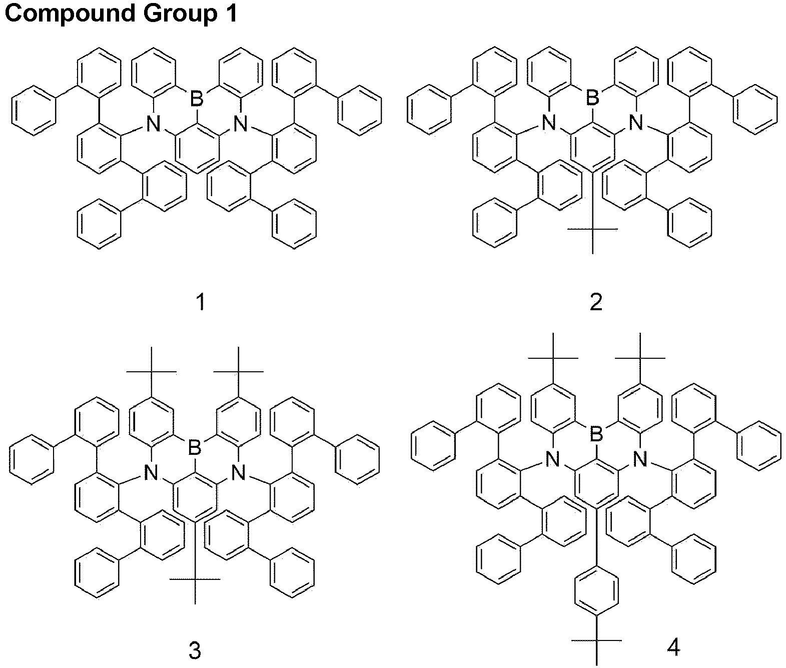

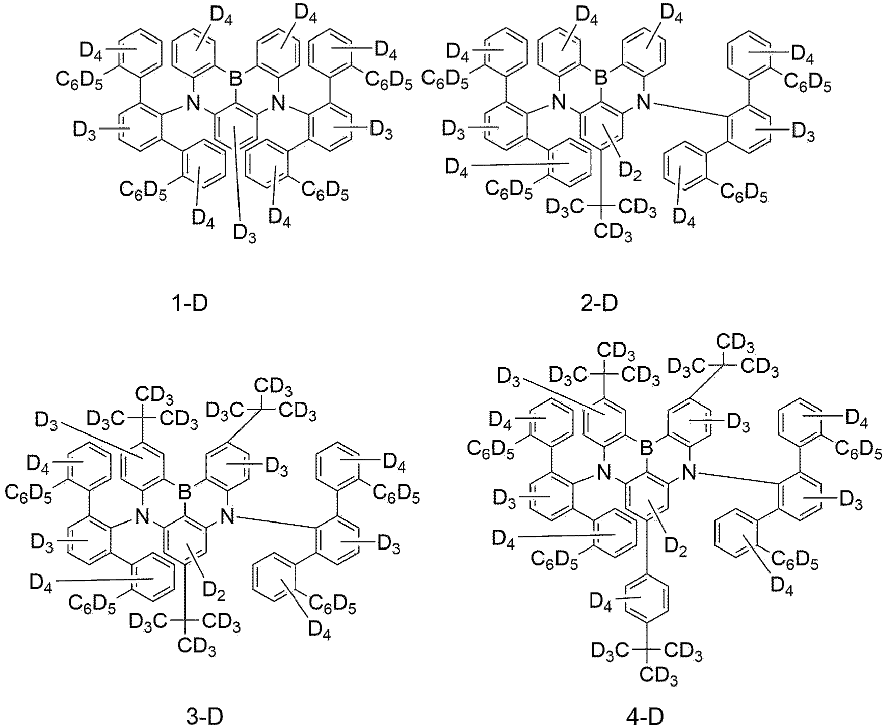

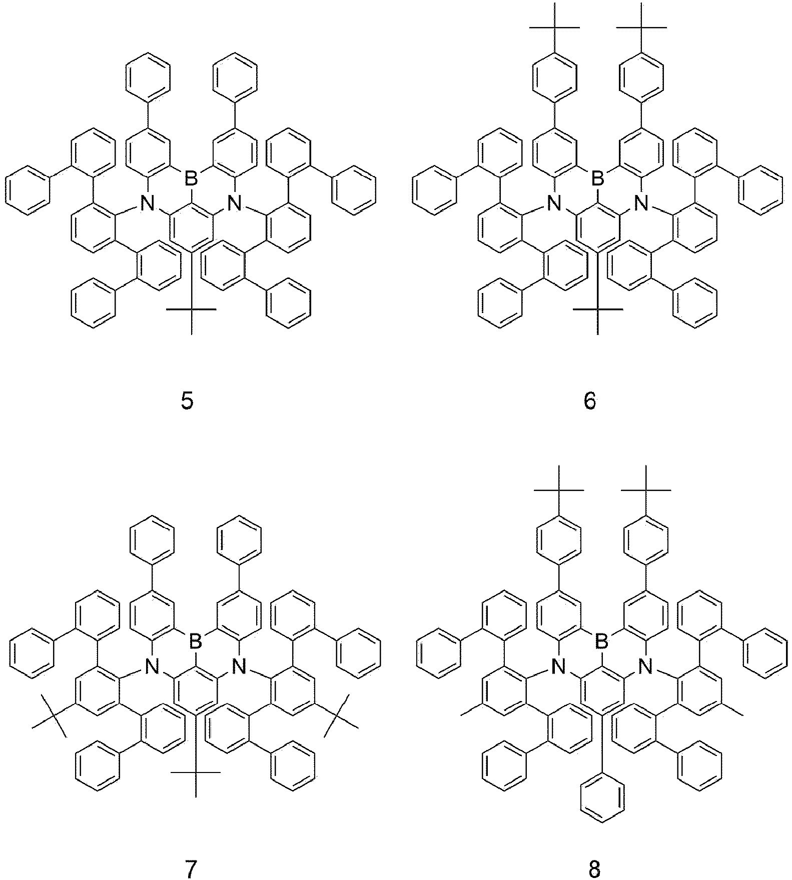

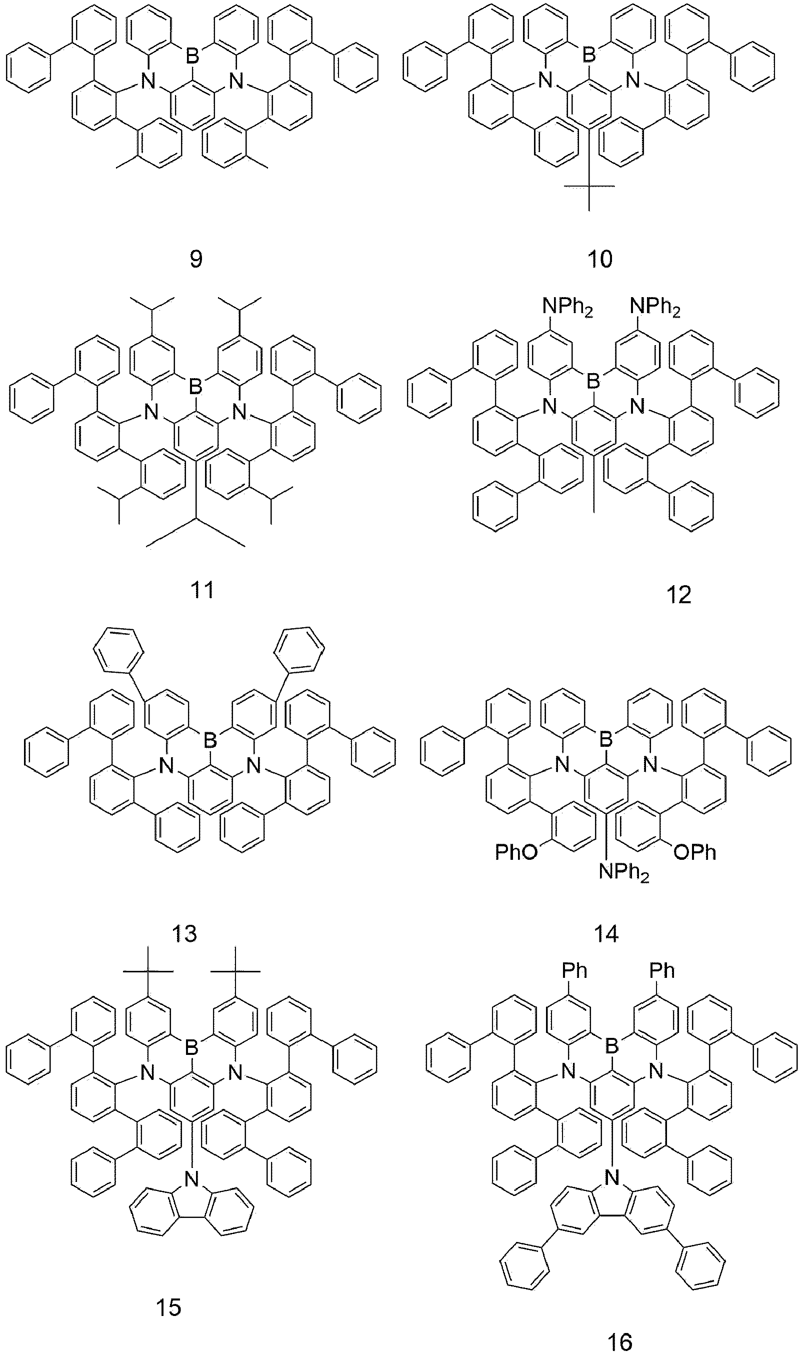

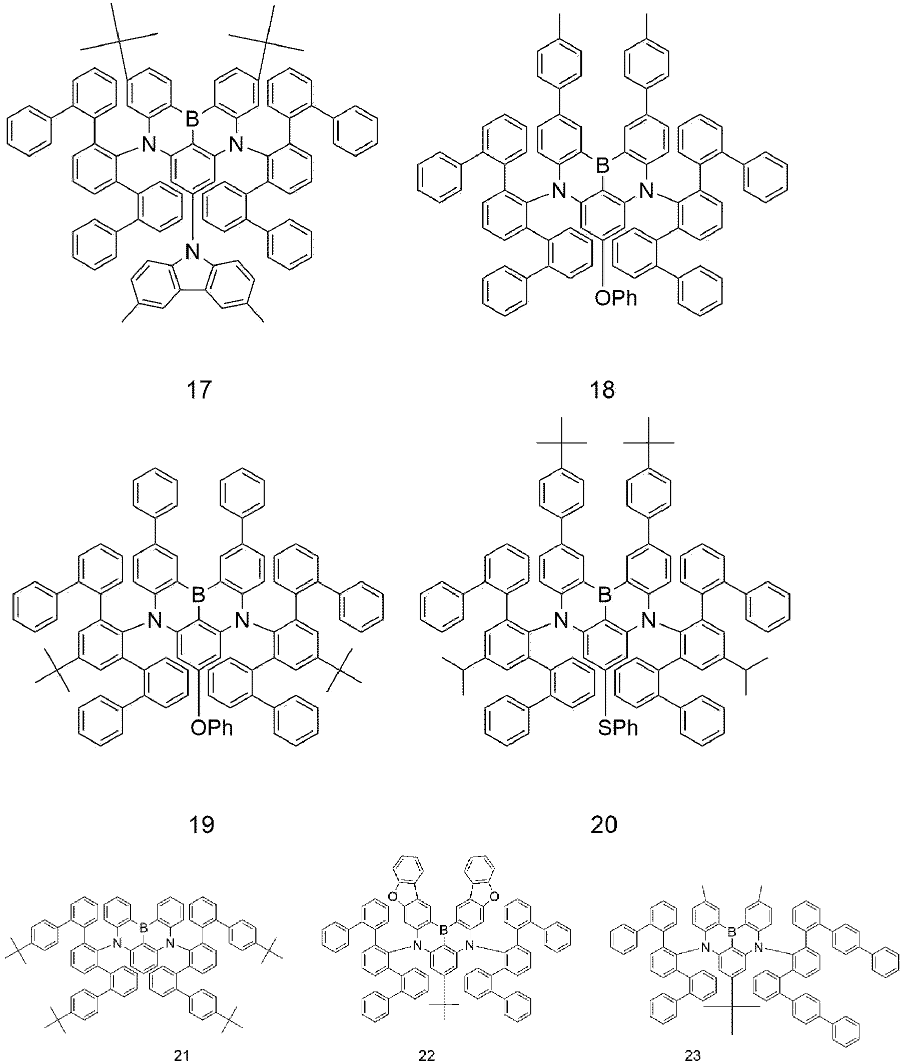

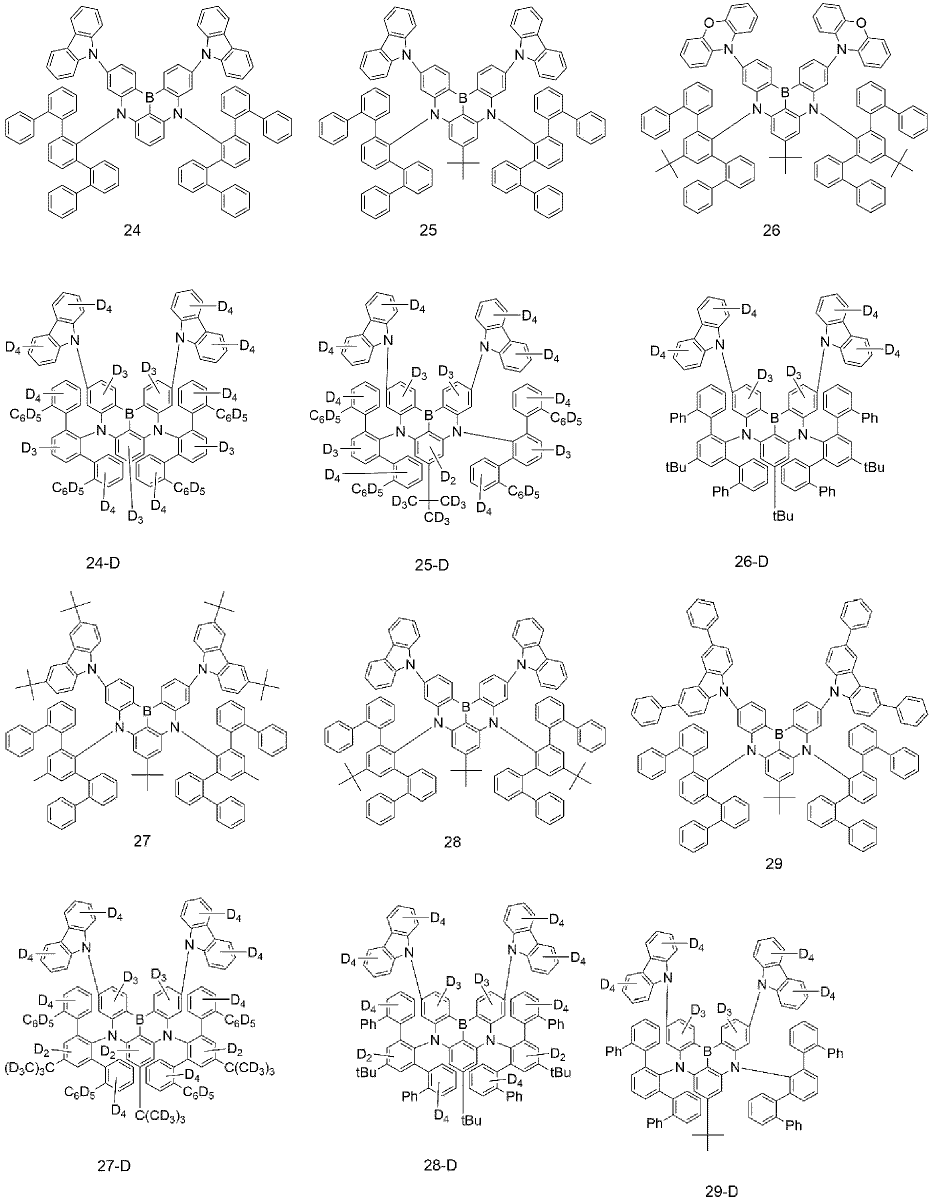

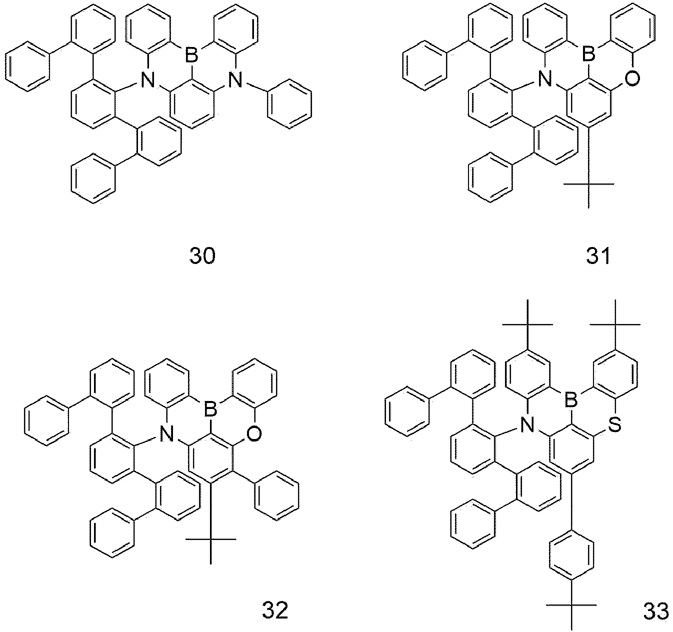

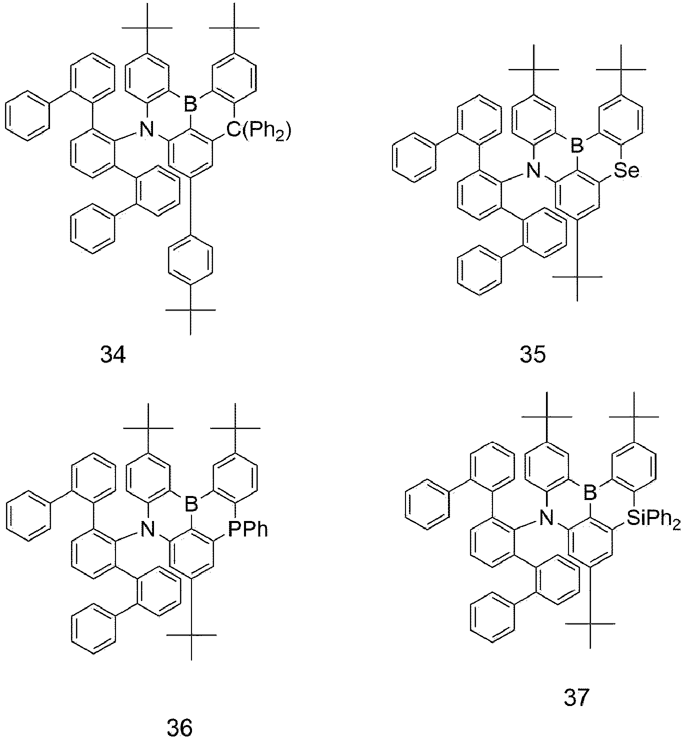

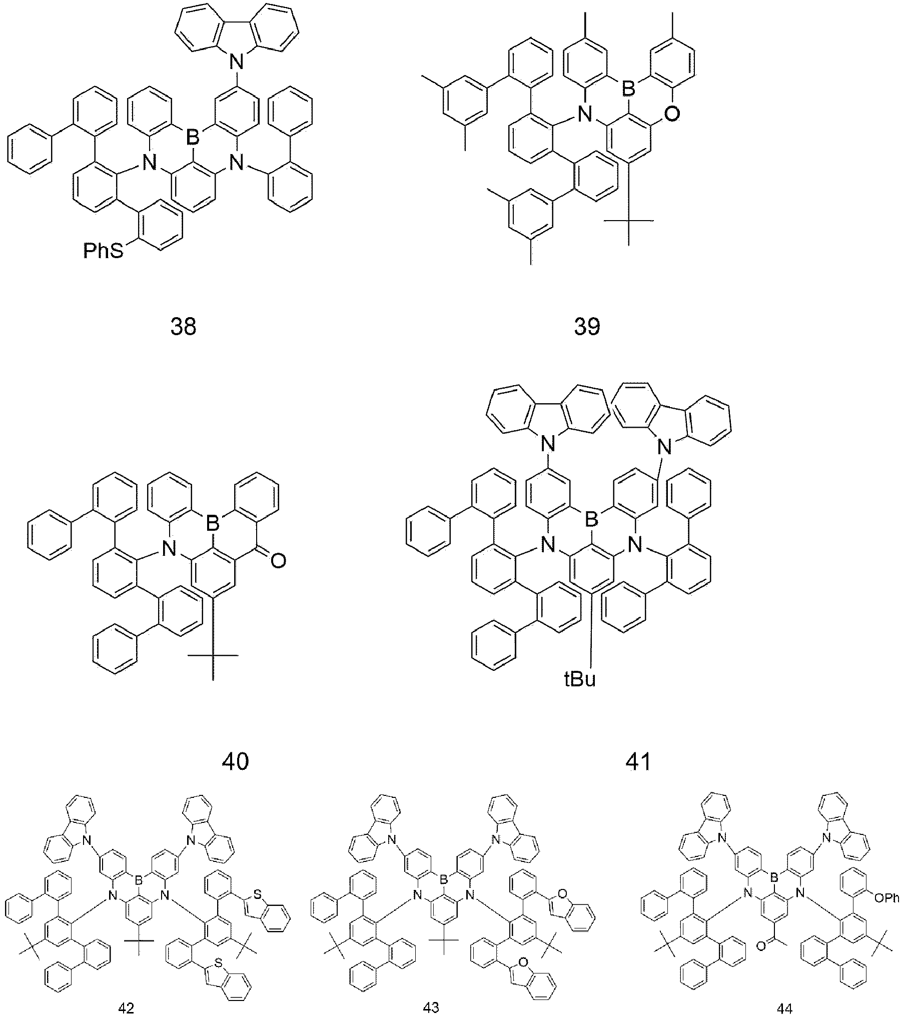

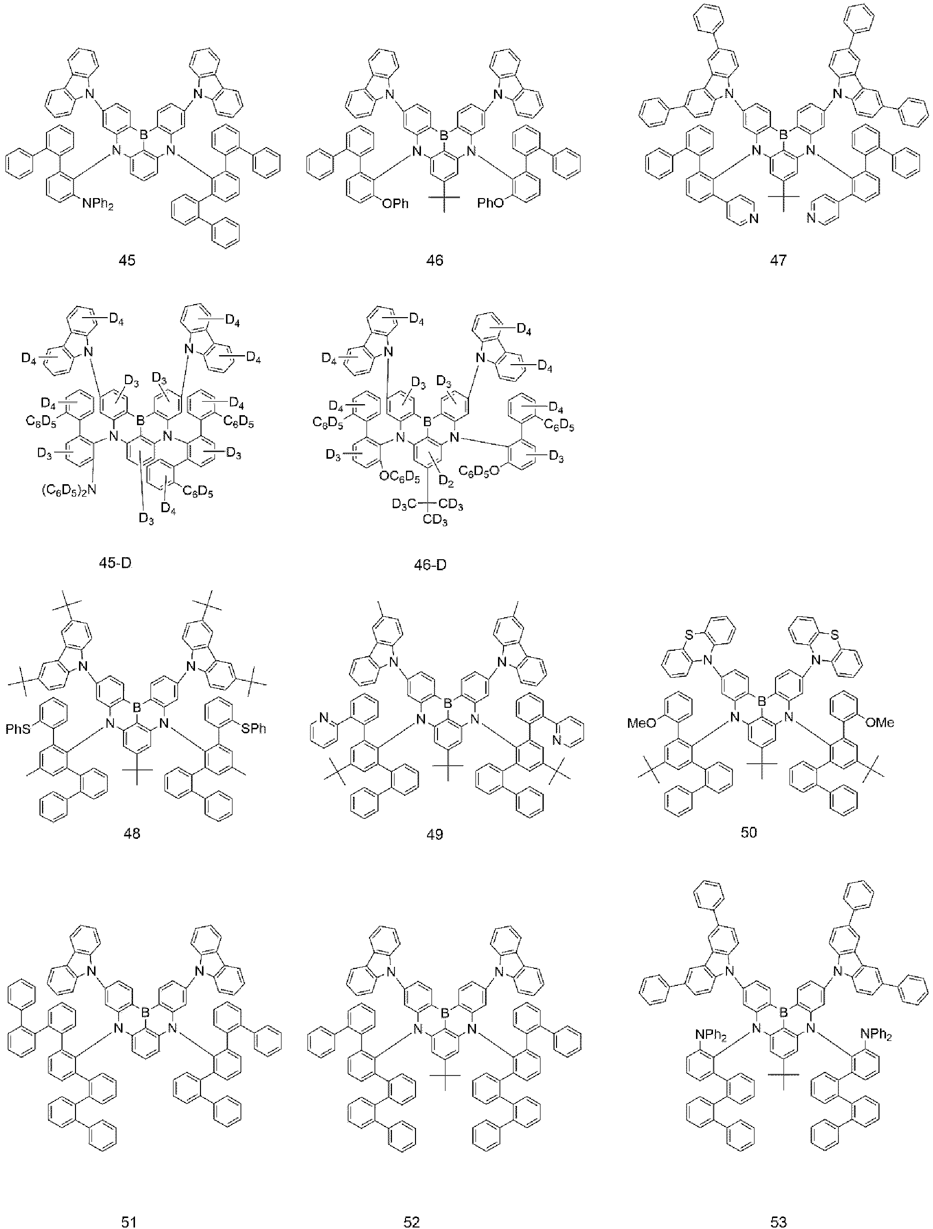

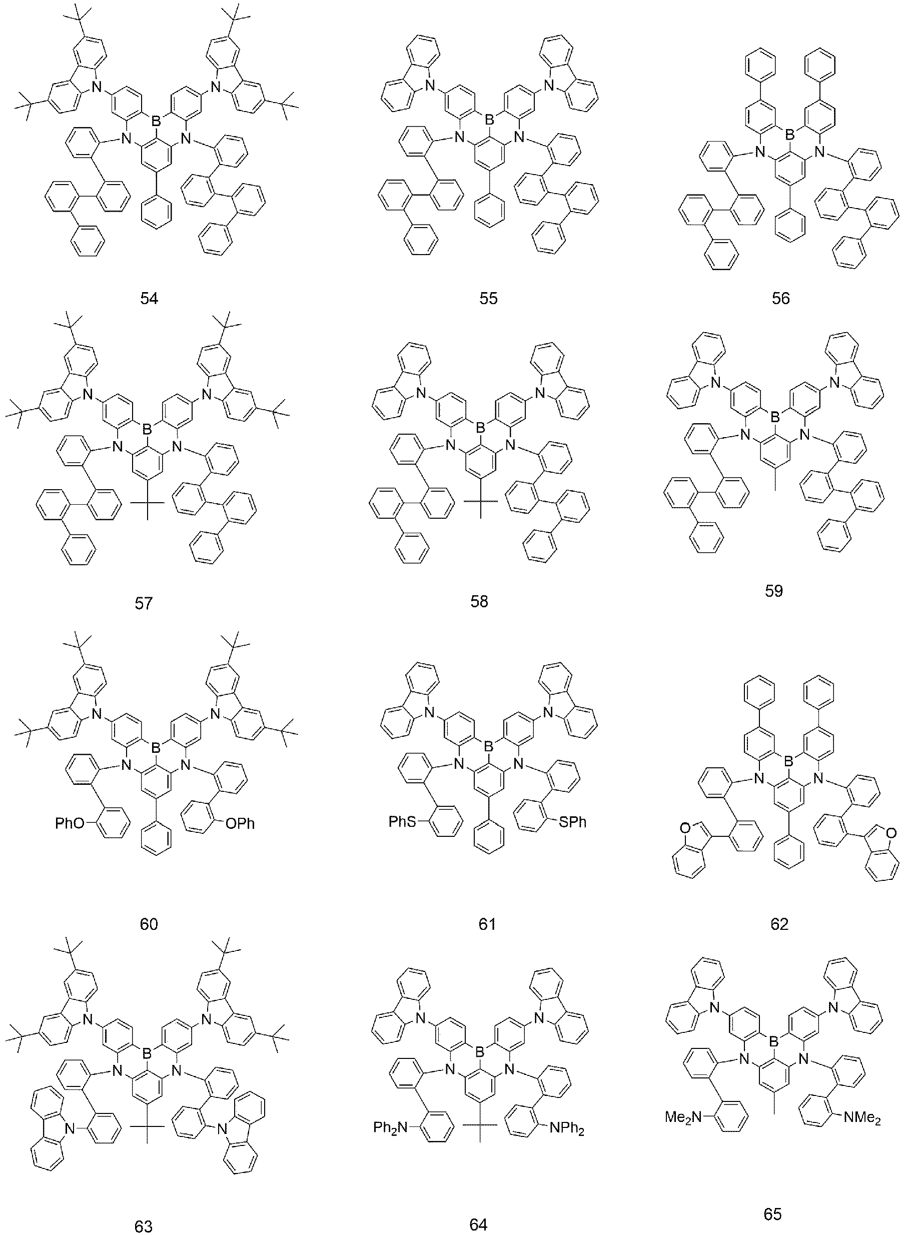

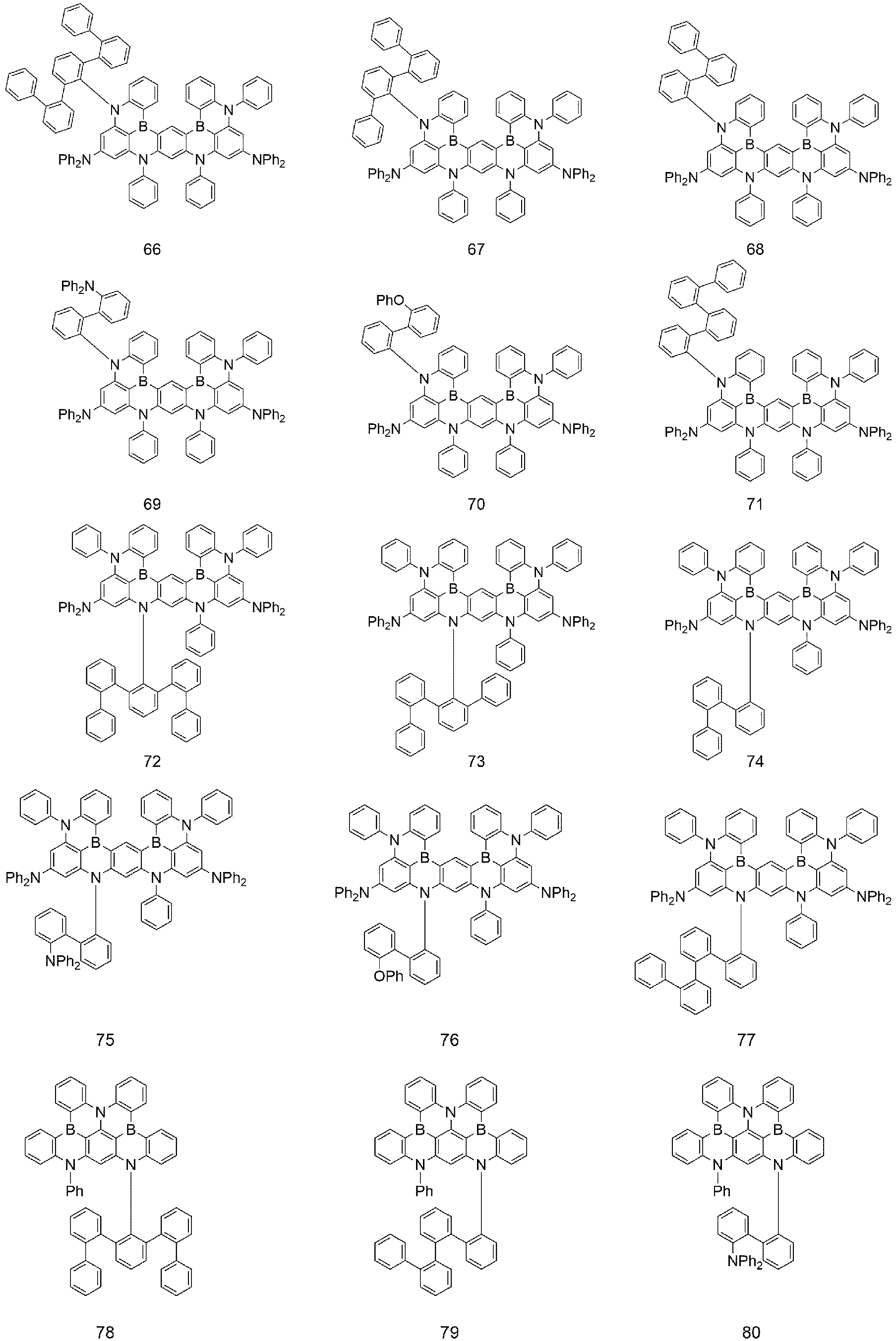

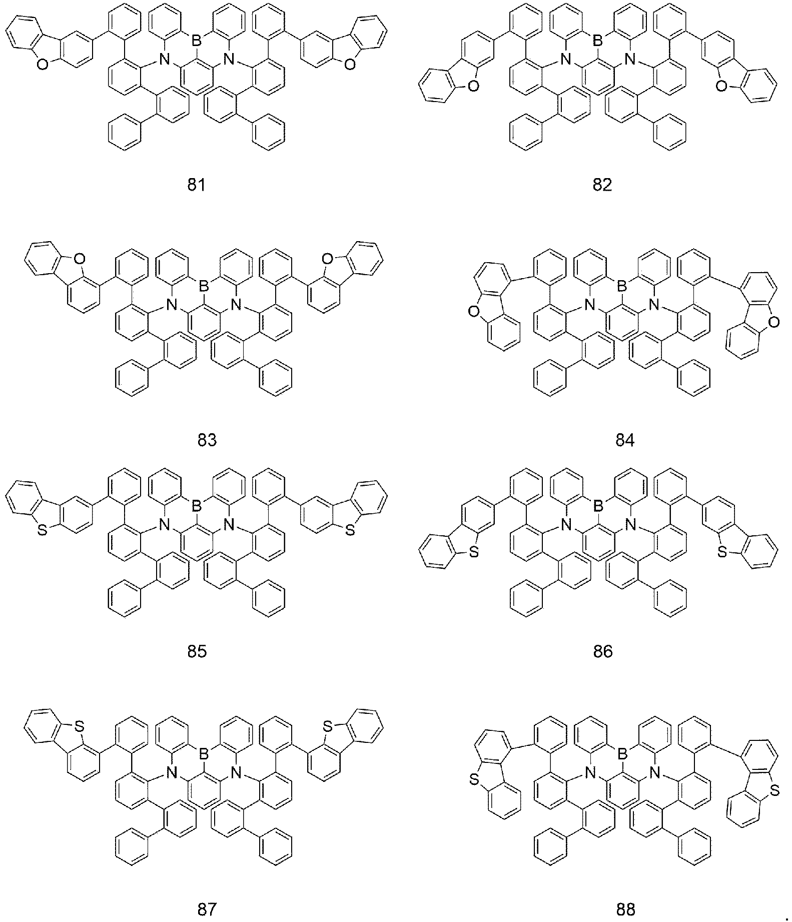

12. A light emitting element comprising:
a first electrode;
a second electrode facing the first electrode; and
an emission layer between the first electrode and the second electrode,
wherein the emission layer comprises the fused polycyclic compound as a first compound according to any one of claims 1 to 11.

13. The light emitting element of claim 11, wherein the emission layer further comprises at least one selected from among a second compound represented by Formula HT-1, a third compound represented by Formula ET-1, and a fourth compound represented by Formula D-1: 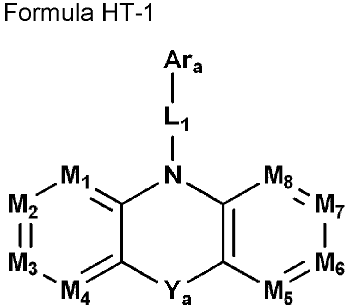 in Formula HT-1,
M₁ to M₈ being each independently N or CR₅₁,
L₁ being a direct linkage, a substituted or unsubstituted arylene group of 6 to 30 ring-forming carbon atoms, or a substituted or unsubstituted heteroarylene group of 2 to 30 ring-forming carbon atoms,
Yₐ being a direct linkage, CR₅₂R₅₃, or SiR₅₄R₅₅,
Arₐ being a substituted or unsubstituted aryl group of 6 to 30 ring-forming carbon atoms or a substituted or unsubstituted heteroaryl group of 2 to 30 ring-forming carbon atoms, and
R₅₁ to R₅₅ being each independently hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and/or combined with an adjacent group to form a ring; 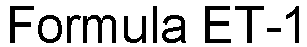 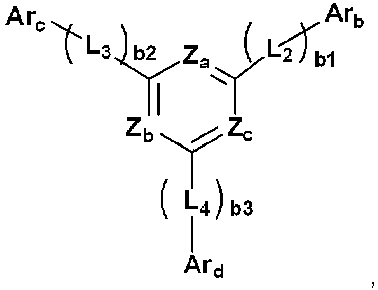 in Formula ET-1,
at least one selected from among Zₐ to Z_{c} being N, and the remainder being CR₅₆,
R₅₆ being hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms,
b1 to b3 being each independently an integer of 0 to 10,
Ar_{b} to Ar_{d} being each independently hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and
L₂ to L₄ being each independently a direct linkage, a substituted or unsubstituted arylene group of 6 to 30 ring-forming carbon atoms, or a substituted or unsubstituted heteroarylene group of 2 to 30 ring-forming carbon atoms; and 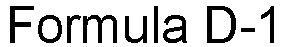 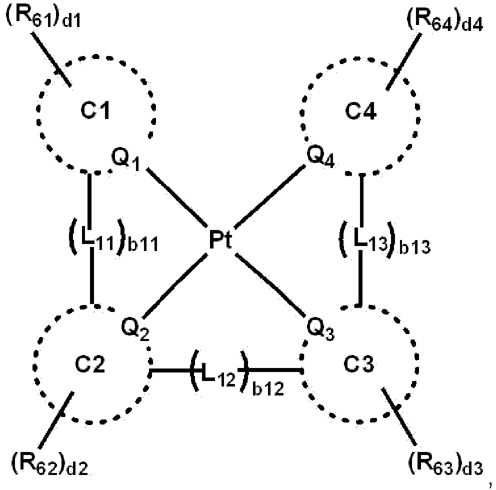 in Formula D-1,
Q₁ to Q₄ being each independently C or N,
C1 to C4 being each independently a substituted or unsubstituted hydrocarbon ring of 5 to 30 ring-forming carbon atoms, or a substituted or unsubstituted heterocycle of 2 to 30 ring-forming carbon atoms,
L₁₁ to L₁₃ being each independently a direct linkage, 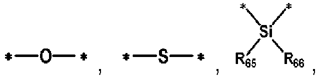 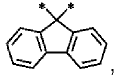 a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms, b11 to b13 being each independently 0 or 1,
R₆₁ to R66 being each independently hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and d1 to d4 being each independently an integer of 0 to 4.

14. A display device comprising:
a base layer;
a circuit layer on the base layer; and
a display device layer on the circuit layer and comprising a light emitting element,
wherein the light emitting element comprises a first electrode, a second electrode on the first electrode, and an emission layer between the first electrode and the second electrode and comprising the fused polycyclic compound as a first compound according to any one of claims 1 to 11.

15. The display device of claim 14, wherein the display device further comprises a light control layer on the display device layer and comprising a quantum dot,
the light emitting element being configured to emit first color light, and
the light control layer comprises:
a first light control part comprising a first quantum dot converting first color light into second color light in a wavelength region longer than the first color light;
a second light control part comprising a second quantum dot converting the first color light into third color light in a wavelength region longer than the first color light and the second color light; and
a third light control part configured to transmit the first color light.
